# EUROPEAN PATENT SPECIFICATION

(11) **EP 3 810 619 B1**
(45) Date of publication and mention of the grant of the patent: **26.04.2023**
(21) Application number: 19731306.7
(22) Date of filing: 21.06.2019
(51) Int. Cl.: C07F 9/50, B32B 15/00, C07F 9/655, C07F 9/6553, C08K 5/00, C08L 77/00, H01L 51/00, H01L 51/50, H01L 51/05, H01L 51/42

(54) **TETRA-NUCLEAR NEUTRAL COPPER (I) COMPLEXES**
TETRA-NUKLEARE NEUTRALE KUPFER (I)-KOMPLEXE
COMPLEXES DE CUIVRE NEUTRE (I) TÉTRANUCLÉAIRES

(30) Priority: 20.06.2018 EP 18178819
(43) Date of publication of application: 28.04.2021
(73) Proprietor: Clariant International Ltd, 4132 Muttenz (CH)
(72) Inventor: BISSESSAR, Damien, 67034 Strasbourg (FR); BELLEMIN LAPONNAZ, Stephane, 67034 Strasbourg (FR); STEFFANUT, Pascal, 68128 Village Neuf (FR)
(74) Representative: Mikulecky, Klaus
(86) International application number: PCT/EP2019/066487
(87) International publication number: WO 2019/243583

(56) References cited:
- LI YAT ET AL: "Synthesis and crystal structures of copper(I) iodide complexes chelating with bis(ethylamidophosphine)", INORGANIC CHEMISTRY COMMUNICATIONS, vol. 6, no. 12, 2003, pages 1451-1453, XP085040315, ISSN: 1387-7003, DOI: 10.1016/J.INOCHE.2003.09.003 cited in the application
- XIAO-CHEN SHAN ET AL: "A solid AND logic stimuli-responsive material with bright nondestructive performance designed by sensitive cuprophilicity", CHEMICAL COMMUNICATIONS, vol. 49, no. 87, 1 January 2013 (2013-01-01), page 10227, XP055508411, ISSN: 1359-7345, DOI: 10.1039/c3cc43241f cited in the application

## Description

The present invention relates to tetra-nuclear neutral copper (I) complexes that have a cubane-like structure, wherein said complexes comprise phosphine ligands which bear one or more aldehyde or ester groups. Furthermore, the present invention refers to methods for generating such copper (I) complexes and to uses thereof.

Today, compounds for optochemical uses are of interest for various applications. For example, such compounds are used in opto-electronic device, as stabilizers in thermoplastic molding masses and for modifying light transmission of a material such as, e.g., in a polymer composition. For the above applications, it is of interest to provide chemically and physically stable compounds with good photophysical properties.

Tetra-nuclear neutral copper (I) complexes that have a cubane-like structure have been considered as a core structure for chemical syntheses (cf. Churchill and Karla, Inorg. Chem., 1974, 13:1899-1904). It has also been considered to use compounds for optochemical uses having such cubane-like core structure that further comprise phosphine ligands. Triarylphosphino ligands such as triphenylphosphino ligands are widely used, although having found to be insufficient for many applications and having rather low chemical flexibility.

Various attempts have been made to replace one or more aryl residues of triarylphosphino ligands by one or more aliphatic residues such as a propenyl residue (Perruchas et al., J. Am Chem. Soc., 2010, 132:10967-10969) or a propyl residue (cf. Perruchas et al., Inorg. Chem., 2011, 50:10682-10692). Also bivalent phosphine ligands based on a dibenzofuran moiety have been described (Xie et al., Chem. Mater., 2017, 29,: 6606-6610). Nevertheless, these complexes do still not bear sufficient chemical and photophysical properties.

It has been tried to improve photophysical properties by providing amide groups within the organic residues of bivalent phosphine ligands (cf. Li et al. Inorg. Chem. Commun., 2003, 6:1451-1453).

The presence of amide nitrogen atoms in this position however bears the risk of undesired side reactions. Further, the process described in Li et al. bases on the use of toxic mercury (Hg).

Also negatively charged ligands such as 3-(diphenylphosphino)propanoic acid have been considered (cf. Shan et al., Chem. Commun., 2013, 49:10227-10229). Due to its charge, the compound is however tending to form salts and might migrate in an electrical field. Further, the carbonic acid group can react with various functional groups and tends to form side products.

Perruchas et al (Inorg. Chem., 2012, 51 :794-798) and Benito et al. (J. Am. Chem. Soc., 2014, 136:11311-11320) teach silicon-containing ligands. These are highly complex and are obtained by a multi-step procedure wherein monovalent ligands are first added to a cubane-like core and then dimerized in a further step.

It is thus an unmet need to provide further compounds usable in optochemical applications that bear high chemical and physical stability and good photophysical properties and means and methods for preparing those.

Surprisingly, it has been found that tetra-nuclear neutral copper (I) complexes that have a cubane-like structure and comprise phosphine ligands which bear one or more aldehyde or ester groups are particularly good compounds usable in optochemical applications. The obtained compounds are chemically stable and provide good photophysical properties. Furthermore, several efficient methods for preparing such compounds have been found. The obtained copper (I) complexes could be prepared without burden and in good yields and were found to have good air and thermal stability.

A first aspect of the present invention relates to a copper (I) complex of Formula (A) 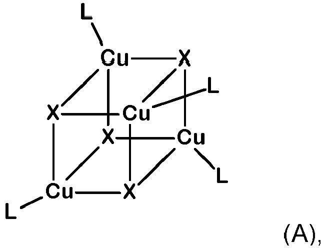 wherein:
each Cu is copper (I);
each X is independently from each other halogen;
each L is independently from each other a ligand that has a structure of Formula (A1):

   P(Ar)ₘ(CHR2-CHR1-CO-Y-Rx)ₙ (A1),
wherein:
   P is phosphorous;
   each Ar is independently from each other an unsubstituted or substituted aryl residue;
   each R1 is independently from each other hydrogen, -R^{a}-R^{b}, -O-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, deuterium, or halogen;
   each R2 is independently from each other hydrogen, -O-R^{b}, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, or -R^{a}-CO-R^{b}, deuterium, or halogen;
   Y is O or a bond to a carbon atom of residue Rx or is N bound to two independent Rx, preferably wherein Y is O or a bond to a carbon atom of residue Rx;
   Rx is an unsubstituted or substituted hydrocarbon residue comprising from 1 to 30 carbon atoms, a polymeric moiety, or a solid support, wherein Rx may optionally be or contribute to a linker that interconnects two ligands L with another;
   R^{a} at each occurrence independently from each other is a single bond, an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue;
   m is an integer from 0 to 2;
   n is an integer from 1 to 3;
   the sum of n and m is 3;
   R^{b} at each occurrence independently from each other is an unsubstituted or substituted C₁-C₂₀-(hetero)alkyl residue, an unsubstituted or substituted C₂-C₂₀-(hetero)alkenyl residue, an unsubstituted or substituted C₂-C₂₀-(hetero)alkinyl residue, an unsubstituted or substituted C₁-C₂₀-(hetero)cycloalkyl residue, an unsubstituted or substituted C₂-C₂₀-(hetero)cycloalkenyl residue, an unsubstituted or substituted C₂-C₂₀-(hetero)cycloalkinyl residue, an unsubstituted or substituted C₂-C₂₀-(hetero)aromatic residue, or an unsubstituted or substituted C₂-C₂₀-alk(hetero)aromatic residue,
   wherein the phosphorous is bound to Cu, and
   wherein said copper (I) complex has a neutral net charge and
   wherein a substituent of a substituted residue does not comprise more than 20 carbon atoms.

It will be understood that the structure of Formula (A) typically is a cubane-like copper (I) complex with four phosphine ligands, in other words a cubane-like [copper (I) - halogen - phosphine] complex with a [Cu₄X₄] cubane core.

Accordingly, the present invention relates to tetra-nuclear neutral copper (I) complexes, so called cubane-like structures (also: cubanes), with mono- or bidentate (i.e., mono- or bivalent) ligands which are bonded via phosphorus atoms. The neutrality of the cubane-like core of the copper (I) complexes of the present invention is given since Cu(I) is mono-positively charged and one of the ligands is mono-negatively charged halogen. Accordingly, also the ligands L are preferably all neutral. As laid out above, in the copper (I) complex (Cu(I) complex) of the present invention, the ligands L may optionally also be bonded to one another, giving rise to a bivalent ligand.

The copper (I) complex of the present invention has a neutral net charge. Accordingly, preferably, all ligands L also each have a neutral net charge. As used herein, the term "neutral net charge" may be understood in the broadest sense as not having a charge (positive (+) or negative (-)) over the whole compound or moiety, i.e., have net zero charge. More preferably, the ligands L do not have an ionic group at all in other words, are uncharged. Alternatively, one or more of the ligands L may be zwitterionic. In the latter case, the copper (I) complex of the present invention may also be a salt of the Formula (A).

As used throughout the present application, the term "aryl" may be understood in the broadest sense as any mono-, bi- or polycyclic aromatic moiety.

Preferably, an aryl is a C₆-C₃₀-aryl, more preferably a C₆-C₁₄-aryl, even more preferably a C₆-C₁₀-aryl, in particular a C₆-aryl. The term "heteroaryl" may be understood in the broadest sense as any mono-, bi- or polycyclic heteroaromatic moiety that includes at least one heteroatom, in particular which bears from one to three heteroatoms per aromatic ring. Preferably, a heteroaryl is a C₁-C₂₉-aryl, more preferably a C₁-C₁₃-aryl, even more preferably a C₁-C₉-aryl, in particular a C₁-C₅-aryl. Accordingly, the terms "arylene" and "heteroarylene" refer to the respective bivalent residues that each bear two binding sites to other molecular structures and thereby serve as a linker structure. Exemplarily, a heteroaryl may be a residue of furan, pyrrole, imidazole, oxazole, thiazole, triazole, thiophene, pyrazole, pyridine, pyrazine or pyrimidine. As far as not otherwise indicated, an aryl or heteroaryl may also be optionally substituted by one or more substituents. An aryl or heteroaryl may be unsubstituted or substituted.

As used throughout the present application, the term "unsubstituted" may be understood in the broadest sense as generally understood in the art. Thus, in accordance with general understanding, an unsubstituted residue may consist of the chemical structure defined and, as far as appropriate, one or more hydrogen atoms bound to balance valency.

As used throughout the present application, the term "substituted" may be understood in the broadest sense as generally understood in the art. Thus, a substituted residue may comprise the chemical structure described and one or more substituents. In other words, one or more hydrogen atoms balancing valency are typically replaced by one or more other chemical entities. Preferably, a substituted residue comprises the chemical structure described and one substituent. In other words, then, one hydrogen atom balancing valency is replaced by another chemical entity. For instance, a substituent may be an atom or a group of atoms which replaces one or more hydrogen atoms on the parent chain of a hydrocarbon residue.

As far as not otherwise defined herein, a substituent may be any substituent. Preferably, a substituent does either not comprise more than 20 carbon atoms. For example, a substituent may be selected from the group consisting of -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, (preferably alkyl terminated) di- or polyethylene glycol, di- or polypropylene glycol, and a halogen, wherein
R^{a} is a single bond, an (unsubstituted or substituted) C₁-C₂₀-alkylene residue, an (unsubstituted or substituted) C₂-C₂₀-alkenylene residue, or an (unsubstituted or substituted) C₂-C₂₀-alkinylene residue; and R^{b} is an (unsubstituted or substituted) C₁-C₂₀-(hetero)alkyl residue, an (unsubstituted or substituted) C₁-C₂₀-(hetero)alkenyl residue, an (unsubstituted or substituted) C₁-C₂₀-(hetero)alkinyl residue, an (unsubstituted or substituted) C₁-C₂₀-(hetero)cycloalkyl residue, an (unsubstituted or substituted) C₁-C₂₀-(hetero)cycloalkenyl residue, an (unsubstituted or substituted) C₁-C₂₀-(hetero)cycloalkinyl residue, or an (unsubstituted or substituted) C₁-C₂₀-(hetero)aromatic residue, wherein preferably the substituent (as a whole) does either not comprise more than 20 carbon atoms.

More preferably, the substituent (as a whole) does either not comprise more than 20 carbon atoms, even more preferably not more than 10 carbon atoms, in particular not more than 4 carbon atoms. The person skilled in the art will immediately understand that the definitions of R^{a} and R^{b} have to be adapted accordingly.

For example, in a particularly preferred embodiment, the defined residues are unsubstituted or are substituted with one substituent that does not comprise more than 4 carbon atoms, wherein a substituent may be selected from the group consisting of -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, (preferably alkyl terminated) di- or polyethylene glycol, or di- or polypropylene glycol; wherein R^{a} is an unsubstituted C₁-C₄-alkylene residue, an unsubstituted C₂-C₄-alkenylene residue, or an unsubstituted C₂-C₄-alkinylene residue; and R^{b} is an unsubstituted C₁-C₄-(hetero)alkyl residue, an unsubstituted C₁-C₄-(hetero)alkenyl residue, an unsubstituted C₁-C₄-(hetero)alkinyl residue, an unsubstituted C₁-C₄-(hetero)cycloalkyl residue, an unsubstituted C₁-C₄-(hetero)cycloalkenyl residue, an unsubstituted C₁-C₄-(hetero)cycloalkinyl residue, or an (unsubstituted or substituted) C₁-C₄-(hetero)aromatic residue.

In a preferred embodiment, a substituent may be selected from the group consisting of -R^{a}-R^{b}, -R^{a}-CO-O-R^{b}, -R^{a}-O-CO-R^{b}, -R^{a}-O-R^{b}, (preferably alkyl terminated) di- or polyethylene glycol, di- or polypropylene glycol, wherein R^{a} and R^{b} are defined as above.

In a particularly preferred embodiment, a substituent is selected from the group consisting of -R^{a}-R^{b}, -R^{a}-CO-O-R^{b}, -R^{a}-O-CO-R^{b}, -R^{a}-O-R^{b}, wherein R^{a} and R^{b} are defined as above and the substituent does not comprise more than 30 carbon atoms, more preferably does not comprise more than 20 carbon atoms, even more preferably does not comprise more than 10 carbon atoms, in particular does not comprise more than 4 carbon atoms. The person skilled in the art will immediately understand that the definitions of R^{a} and R^{b} have to be adapted accordingly as laid out above.

As used throughout the present application, the term "alkyl" may be understood in the broadest sense as both, linear or branched chain alkyl residue. Preferred alkyl residues are those containing from one to 20 carbon atoms. More preferred alkyl residues are those containing from one to ten carbon atoms. Particularly preferred alkyl residues are those containing from one to four carbon atoms. Exemplarily, an alkyl residue may be methyl, ethyl, propyl, isopropyl, butyl, isobutyl or tert-butyl. The term "heteroalkyl" may be understood in the broadest sense as both, linear or branched chain alkyl residue that includes at least one heteroatom, in particular which bears from one to three heteroatoms. Typically, the heteroatom may replace a carbon atom. The valencies are adapted accordingly. As far as not otherwise indicated, an alkyl or heteroalkyl may also be optionally substituted by one or more substituents. A (hetero)cycloalkyl refers to the respective cyclic structure that is typically an aliphatic cyclic structure. The terms "alkylene", "heteroalkylene", "cycloalkylene" and "heterocycloalkylene" refer to bivalent residues that each bear two binding sites to other molecular structures and thereby serve as a linker structure.

As used throughout the present invention, an heteroatom may be any heteroatom, in particular a di-, tri- or tetravalent atom, such as, e.g., oxygen, nitrogen, sulfur, silicium, or a combination of two or more thereof, which may be optionally further substituted. It will be understood that when an heteroatom replaces a carbon atom, the valency and number or hydrogen atoms will be adapted accordingly. Accordingly, a residue comprising one or more heteroatoms may, for example, comprise a group selected from -O-, -NH-, =N-, -NCH₃-, -Si(OH)₂-, -Si(OH)CH₃-,-Si(CH₃)₂-, -O-Si(OH)₂-O-, -O-SiOCH₃-O-, -O-Si(CH₃)₂-O-, -S-, -SO-, -SO₂-, -SO₃-, - SO₄-, or a salt thereof.

The term "alkenyl" may be understood in the broadest sense as both, linear or branched chain alkenyl residue, i.e. a hydrocarbon comprising at least one double bond. An alkenyl may optionally also comprise two or more double bonds. Preferred alkenyl residues are those containing from two to 20 carbon atoms. More preferred alkenyl residues are those containing from two to ten carbon atoms. Particularly preferred alkenyl residues are those containing from two to four carbon atoms. The term "heteroalkenyl" may be understood in the broadest sense as both, linear or branched chain alkenyl residue that includes at least one heteroatom, in particular which bears from one to three heteroatoms. As far as not otherwise indicated, an alkenyl or heteroalkenyl may also be optionally substituted by one or more substituents. A (hetero)cycloalkenyl refers to the respective cyclic structure that is typically an aliphatic cyclic structure. The terms "alkenylene", "heteroalkenylene", "cycloalkenylene" and "heterocycloalkenylene" refer to bivalent residues that each bear two binding sites to other molecular structures and thereby serve as a linker structure.

The term "alkinyl" may be understood in the broadest sense as both, linear or branched chain alkinyl residue, i.e. a hydrocarbon comprising at least one double bond. An alkinyl may optionally also comprise two or more double bonds. Preferred alkinyl residues are those containing from two to 20 carbon atoms. More preferred alkinyl residues are those containing from two to ten carbon atoms. Particularly preferred alkinyl residues are those containing from two to four carbon atoms. The term "heteroalkinyl" may be understood in the broadest sense as both, linear or branched chain alkinyl residue that includes at least one heteroatom, in particular which bears from one to three heteroatoms. As far as not otherwise indicated, an alkinyl or heteroalkinyl may also be optionally substituted by one or more substituents. A (hetero)cycloalkinyl refers to the respective cyclic structure that is typically an aliphatic cyclic structure. The terms "alkinylene", "heteroalkinylene", "cycloalkinylene" and "heterocycloalkinylene" refer to bivalent residues that each bear two binding sites to other molecular structures and thereby serve as a linker structure.

It will be noticed that hydrogen can, at each occurrence, be replaced by deuterium. Each X in the copper (I) complex of Formula (A) may be any halogen. In a preferred embodiment, each X is of the same kind. In other words, when each X is of the same kind, the copper (I) complex of the present invention merely comprises a single type of X only. Then, the cubane-like core comprises a single type of halogen only. In still other words, then, the sum formula of the cubane-like core is Cu₄X₄.

In a preferred embodiment, a ligand is a ligand having a structure of one of the following Formulae (A1') or (A1"): 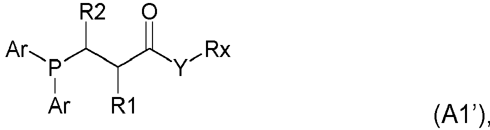 or 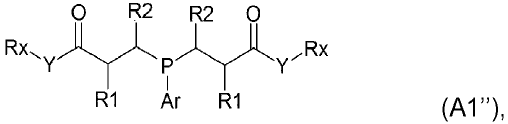 wherein P, Ar, R1, R2, Y and Rx are each independently from each other defined as laid out in the present invention.

Alternatively, a ligand may also be a ligand having a structure of one of the following Formula (A1‴): 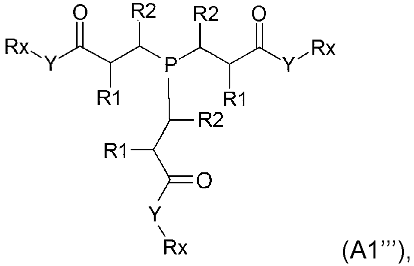 wherein P, Ar, R1, R2, Y and Rx are each independently from each other defined as laid out in the present invention.

In a preferred embodiment, m is an integer from 1 or 2 and n is an integer from 1 to 2. Therefore, in one preferred embodiment, m is 2 and n is 1. In another preferred embodiment, m is 1 and n is 2.

Each X may independently from each other be iodine (I), bromine (Br), chlorine (Cl), fluorine (F), or astatine (At). Preferably, each X is independently from each other selected from the group consisting of iodine (I), bromine (Br), chlorine (Cl), and fluorine (F). More preferably, each X is independently from each other selected from the group consisting of iodine (I), bromine (Br), and chlorine (Cl). Even more preferably, each X is independently from each other selected from the group consisting of iodine (I) and bromine (Br). In a particularly preferred embodiment, each X is iodine. In other words, in a particularly preferred embodiment, the cubane-like core comprises a iodine as halogen only. In still other words, then, the sum formula of the cubane-like core is Cu₄Cl₄. In still other words, the all of X are each iodine.

The aryl residue Ar may be any aryl residue. Preferably, Ar is an unsubstituted or substituted C₆-C₁₄-aryl, more preferably an unsubstituted or substituted C₆-C₁₀-aryl. In a preferred embodiment, each Ar is independently from each other an unsubstituted or substituted phenyl residue.

The ligands L may be of the same kind or may be different. Preferably, at least two ligands L may be of the same kind (i.e., have the same chemical formula), more preferably at least three ligands L may be of the same kind. In a more preferred embodiment, each ligand L is a monovalent ligand of the same kind. In other words, when each ligand L is a monovalent ligand of the same kind, the copper (I) complex of the present invention merely comprises a single type of ligand L.

In an alternative preferred embodiment, two ligands L are interconnected with another, thereby forming a bivalent ligand. More preferably, two times each two ligands L are interconnected with another, thereby each forming a bivalent ligand. Even more preferably, two times each two ligands L of the same kind are interconnected with another, thereby forming two bivalent ligands of the same kind.

In an alternative preferred embodiment, each L is independently from each other a diarylphosphine residue of Formula (A2):

P(Ar)ₘ(CHR2-CHR1-CO-Y-R13)ₙ (A2),

wherein P, Ar, R1, R2, Y, R^{a}, R^{b}, m and n are defined as laid out throughout the present invention, and wherein:
R13 is -R^{a}-R^{b}, -R^{c}-CO-O-R^{b}, -R^{c}-O-CO-R^{b}, -R^{c}-O-R^{b}, -R^{c}-CO-NH-R^{b}, -R^{c}-NH-CO-R^{b}, -R^{c}-NH-R^{b}, -R^{c}-CO-R^{b}, di- or polyethylene glycol, di- or polypropylene glycol, a polymeric moiety, or a solid support; and
R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue, wherein the phosphorous is bound to Cu.

In a more preferred embodiment, each L is independently from each other a diarylphosphine residue of Formula (A2'): 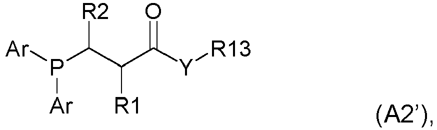 wherein P, Ar, R1, R2, Y, R^{a} and R^{b} are defined as above, and wherein:
R13 is -R^{a}-R^{b}, -R^{c}-CO-O-R^{b}, -R^{c}-O-CO-R^{b}, -R^{c}-O-R^{b}, -R^{c}-CO-NH-R^{b}, or -R^{c}-NH-CO-R^{b}, -R^{c}-NH-R^{b}, -R^{c}-CO-R^{b}, (preferably alkyl terminated) di- or polyethylene glycol, di- or polypropylene glycol, a polymeric moiety, or a solid support, wherein the phosphorous is bound to Cu.

In a preferred embodiment, Y is a single bond and R13 is selected from the group consisting of -CH₃, -CH₂CH₃, -(CH₂)₂CH₃, -(CH₂)₃CH₃, or N(CH₃)₂, preferably wherein R1 and R2 are both hydrogen.

In a preferred embodiment, Y is O and R13 is selected from the group consisting of -CH₂CH₃, -(CH₂)₂CH₃, -(CH₂)₃CH₃, -CH₂-CH((C₂H₅)-(CH₂)₃-CH₃, -(CH₂)₄-CCH, - Ph(CH₂-CH=CH₂), and -CH₂-thiophen.

In a preferred embodiment, Y is O and R13 is selected from the group consisting of -CH₂CH₃, -(CH₂)₂CH₃, -(CH₂)₃CH₃, -CH₂-CH((C₂H₅)-(CH₂)₃-CH₃, -(CH₂)₄-CCH, - Ph(CH₂-CH=CH₂), -CH₂-thiophen, -CH₂-furanyl, or cyclohexyl.

In an alternative preferred embodiment, Y is N and two R13 are each -CH₃.

In a preferred embodiment, each L is a diphenylphosphine residue of Formula (A4): 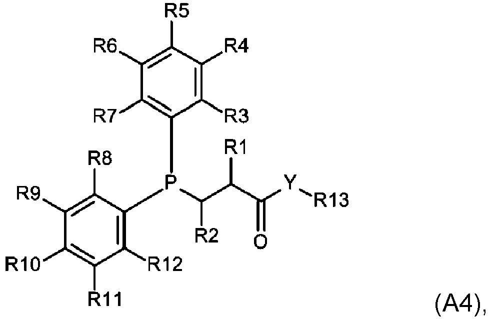 wherein P, R1, R2, Y, R13, R^{a}, R^{b} and R^{c} are defined as above, and wherein:
R3 to R12 are independently from each other selected from hydrogen, a C₁-C₁₈-alkyl residue and a C₁-C₁₂-alkoxy residue, and wherein the phosphorous is bound to Cu.

In a more preferred embodiment, R1 to R10 are independently from each other selected from the group consisting of hydrogen, a unsubstituted C₁-C₂₀-alkyl residue, or a unsubstituted C₁-C₁₂-alkoxy residue. In an even more preferred embodiment, R1 to R10 are independently from each other selected from the group consisting of hydrogen, a unsubstituted C₁-C₆-alkyl residue, or a unsubstituted C₁-C₆-alkoxy residue. In an even more preferred embodiment, R1 to R10 are independently from each other selected from the group consisting of hydrogen and a unsubstituted C₁-C₄-alkyl residue.

Thus, in a preferred embodiment, each of R1 to R10 is independently from each other selected from the group consisting of hydrogen, methyl, ethyl, n-propyl, iso-propyl, or a C₄-alkyl. In a preferred embodiment, at least six of residues R1 to R10 are hydrogen, preferably at least seven of residues R1 to R10 are hydrogen, preferably at least eight of residues R1 to R10 are hydrogen, preferably at least nine of residues R1 to R10 are hydrogen. In a preferred embodiment, all of residues R1 to R10 are hydrogen.

In a highly preferred embodiment, R1 is hydrogen or -R^{a}-R^{b}, or -R^{a}-CO-O-R^{b}.

In an embodiment, R13 is -R^{a}-R^{b}, -R^{a}-O-R^{b}, (preferably alkyl terminated) di- or polyethylene glycol, di- or polypropylene glycol, or a polymeric moiety.

In a preferred embodiment, each L is a diphenylphosphine residue of Formula (A6): 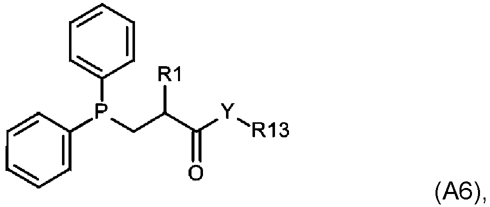 wherein P, R^{a} and R^{b} are defined as above, and wherein:
R1 is hydrogen or -R^{a}-R^{b}, or -R^{a}-CO-O-R^{b}, Y is O, NH or a bond to a carbon atom of residue Rx or is N bound to two independent Rx, preferably wherein Y is O or a bond to a carbon atom of residue Rx; and R13 is -R^{a}-R^{b}, -R^{a}-O-R^{b}, (preferably alkyl terminated) di- or polyethylene glycol, di- or polypropylene glycol, or a polymeric moiety, wherein the phosphorous is bound to Cu.

In a preferred embodiment, each L is a diphenylphosphine residue of Formula (A6), wherein each P is phosphorous; R1 is selected from hydrogen or -R^{a}-R^{b}, and -R^{a}-CO-O-R^{b}, wherein R1 does not comprise more than 4 carbon atoms;
Y is selected from O and a single bond; and R13 is -R^{a}-R^{b}, -R^{a}-O-R^{b}, (preferably alkyl terminated) di- or polyethylene glycol, o di- or polypropylene glycol, or a polymeric moiety.

In an alternative preferred embodiment, two L are interconnected with another, thereby forming a bivalent ligand of Formula (A3): 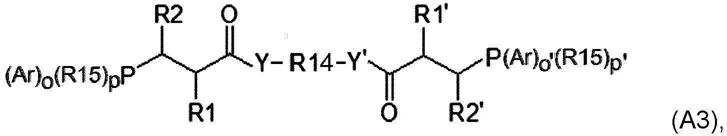 wherein P, Ar, R^{a}, R^{b} and R^{c} are defined as laid out throughout the present invention, and wherein:
o and o' are the same or different and are independently from each other an integer from 0 to 2;
p and p' are the same or different and are independently from each other an integer from 0 to 2;
the sum of o and p is 2 and the sum of o' and p' is 2;
R1 and R1' are the same or different and are independently from each other selected from hydrogen, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, and -R^{a}-CO-R^{b};
R2 and R2' are the same or different and are independently from each other selected from hydrogen, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, and -R^{a}-CO-R^{b};
Y and Y' are the same or different and are independently from each other selected from O and a single bond to a carbon atom of residue Rx; and
R14 is a bivalent linker comprising 1 to 30 carbon atoms;
R15 is -R^{a}-R^{b}, -R^{c}-CO-O-R^{b}, -R^{c}-O-CO-R^{b}, -R^{c}-O-R^{b}, -R^{c}-CO-NH-R^{b}, -R^{c}-NH-CO-R^{b}, -R^{c}-NH-R^{b}, -R^{c}-CO-R^{b}, di- or polyethylene glycol, di- or polypropylene glycol, a polymeric moiety, or a solid support,
wherein phosphorous is each bound to a Cu.

In a preferred embodiment, R14 is selected from -R^{c}-, -R^{a}-O-R^{a}-, a di- or polyethylene glycol linker, a di- or polypropylene glycol linker, -R^{c}-CO-O-R^{c}-, -R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, -R^{c}-CO-NH-R^{c}-NH-CO-R^{c}-, -R^{c}-NH-CO-R^{c}-,-R^{c}-NH-CO-R^{c}-CO-NH-R^{c}-, -R^{c}-NH-R^{c}-, - R^{c}-CO-R^{c}-, and -R^{c}-NH-R^{c}-NH-R^{c}-.

In a preferred embodiment, throughout the present invention, p (and p') is each an integer of 0 or 1 and o(and o') is an integer of 1 or 2, wherein the sum of o and p (and o' and p') is 2. In another preferred embodiment, p (and p') is 0 and o (and o') is 2.

In a preferred embodiment, R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue.

In an even more preferred embodiment, R14 is selected from -R^{c}-, -R^{a}-O-R^{a}-, a di- or polyethylene glycol linker, a di- or polypropylene glycol linker, -R^{c}-CO-O-R^{c}-, - R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, - R^{c}-CO-NH-R^{c}-NH-CO-R^{c}-, -R^{c}-NH-CO-R^{c}-,-R^{c}-NH-CO-R^{c}-CO-NH-R^{c}-, -R^{c}-NH-R^{c}-, -R^{c}-CO-R^{c}-, and -R^{c}-NH-R^{c}-NH-R^{c}-; and
R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue.

In a preferred embodiment, two L are interconnected with another, thereby forming a bivalent ligand of Formula (A3'): 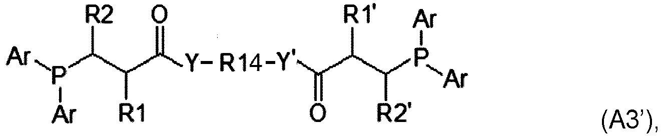 wherein Ar, P, R1, R1', R2, R2' Y, Y', R14, R^{a}, R^{b} and R^{c} are defined as laid out throughout the present invention, wherein phosphorous is each bound to a Cu.

In a preferred embodiment, two L are interconnected with another, thereby forming a bivalent ligand of Formula (A5): 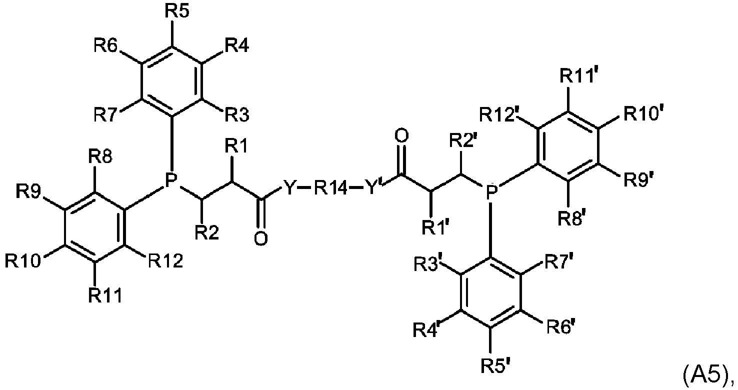 wherein P, R1, R1', R2, R2' Y, Y', R14, R^{a}and R^{b} (and R^{c}) are defined s laid out throughout the present invention, and wherein:
R3 to R12 and R3' to R12' are independently from each other selected from hydrogen, a C₁-C₁₈-alkyl residue, and a C₁-C₁₂-alkoxy residue; and
R14 is selected from -R^{c}-, -R^{a}-O-R^{a}-, a di- or polyethylene glycol linker, a di- or polypropylene glycol linker, -R^{c}-CO-O-R^{c}-, -R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, -R^{c}-CO-NH-R^{c}-NH-CO-R^{c}-, -R^{c}-NH-CO-R^{c}-,-R^{c}-NH-CO-R^{c}-CO-NH-R^{c}-, -R^{c}-NH-R^{c}-, -R^{c}-CO-R^{c}-, -R^{c}-NH-R^{c}-NH-R^{c}-;
R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue, wherein a substituent of a substituted residue does not comprise more than 20 carbon atoms, wherein phosphorous is each bound to a Cu.

In a preferred embodiment, R1 to R10 are independently from each other selected from the group consisting of hydrogen, a unsubstituted C₁-C₂₀-alkyl residue, or a unsubstituted C₁-C₁₂-alkoxy residue. In an even more preferred embodiment, R1 to R10 are independently from each other selected from the group consisting of hydrogen, a unsubstituted C₁-C₆-alkyl residue, or a unsubstituted C₁-C₆-alkoxy residue. In an even more preferred embodiment, R1 to R10 are independently from each other selected from the group consisting of hydrogen and a unsubstituted C₁-C₄-alkyl residue. Thus, in a highly preferred embodiment, each of R1 to R10 is independently from each other selected from the group consisting of hydrogen, methyl, ethyl, n-propyl, iso-propyl, or a C₄-alkyl. In a highly preferred embodiment, at least six of residues R1 to R10 are hydrogen, more preferably at least seven of residues R1 to R10 are hydrogen, even more preferably at least eight of residues R1 to R10 are hydrogen, even more preferably at least nine of residues R1 to R10 are hydrogen. In a highly preferred embodiment, all of residues R1 to R10 are hydrogen.

In a preferred embodiment, R1 and R1' are the same or different and are independently from each other selected from hydrogen or -R^{a}-R^{b}, and -R^{a}-CO-O-R^{b}.

In a preferred embodiment, R14 is selected from -R^{c}-, -R^{a}-O-R^{c}-, (preferably alkyl terminated) di- or polyethylene glycol, and di- or polypropylene glycol.

In a preferred embodiment, two L are interconnected with another, thereby forming a bivalent ligand of Formula (A7): 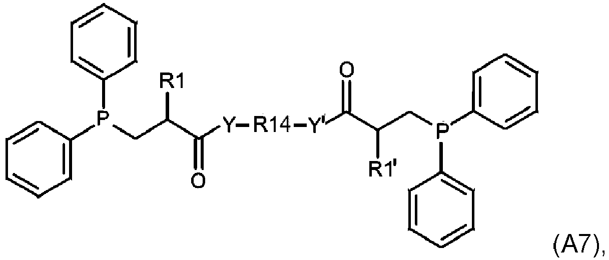 wherein P, R^{a}, R^{b} and R^{c} are defined as above, and wherein:
each P is phosphorous;
R1 and R1' are the same or different and are independently from each other selected from hydrogen or -R^{a}-R^{b}, and -R^{a}-CO-O-R^{b},
Y and Y' are the same or different and are independently from each other selected from O and a single bond; and
R14 is selected from -R^{c}-, -R^{a}-O-R^{c}-, (preferably alkyl terminated) di- or polyethylene glycol, and di- or polypropylene glycol, wherein phosphorous is each bound to a Cu.

In a preferred embodiment, two L are interconnected with another, thereby forming a bivalent ligand of Formula (A7), wherein each P is phosphorous;
R1 and R1' are the same and are each selected from hydrogen or -R^{a}-R^{b}, and -R^{a}-CO-O-R^{b}, wherein R1 and R1' each do not comprise more than 4 carbon atoms;
Y and Y' are the same and are each selected from O and a single bond;
R14 is selected from -R^{c}-, -R^{a}-O-R^{c}-, (preferably alkyl terminated) di- or polyethylene glycol, and di- or polypropylene glycol, and wherein R14 does not comprise more than 10 carbon atoms.

In a highly preferred embodiment, at least one, more preferably at least two, even more preferably at least three, in particular each, mono- or bivalent ligand L is/are selected from the group consisting of: 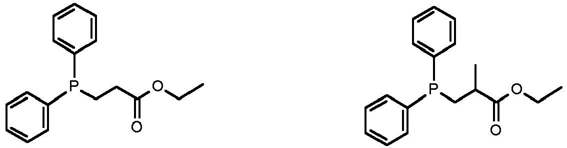 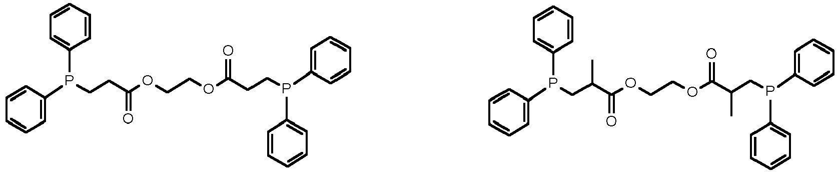 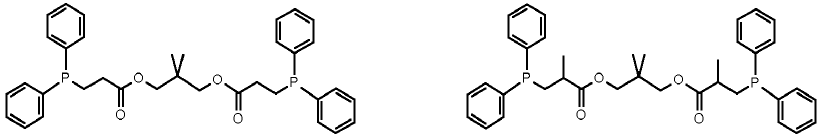 and 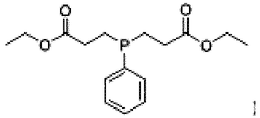 wherein the phosphorous is bound to Cu.

In a preferred embodiment, the copper (I) complex is selected from the group consisting of: 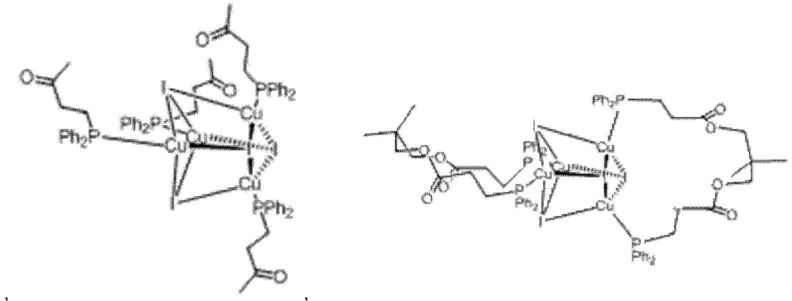 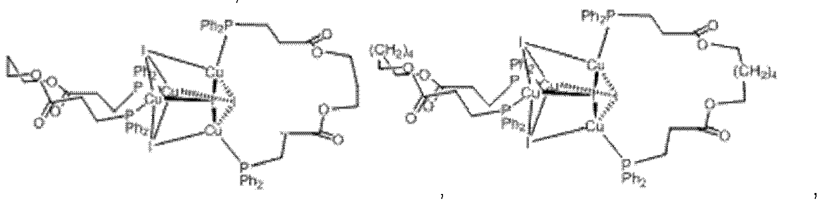 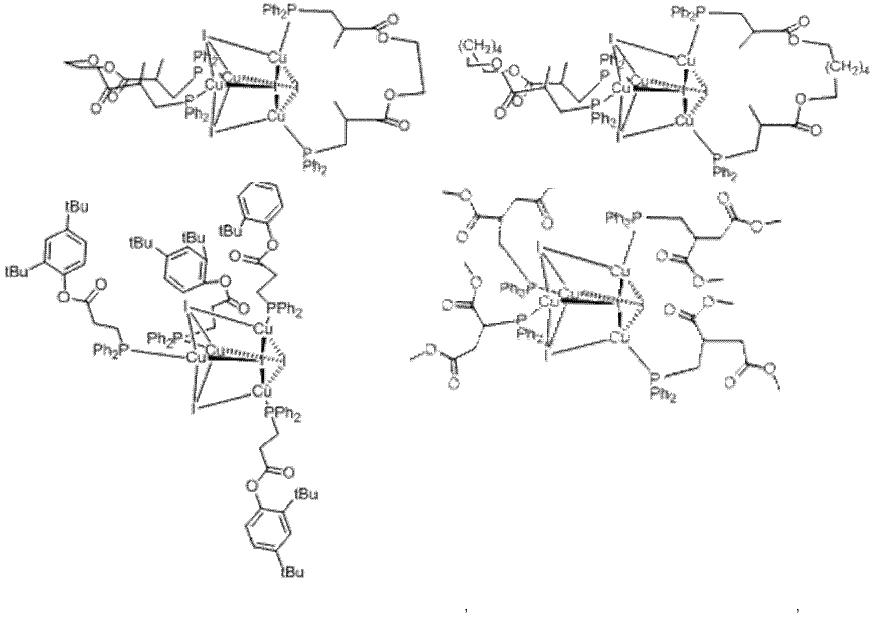 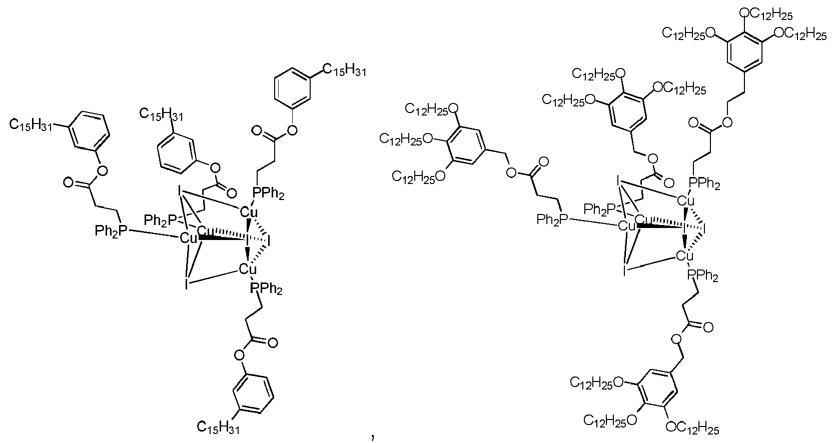 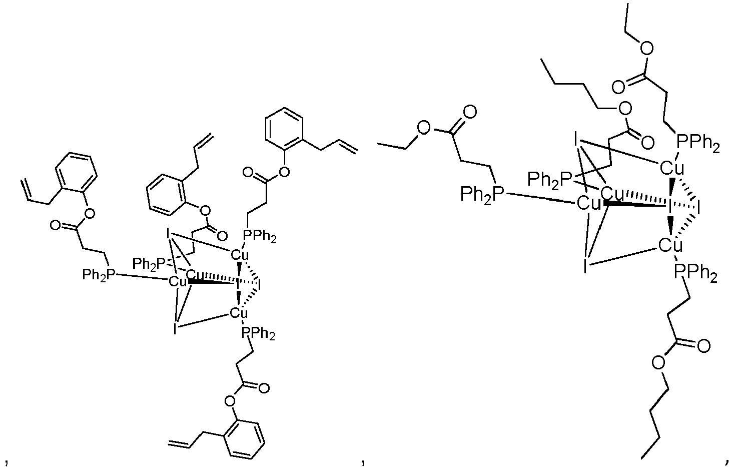 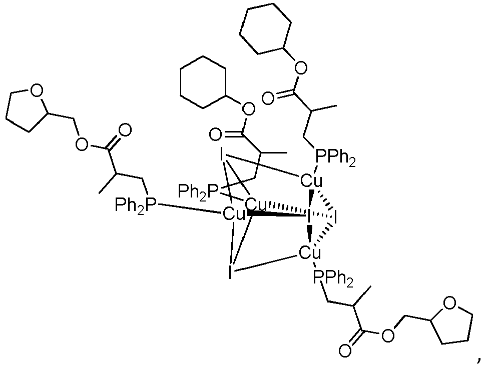 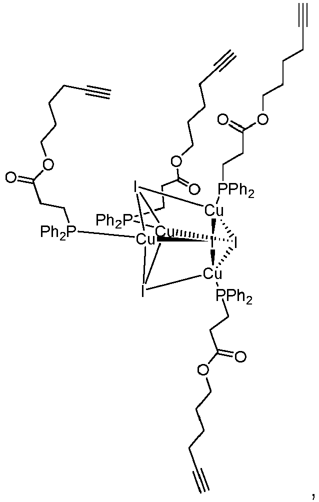 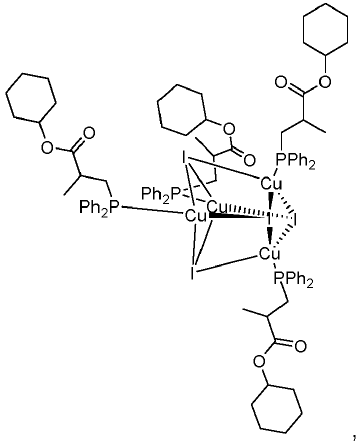 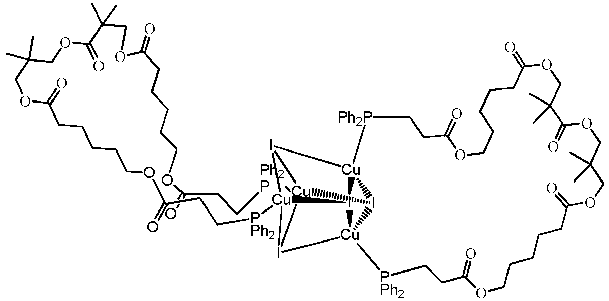 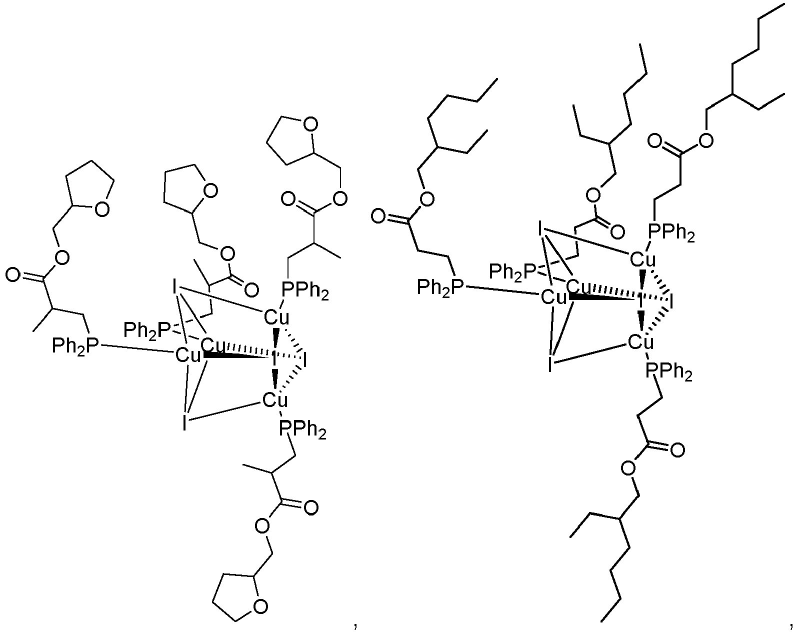 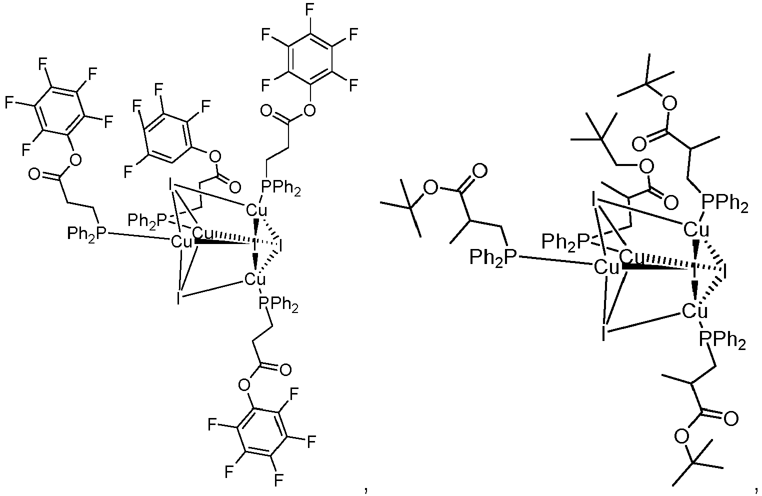 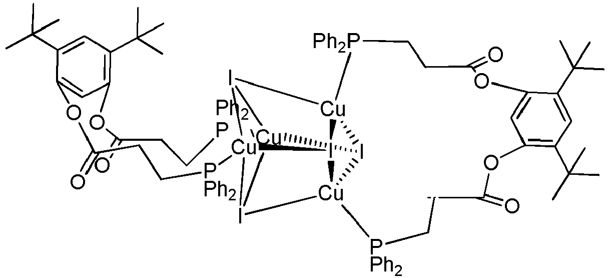 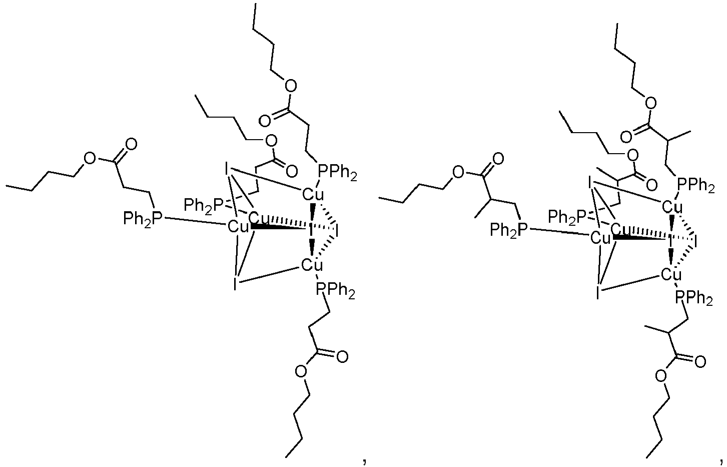 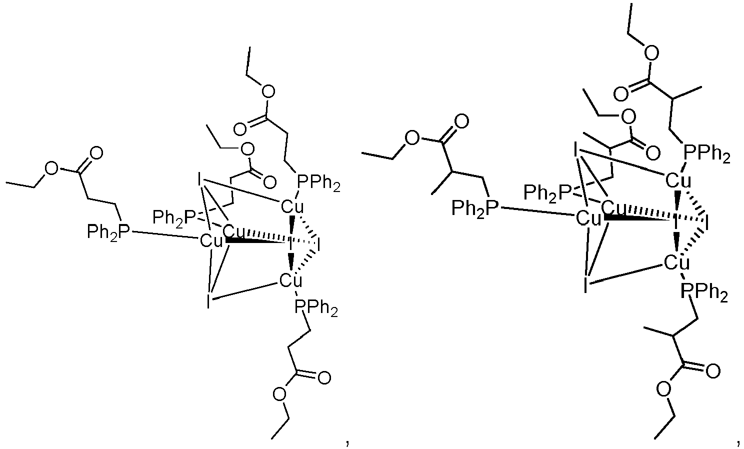 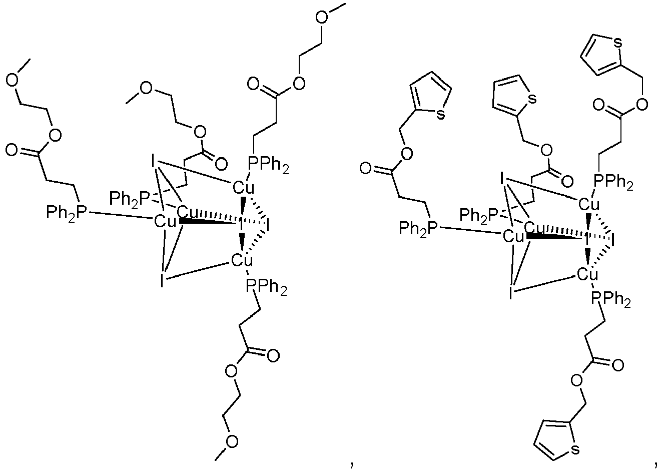 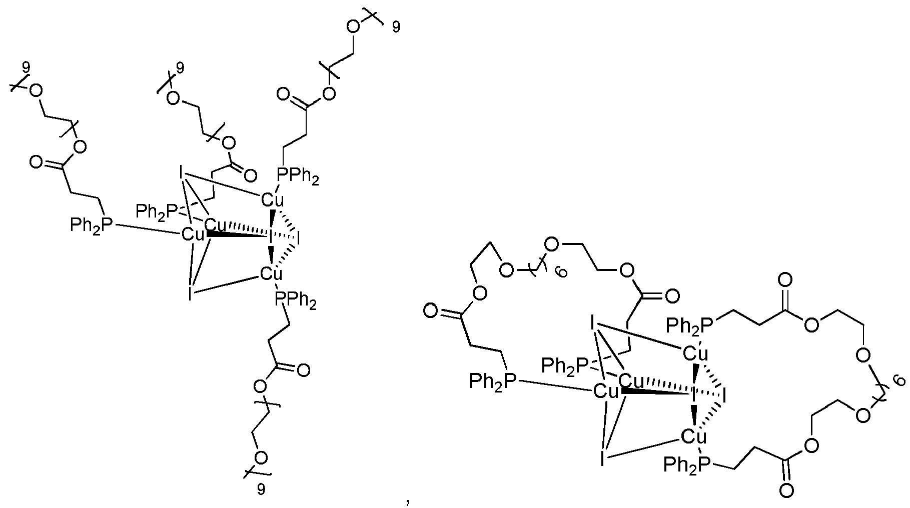 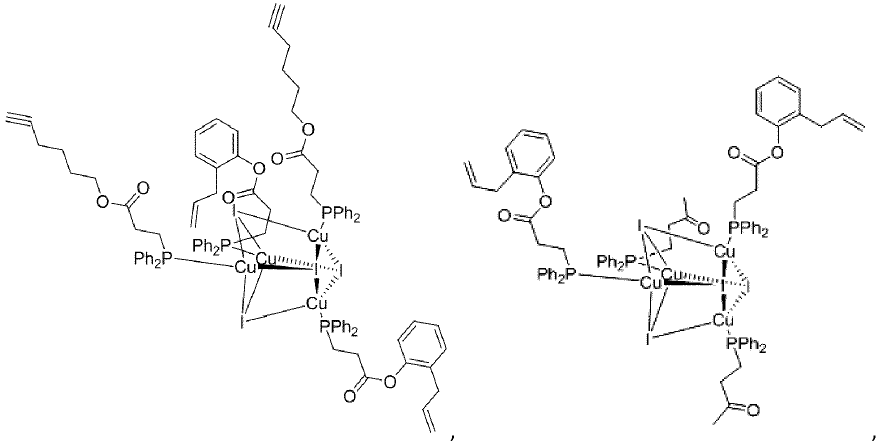 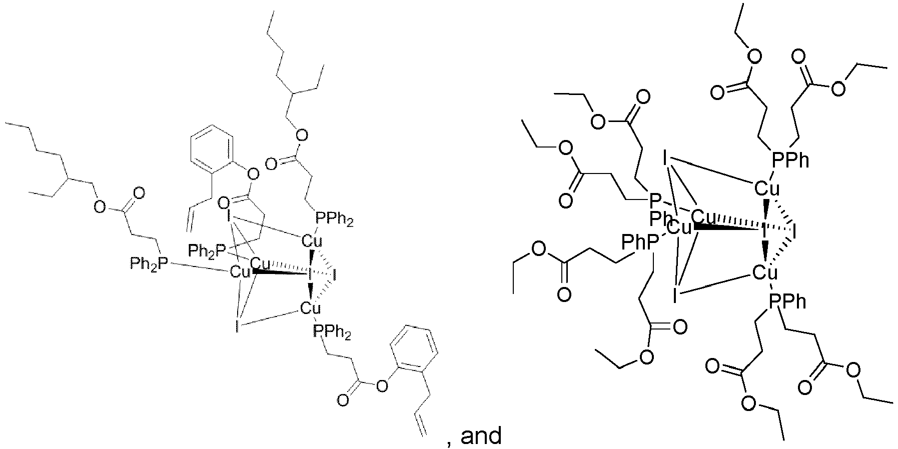 wherein Ph is an unsubstituted phenyl residue.

A copper (I) complex of the present invention can be prepared by various methods. The present invention also refers to means for preparing a copper (I) complex of the present invention.

In a preferred embodiment, the copper (I) complex of the present invention has an excitation maximum of from 290 to 370 nm and emission maximum of from 500 to 620 nm. This emission maximum is typically determined in dry state. Preferably, all photophysical properties (emission, excitation and quantum yield) were determined in the dry state (no solvent).

A further aspect of the invention relates to a method for generating a copper (I) complex of the present invention, said method comprising the following steps:
(i) providing, in an inert atmosphere:
   (a) copper (I) halide,
   (b) an electronically neutral substituted ligand L as defined above, and
   (c) a solvent in which components (a) and (b) are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

The definitions and preferred embodiments as laid out in the context of the copper (I) complex of the present invention above *mutatis mutandis* apply to any of the methods for preparing such.

Step (i) of providing the components (a)-(c) may be performed by any means. Preferably, the components (a)-(c) are provided in the (essential) absence of water, in particular in the (essential) absence of water and oxygen. Accordingly, (essentially) water-free solvent is used. The components (a)-(c) may be provided by any means for providing an inert atmosphere such as, e.g., an airproof container. in any type of airproof container. Such airproof container may be a Schlenck tube. Such airproof container may be flame-dried. It will be understood, that, in particular at an industrial scale, also other airproof containers may be used. For providing an inert atmosphere, any protection gas (also : inert gas) may be used. For example a noble gas (e.g., argon) or nitrogen may be used as an inert atmosphere. Preferably, an inert atmosphere may be under argon atmosphere.

Copper (I) halide (also copper (I) halogenide) may be any salt composed of copper (I) ions (Cu⁺) and halide ions (X⁻), i.e., any CuX salt. Preferably, only a single type of halide is used. The copper (I) halide may be Cul, CuBr, CuCl, CuF or CuAt. Preferably, the copper (I) halide is Cul, CuBr, CuCl or CuF, more preferably Cul, CuBr or CuCl, even more preferably Cul or CuBr. In particular, the copper (I) halide is Cul (copper (I) iodide).

The an electronically neutral substituted ligand L may be such as defined above, preferably an unsubstituted or substituted diarylphosphine ligand (PHPh₂), in particular unsubstituted or substituted diphenylphosphine ligand (PHPh₂). Preferably, only a single kind of ligand is used. Alternatively, also bivalent ligands may be used.

The solvent may be any solvent usable to dissolve components (a) and (b), i.e., the copper (I) halide and the electronically neutral substituted ligand L. Preferably, the solvent is (essentially) free of water, in other words, is a dry solvent. It will be understood that the solvent may also be a mixture of two or more components. For example, the solvent may be selected from dry toluene, dichloromethane, tetrahydrofuran (THF), methyltetrahydrofuran (methyl-THF), or mixtures thereof. It will be understood that the person skilled in the art will adapt the solvent to the solubility of the used components (a) and (b), in particular of the ligand L.

The step (ii) of incubating the solution at conditions allowing the formation of the copper (I) complex may be performed at any conditions suitible for this purpose. It will be understood that the person skilled in the art will adapt this step to the used components (a) and (b), in particular of the ligand L. In a preferred embodiment, step (ii) is conducted at a temperature in the range of between 80 and 250°C, preferably at a temperature in the range of between 90 and 200°C, preferably at a temperature in the range of between 100 and 150°C, preferably at a temperature in the range of between 100 and 120°C, preferably at a temperature in the range of between 105 and 115°C, for example at a temperature of approximately 110°C. In a preferred embodiment, step (ii) is conducted for at least one hour, more preferably for at least two hours, even more preferably for at least four hours, even more preferably for at least twelve hours, even more preferably for between 12 and 48 hours, even more preferably for between 20 and 28 hours, even more preferably for between 22 and 26 hours, exemplarily for approximately 24 hours. Accordingly, in a preferred embodiment, step (ii) is conducted at a temperature in the range of between 80 and 250°C for at least 1 hour. In a more preferred embodiment, step (ii) is conducted at a temperature in the range of between 100 and 150°C for between 12 and 48 hours. In an even more preferred embodiment, step (ii) is conducted at a temperature in the range of between 105 and 115°C for between 22 and 26 hours. In an even more preferred embodiment, step (ii) is conducted at a temperature in the range of between 100 and 120°C for between 20 and 28 hours.

Exemplarily, step (ii) is conducted at a temperature of approximately 110°C for approximately 24 hours. Then, the mixture obtained from step (ii) may be cooled down to room temperature (RT).

As an optional further step (iii), the solvent may be removed. This may be performed by any means such as, e.g., by means of a vacuum. For example, at a laboratory scale, a rotary evaporator or a dissicator may be used for this step. will be understood, that, in particular at an industrial scale, also other means may be used. In this step (iii), a solid residue of the copper (I) complex of the present invention may be obtained.

As an optional further step (iv), a composition comprising the copper (I) complex of the present invention obtainable from any of the above steps is contacted with an anti-solvent. Preferably, a solid residue of the copper (I) complex of the present invention is prepared and dissolved in a suitable solvent. The solvent may be any solvent usable to dissolve the copper (I) complex of the present invention. It will be understood that the solvent may also be a mixture of two or more components. For example, the solvent may be dichloromethane (CH₂Cl₂). It will be understood that the person skilled in the art will adapt the solvent to the solubility of the copper (I) complex of the present invention.

As used throughout the present invention, the term "anti-solvent" may be understood in the broadest sense as any liquid in which the copper (I) complex of the present invention is less soluble. Thus, when the solution comprising the copper (I) complex of the present invention is mixed with the anti-solvent, it may at least partly precipitate.

The anti-solvent may be any liquid suitible for this purpose. It will be understood that the person skilled in the art will adapt the anti-solvent to the solubility of the copper (I) complex of the present invention. For example, the anti-solvent may be diethyl ether (Et₂O). Optionally, the precipitate may also be washed once, or more often by an anti-solvent. Optionally, the copper (I) complex of the present invention may be dried by any means, e.g., by means of filtration, centrifugation, evaporation, etc. For example, the copper (I) complex of the present invention may be dried under vacuum.

The copper complex may, however, also prepared by using an electronically neutral phosphine ligand precursor and an unbound (meth)acrylate derivative AD compound and combine these during the synthesis

Accordingly, a further aspect of the present invention relates to a method for generating a copper (I) complex of the present invention, said method comprising the following steps:
(i) providing, in an inert atmosphere:
   (a') copper (I) halide,
   (b') educts of the ligand L:
      (b1') an electronically neutral phosphine ligand precursor of formula (L1):

         PH(Ar)ₒ(CHR2-CHR1-CO-Y-Rx)ₚ (L1),

         wherein:
         o is an integer from 0 to 2; and
         p is an integer from 0 to 2;
         the sum of o and p is 2,
         and P, H, Ar, R1, R2, Y and Rx are defined laid out throughout the present invention; and
      (b2') an unbound (meth)acrylate derivative AD compound;
   (c') a solvent in which components (a'), (b1') and (b2') are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

The step (ii) of provision of providing the components (a'), (b') and (c') (of step (i) may be performed as described for components (a), (b) and (c) above. Dry toluene or alternative solvents may be used as solvent (c'). Also step (ii) and optional steps (iii) and (iv) may be each conducted as described in the method above.

In a preferred embodiment, the reaction of step (ii) of the above method may be performed by the following reaction:

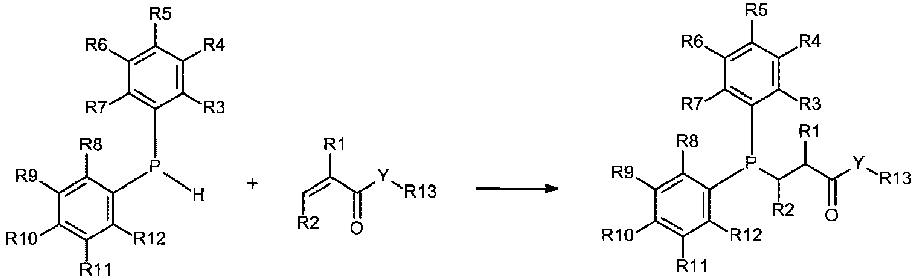

Herein, each of R1-R12 may be defined as above; Y may be a single bond, O or NH, in particular O or a single bond to a carbon atom of R13; and
R13 is C₁-C₂₀-alkyl, alkyl terminated polyethylene glycol, di- or polypropylene glycol, unsubstituted or substituted phenyl, or a polypropylene glycol chain.

Preferably, all residues R1-R13 and Y are defined as above. It will be understood that a corresponding reaction can also be performed with a bivalent compound.

In a preferred embodiment, an electronically neutral phosphine ligand precursor of formula (L1) is according to formula (L1'):

PHAr₂ (L1'),

wherein the residues are defined as defined throughout the present invention.

A further aspect of the present invention relates to a method for generating a copper (I) complex of any of the present invention, said method comprising the following steps:
(i) providing, in an inert atmosphere:
   (a") a copper (I) complex precursor of Formula (A') 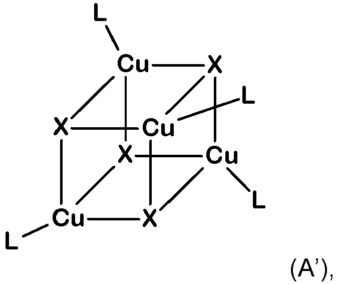 wherein:
      each Cu is copper (I);
      each X is independently from another halogen,
      each L is independently from each other a ligand of formula (L1'):

         PH(Ar)ₒ(CHR2-CHR1-CO-Y-Rx)ₚ (L1'),

         wherein:
         o is an integer from 0 to 2; and
         p is an integer from 0 to 2;
         the sum of o and p is 2,
         and P, H, Ar, R1, R2, Y and Rx are defined as laid out throughout the present invention; and
         wherein said copper (I) complex has a neutral net charge,
   (b") an unbound (meth)acrylate derivative AD compound, and
   (c") a solvent in which components (a") and (b") are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

Step (i) of providing the components (a)-(c) may be performed by any means. Preferably, the components (a)-(c) are provided in the (essential) absence of water, in particular in the (essential) absence of water and oxygen as described in the method above.

In a preferred embodiment, the copper (I) complex precursor of Formula (A') is dissolved in suitable solvent such as, e.g., dry acetonitrile, dichloromethane or a combination thereof. Alternatively, also other solvents may be used as solvent (c").

In a preferred embodiment, an electronically neutral phosphine ligand precursor of formula (L1) is according to formula (L1') as laid out above.

The unbound (meth)acrylate derivative AD compound may be added by any means. Preferably, step (ii) is conducted at a temperature range of from 50°C to 100°C, more preferably from 55°C to 90°C, even more preferably from 60°C to 80°C, even more preferably from 65°C to 75°C, in particular at approximately 70°C. In a preferred embodiment, step (ii) is conducted for at least one hour, more preferably for at least two hours, even more preferably for at least three hours, even more preferably in a time range of from three to 24 hours, more preferably from four to twelve hours, in particular from five to eight hours. In a preferred embodiment, step (ii) is conducted for at least one hour at a temperature in the range of from 50°C to 100°C. In a more preferred embodiment, step (ii) is conducted for at least three hours at a temperature in the range of from 60°C to 80°C. In an even more preferred embodiment, step (ii) is conducted for four to twelve hours at a temperature in the range of from 65°C to 75°C. In particularly preferred embodiment, step (ii) is conducted for five to eight hours at a temperature of approximately 70°C.

Optional steps (iii) and (iv) may preferably be conducted as laid out in the context of the above methods.

The (meth)acrylate derivative AD may be any compound having a (meth)acrylate core structure. Exemplarily, it may be an acrylate, an acrylamide, an alkyl acrylate, or an alkyl acrylamide. In a preferred embodiment, the (meth)acrylate derivative AD compound is a compound of Formula (B): 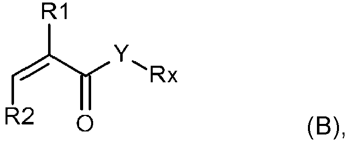 wherein:
R1 is hydrogen, -R^{a}-R^{b}, -O-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, deuterium, or halogen;
R2 is hydrogen, -O-R^{b}, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, or -R^{a}-CO-R^{b}, deuterium, or halogen;
Y is O, NH or a bond to a carbon atom of residue Rx or is N bound to two independent Rx, preferably wherein Y is O or a bond to a carbon atom of residue Rx;
Rx is a residue comprising from 1 to 30 carbon atoms, a polymeric moiety, or a solid support, wherein Rx may optionally be or contribute to a linker that interconnects two ligands L with another;
R^{a} at each occurrence independently from each other is a single bond, at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue; and
R^{b} at each occurrence independently from each other is an unsubstituted or substituted C₁-C₂₀-(hetero)alkyl residue, an unsubstituted or substituted C₂-C₂₀-(hetero)alkenyl residue, an unsubstituted or substituted C₂-C₂₀-(hetero)alkinyl residue, an unsubstituted or substituted C₁-C₂₀-(hetero)cycloalkyl residue, an unsubstituted or substituted C₂-C₂₀-(hetero)cycloalkenyl residue, an unsubstituted or substituted C₂-C₂₀-(hetero)cycloalkinyl residue, an unsubstituted or substituted C₂-C₂₀-(hetero)aromatic residue, or an unsubstituted or substituted C₂-C₂₀-alk(hetero)aromatic residue.

It will be understood that the meth)acrylate derivative AD compound may, alternatively, also have the following formula (B'):

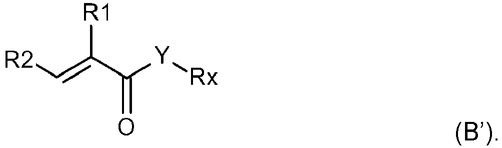

In a preferred embodiment, the (meth)acrylate derivative AD compound is selected from the group consisting of acrolein, isopentyl diacrylate, propanediol diacrylate, hexanediol diacrylate, ethanediol dimetacrylate, hexanediol dimetacrylate, ditertbutylphenol acrylate, methyl itaconate, cardanol acrylate, ortho-allyl-phenol acrylate, hex-1-yne acrylate, cyclohexyl metacrylate, furane metacrylate, ethylhexyl acrylate, perfluoroaryl acrylate, tert.-butyl metacrylate, butyl acrylate, butyl metacrylate, ethyl acrylate, ethyl metacrylate, PEG-1 to PEG-20 acrylate (in particular PEG-9 acrylate), hexyl 1,6 diethylene glycol acrylate, thiophene acrylate, methylacrylate, methyl acrylate, and diterbutyl catechol acrylate.

In a preferred embodiment, the compounds may be conjugated as follows: 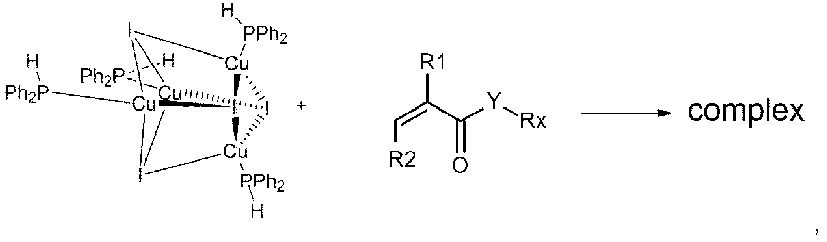 or 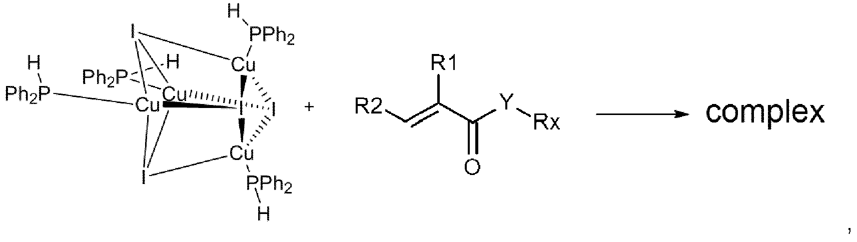 wherein the residues are defined as above. It is understood that this scheme also works with a mixture of two (or more) different moities of Formula (B) and/or (B'). It will be understood that each Ph may independently from another be replaced by any Ar. In a preferred embodiment, this step is conducted according to the following scheme:

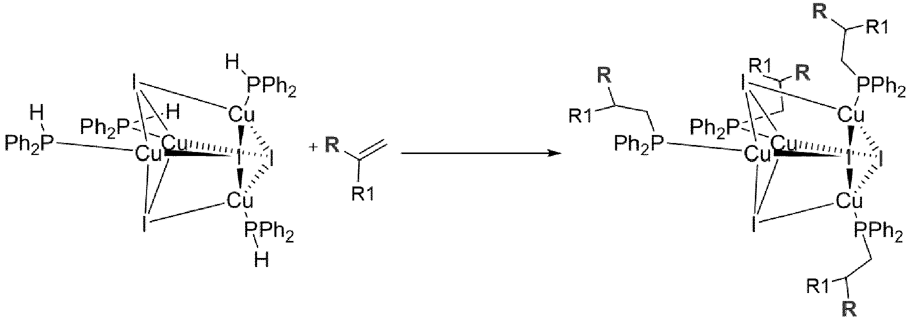

It will be understood that each Ph may independently from another be replaced by any Ar. Also two different ligands may be used. Thus, in an alternative preferred embodiment, this step is conducted according to the following scheme:

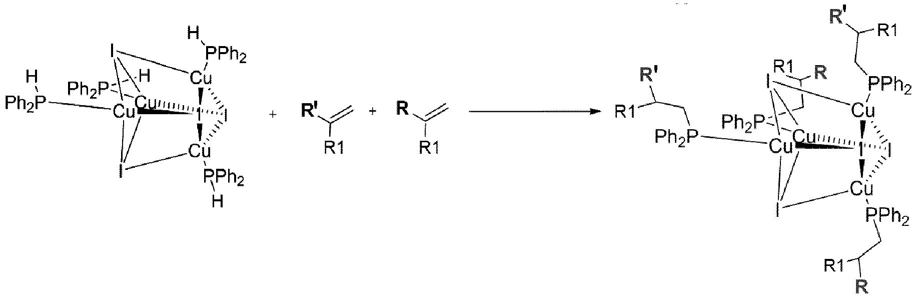

It will be understood that each Ph may independently from another be replaced by any Ar. Herein, the residues R and R' may, for example, be independently from another selected from the following the following: 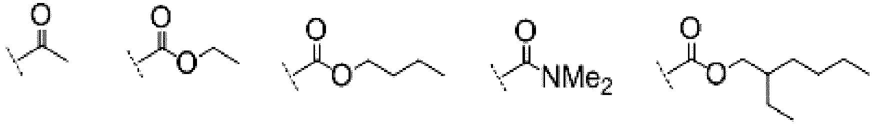 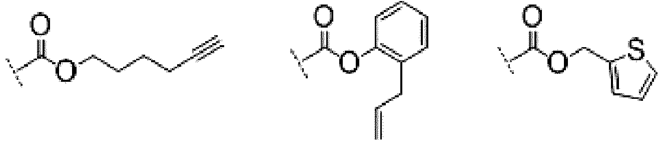 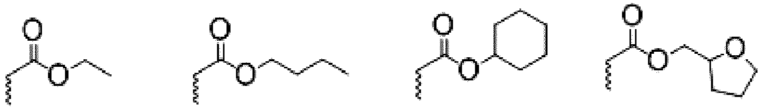 wherein the dashed line indicates the binding site to a -CH=CH₂ moiety (acrylate derivative) and the waved line indicates the binding site to a -C(CH₃)=CH₂ moiety (methacrylate derivative).

Preferably, the reaction is conducted under UV light (e.g., at 455 nm), e.g., obtained by a light-emitting diode (LED) (e.g., LED 455). DCM may be used as solvent. The reaction may be conducted at room temperature for, e.g., 1-4 hours. The unsaturated moiety (B) may be used in a stoichiometric amount around 4 eq or slightly above this level such as 4.2 eq. When a mixture of two different unsaturated moieties (B) are used, these may be each used in approximately half of the stoichiometric amount, i.e., each at around 2 eq, or slightly above, e.g., 2.1 eq.

Furthermore, the present invention relates to the use of a copper (I) complex of the present invention for the production of electronic components or thermal stabilization of engineering thermoplastics or as modifiers of light transmission through the poly-olefins films for agriculture.

Accordingly, a further aspect of the present invention relates to an opto-electronic device containing a copper (I) complex of the present invention.

The copper (I) complexes of the present invention may be used as a host or a guest in an opto-electronic device. An opto-electronic device may be any device sufficient for generating light when an electrical current flow is applied.

Preferably, an opto-electronic device is selected from the group consisting of organic light-emitting diodes (OLED, e.g., an thermally activated delayed fluorescence (TADF) OLED), organic solar cells, electrographic photoreceptors, organic dye lasers, organic transistors, photoelectric converters, and organic photodetectors.

Accordingly, a further aspect of the present invention relates to the use of an opto-electronic device containing a copper (I) complex of the present invention for generating light at a wavelength range of 450 to 600 nm, in particular 500 to 580 nm.

A further aspect of the present invention relates to the use of a copper (I) complex of the present invention for thermal stabilization of a thermoplastic molding mass.

The Figures and Examples depicted below and the claims are intended to illustrate further embodiments of the present invention.

### Brief description of the Figures

**Figure 1** shows the three-dimensional structure of a copper (I) complex of the present invention: Example Complex 2.
**Figure 2** shows the three-dimensional structure of a copper (I) complex of the present invention: Example Complex 3.
**Figure 3** shows the three-dimensional structure of a copper (I) complex of the present invention: Example Complex 23.
**Figure 4** shows the three-dimensional structure of a copper (I) complex of the present invention: Example Complex 33.

### Examples

### Synthesis of the copper (I) complexes of the present invention:

### Process A)

Copper(I) Iodide, phosphine and dry toluene* were placed in a flame-dried Schlenck tube under argon. The solution was heated at 110°C during 24 hours. Then the mixture was cooled down to the room temperature and the solvent was removed under vacuum. The solid residue was dissolve in dichloromethane (CH₂Cl₂) and the solution was poured into diethyl ether (Et₂O). The complex precipitates directly and was filtrate and washed several times with Et₂O. The product was dried under vacuum. * Other solvents can be used (Dichloromethane or THF) depending of the solubility of phosphines

### Process B)

Copper(I) Iodide, diphenylphosphine, acrylate derivative and dry toluene were placed in a flame-dried Schlenck tube under argon. The solution was heated at 110°C during 24 hours. Then the mixture was cooled down to the room temperature and the solvent was removed under vacuum. The solid residue was dissolve in CH2CI₂ and the solution was poured into Et₂O. The complex precipitates directly and was filtrate and washed several times with Et₂O and hexane. The product was dried under vacuum.

### Process C)

Cul-diphenylphosphine complex was dissolved in dry acetonitrile (or CH2Cl2) and placed in a flame-dried Schlenck tube under argon. The acrylate derivative was added and the solution was heated at 70°C during 7 hours. Then the mixture was cooldown to the room temperature and the solvent was removed under vacuum. The solid residue was dissolve in CH₂Cl₂ and the solution was poured into Et₂O. The complex precipitates directly and was filtrate and washed several times with Et2O and hexane. The product was dried under vacuum.

### Process D)

Cul-diphenylphosphine complex was dissolved in dry dichloromethane and placed in a flame-dried Schlenck tube under argon. The acrylate derivative was added and the solution was exposed to UV light using an light-emitting diode (LED) at, for example, 365 nm during 6 hours. Then the mixture was cooled down to the room temperature and the solvent was removed under vacuum. The solid residue was dissolve in CH2Cl2 and the solution was poured into Et₂O or Hexane. The complex precipitates directly and was filtrate and washed several times with Et₂O and hexane. The product was dried under vacuum.

The following ligands were used:

**Table 1. Ligands**

| Ligand | Olefin precursor (short name) | State |
|---|---|---|
| PPh2H | | Powder |
| Ligand 2 | acrolein | Powder |
| Ligand 3 | isopentyl diacrylate | Powder |
| Ligand 4 | propanediol diacrylate | Powder |
| Ligand 5 | hexanediol diacrylate | Powder |
| Ligand 6 | ethanediol dimetacrylate | Powder |
| Ligand 7 | hexanediol dimetacrylate | Powder |
| Ligand 8 | ditertbutylphenol acrylate | Powder |
| Ligand 9 | methyl itaconate | Powder |
| Ligand 10 | 3-pentadecylphenyl acrylate | Oil |
| Ligand 11 | 3,4,5-tris(dodecyloxy)benzyl acrylate | Oil |
| Ligand 12 | ortho-allyl-phenol acrylate | Oil |
| Ligand 13 | Hex-1-yne acrylate | Oil |
| Ligand 14 | Hydroxypivalyl hydroxypivalate bis[6-(acryloyloxy)hexanoate] | Oil |
| Ligand 15 | Cyclohexyl metacrylate | Oil |
| Ligand 16 | Furane metacrylate | Oil |
| Ligand 17 | Ethylhexyl acrylate | Oil |
| Ligand 18 | Perfluoroaryl acrylate | Oil |
| Ligand 19 | 4,6-di-ter-butylbenzene-1,3 diol diacrylate | Oil |
| Ligand 20 | Tertiobutyl metacrylate | Powder |
| Ligand 21 | Butyl acrylate | Oil |
| Ligand 22 | Butyl metacrylate | Oil |
| Ligand 23 | Ethyl acrylate | Powder |
| Ligand 24 | Ethyl metacrylate | Powder |
| Ligand 29 | PEG-9 acrylate | Oil |
| Ligand 30 | Hexyl 1,6 diethylene glycol acrylate | Powder |
| Ligand 31 | Thiophene acrylate | Powder |
| Ligand 32 | Methyl acrylate | |

**Table 2. Copper (I) complexes prepared with the corresponding ligands (monochelating as Cu₄I₄(RPPh₂)₄ and bis chelating as Cu4I4(Ph₂PRPPh₂)₂)**

| ID | Phosphine used | Coordination | Procedure used | state |
|---|---|---|---|---|
| Complex 1 | PPh2H | mono | A | powder |
| Complex 2 | Ligand 2 | mono | A, B, C, D | powder |
| Complex 3 | Ligand 3 | bis | A | powder |
| Complex 4 | Ligand 4 | bis | A | powder |
| Complex 5 | Ligand 5 | bis | A | powder |
| Complex 6 | Ligand 6 | bis | A | powder |
| Complex 7 | Ligand 7 | bis | A | powder |
| Complex 8 | Ligand 8 | mono | A | powder |
| Complex 9 | Ligand 9 | mono | A | powder |
| Complex 10 | Ligand 10 | mono | A | oil |
| Complex 11 | Ligand 11 | mono | A | oil |
| Complex 12 | Ligand 12 | mono | A | oil |
| Complex 13 | Ligand 13 | mono | A | oil |
| Complex 14 | Ligand 14 | bis | A, D | oil |
| Complex 15 | Ligand 15 | mono | A, B, C | oil |
| Complex 16 | Ligand 16 | mono | A | oil |
| Complex 17 | Ligand 17 | mono | A | oil |
| Complex 18 | Ligand 18 | mono | A | oil |
| Complex 19 | Ligand 19 | mono | A | oil |
| Complex 20 | Ligand 20 | mono | A | Powder |
| Complex 21 | Ligand 21 | mono | A, D | oil |
| Complex 22 | Ligand 22 | mono | A | oil |
| Complex 23 | Ligand 23 | mono | A, D | Powder |
| Complex 24 | Ligand 24 | mono | A | Powder |
| Complex 25 | Ligand 21 + Ligand 23 | mono | A | oil |
| Complex 26 | Ligand 15 + Ligand 16 | mono | A | oil |
| Complex 27 | Ligand 12 + Ligand 17 | mono | A | oil |
| Complex 28 | Ligand 12 + Ligand 13 | mono | A | oil |
| Complex 29 | Ligand 29 | mono | A | oil |
| Complex 30 | Ligand 30 | bis | A, D | Powder |
| Complex 31 | Ligand 31 | mono | A | Powder |
| Complex 32 | Ligand 12 | | A | |
| | Ligand 32 | | | |

The chemical structures of several copper (I) complexes are depicted as follows:

### Complex 1 (Educt and Comparative Example)

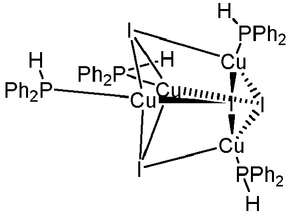

**¹H NMR** (500 MHz, CDCl₃): 5.82 (d, J=315.6 Hz, 4H), 7.18 (m, 16H), 7.26 (m, 8H), 7.49 (m, 16H) ppm. **¹³C NMR** (126 MHz, CDCl₃): δ 128.57(d, J= 9Hz), 129.59, 130.32(d, J= 29Hz), 134.1(d, J= 12.4Hz) ppm. **³¹P {¹H} NMR** (203 MHz, CDCl₃): δ -39 (br) ppm. **Anal. Calcd** for C₆₄H₆₆Cu₄I₄O₄P₄: C, 38.26; H, 2.94. Found: C, 36.49; H, 2.82. **IR (neat) v =** 2975, 1476, 1437, 1089, 887, 819, 725, 686 cm⁻¹ **ATG:** 5% par mass lost at 257°C

### Complex 2

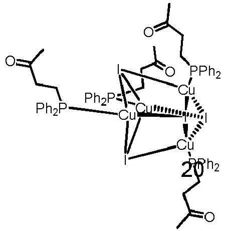

**¹H NMR** (500 MHz, CDCl₃): δ 7,60-7,50 (m, 16H), 7,39-7,32 (m, 8H), 7,31-7,25 (m, 16H), 2,69-2,56 (m, 8H), 2,51-2,51 (m, 8H), 1,91 (s, 12H) ppm. **¹³C NMR** (126 MHz, CDCl₃): δ 173,17; 133,65 (d); 133,24 (d); 129,76; 128,68 (d); 38,75 (d); 29,80 (d, *J* = *8 Hz*); 22,19 ppm.**³¹P {¹H} NMR** (203 MHz, CDCl₃): δ -29,53 (br) ppm. Anal. Calcd for C₆₄H₆₆Cu₄I₄O₄P₄: C, 43,02 ; H, 3,84. Found: C, 43,61 ; H, 3,92. **IR (neat) v =** 3053, 2912, 1710, 1575, 1487, 1434, 1356, 1215, 1159, 1099, 868, 739, 693 cm-¹. **ATG:** 5% per mass lost at 317°C

### Complex 3

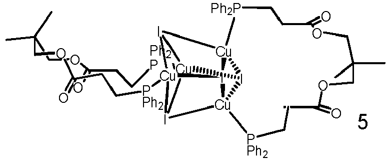

**¹H NMR** (500 MHz, CDCl₃): δ 7,63-7,54 (m, 16H), 7,43-7,36 (m, 8H), 7,34-7,27 (m, 16H), 3,91 (s, 8H), 2,69-2,53 (m, 16H), 0,91 (s, 12H) ppm. **¹³C NMR** (126 MHz, CDCl₃): δ 207,57; 133,65 (d); 133,24; 132,92; 129,76; 128,68 (d); 72,36; 35,09, 38,98 (d); 30,21 ; 20,95 (d) ppm. **³¹P {¹H} NMR** (203 MHz, CDCl₃): δ -31,75 (br) ppm. **Anal. Calcd** for C₇₁H₈₀Cu₁₄I₄O₈P₄: C, 43,80; H, 4,14. Found: C, 44,63; H, 4,1. **ATG:** 5% per mass lost at 253°C

### Complex 4

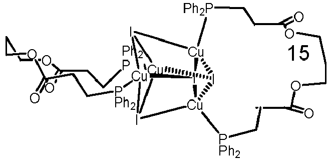

**¹H NMR** δ (500 MHz, CDCl₃): δ 7,70-7,10 (m, 40H), 4,20 (br, 8H), 3,51 (br, 2H), 2,69-2,53 (br, 16H), 1,92 (br, 4H) ppm. **¹³C NMR** (126MHz, CDCl₃) : 173,05 (d) ; 133,00 (d) ; 132,72 ; 129,62 ; 128,49 (br) ; 64,33 ; 29,50 ; 27,67 ; 22,59 ppm. **³¹P {¹H} NMR** (203 MHz, CDCl₃): δ -31,82 (br) ppm.

### Complex 5

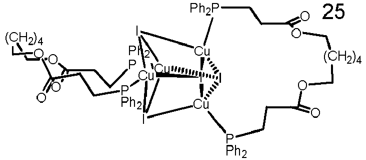

**¹H NMR** (500 MHz, CDCl₃): δ 7,83-7,12 (m, 40H), 4,11-3,63 (br, 8H), 3,51 (br 2H), 3,51 (br 2H), 2,74 (br, 2H), 2,23 (br, 2H), 0,90 (br, 12H) ppm. **¹³C NMR** (126 MHz, CDCl₃): δ 173,32; 133,48 (d, *J* = *13 Hz*); 132,86 (d, *J* = *25 Hz*); 129,81; 128,59 (d, *J = 10 Hz);* 64,74, 38,98 (d, *J* = 9 Hz);28,70; 26,46; 22, 75 (d, *J* = *21 Hz*) ppm. **³¹P {¹H} NMR** (203 MHz, CDCl₃): δ -30,52 (br) ppm.

### Complex 6

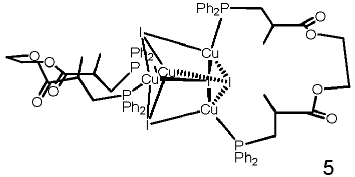

**¹H NMR** (500 MHz, CDCl₃): δ 7,83-7,12 (m, 40H), 4,11-3,63 (br, 8H ), 3,51 (br 2H), 3,51 (br 2H), 2,74 (br, 2H), 2,23 (br, 2H), 0,90 (br, 12H) ppm. **¹³C NMR** (126 MHz, CDCl₃): δ 207,57; 133,65 (d); 133,24; 132,92; 129,76; 128,68 (d); 72,36; 35,09, 38,98 (d); 30,21 ; 20,95 (d) ppm. **³¹P {¹H} NMR** (203 MHz, CDCl₃): δ -31,75 (br) ppm.

### Complex 7

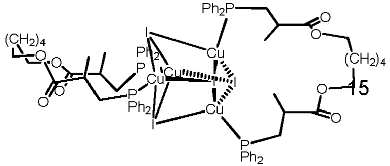

**¹H NMR** (500 MHz, CDCl₃): δ 7,83-7,12 (m, 40H), 4,11-3,63 (br, 8H), 3,51 (br 2H), 3,51 (br 2H, C**H**'), 2,74 (br, 2H, CH₂-P), 2,23 (br, 2H, CH₂-P), 0,90 (br, 12H, CH₃) ppm. **¹³C NMR** (126 MHz, CDCl₃): δ 176,52; 134,18 (m); 133,12 (m); 129,70 (m); 128,5; 64,55, 36,67; 31,57 (m); 28,78; 26,96; 26,38, 20,12 (m) ppm. **³¹P {¹H} NMR** (203 MHz, CDCl₃): δ -30,18 (br) ppm.

### Complex 8

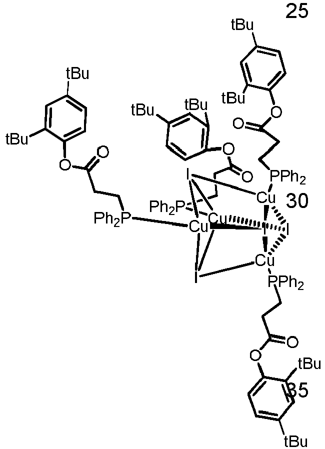

**¹H NMR** (500 MHz, CDCl₃): δ 7,83-7,12 (m, 16H), 7,40-7,29 (m, 28H), 7,16 (dd, 4H), 6,77 (d,4H), 2,86 (br, 8H), 2,74 (br, 8H), 1,27 (s, 36H), 1,19 (br, 36H) ppm. **¹³C NMR** 126 MHz, CDCl₃): δ 170,62 (d) ;146,92 ; 145,73 ; 138,88 ; 132,51 (d) ;131,59 ; 128,82 ;127,62 ; 123,002 ; 122,73 ; 122,153 ; 114,904 ; 33,62 ; 33,57 ; 30,48 ; 29,34 ; 28,66 ; 21,18 (br). **³¹P {¹H} NMR** (203 MHz, CDCl₃): δ - 29,80 (br) ppm.

### Complex 9

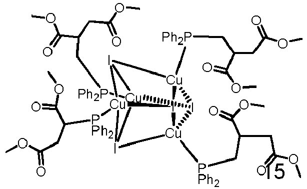

**¹H NMR** (500 MHz, CDCl₃): δ 7,65-7,50 (m, 16H), 7,40-7,25 (m, 24H), 3,38 (s, 24H), 3,29 (br, 4H), 2,90-2,70 (m, 4H), 2,65-2,45 (m, 12H) ppm. **¹³C NMR** (126 MHz, CDCl₃): δ 174,31 (d); 171,87;133,56 (m); 132,39 (d), 129,89 (dd); 128,59 (d); 52,19; 51,64; 37,86 (d); 36,59 (d); 28,22 (d) ppm. **³¹P {¹H} NMR** (203 MHz, CDCl₃): δ -28,66 (br) ppm. **IR (neat) v =** 3033, 2946, 1730, 1579, 1487, 1477, 1436, 1366, 1191, 1099, 1011, 795, 688 cm⁻¹

### Complex 10

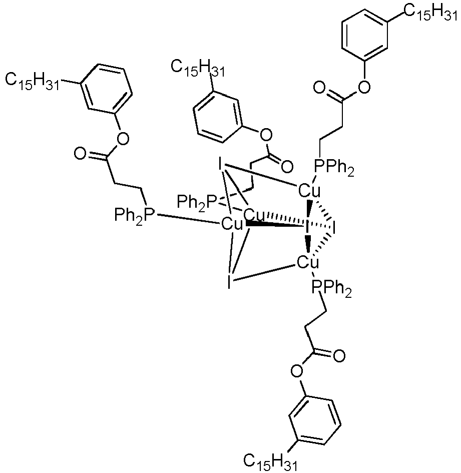

**¹H NMR** (500 MHz, CDCl₃): δ 7,70-7,57 (br, 16H), 7,37-7,27 (m, 24H), 7,20-7,14 (m, 4H), 7,00-6,95 (d, 4H), 6,79-6,72 (m, 8H) 2,90-2,74 (br, 8H), 2,73-2,63 (br, 8H), 2,52 (t, 8H), 1,54 (br, 8H), 1,25 (s, 96H), 0,86 (t, 12H ) ppm **¹³C NMR** (126 MHz, CDCl₃): δ 171,61 (d); 152,87;144,66 (m); 133,49 (d), 132,89 (dd); 128,59 (d); 125,86, 124,49, 118,82, 36,01 ; 32,15 ; 31,43 ; 29,90 ; 29,82 ; 29,73 ; 29,58 ; 22,88 ; 14,28 ppm. **³¹P {¹H} NMR** (203 MHz, CDCl₃): δ -29,76 (br) ppm.

### Complex 11

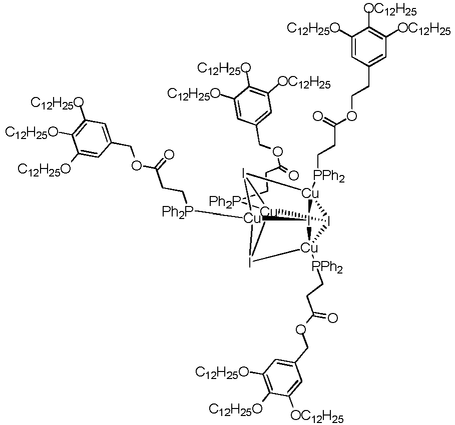

**¹H NMR** (500 MHz, CDCl₃): δ 7,63-7,47 (br, 16H), 7,34-7,20 (m, 24H), 6,48 (s, 8H, ι), 3,90 (br, 24H), 2,73-2,63 (br, 16H), 1,80-1,66 (br, 24H*)*, 1,44 (br, 24H), 1,27 (s, 192H), 0,88 (t, 36H) ppm **¹³C NMR** (126MHz, CDCl₃): δ 171,75 ; 152,15 ; 137,08 ; 132,29 (d) ; 129,66 ; 128,72 ; 127,62 (d) ; 105,92 ; 72,39 ; 68,09 ; 65,85 ; 30,94 ; 29,91 ; 29,36 ; 28,76 ; 28,73 ; 28,67 ; 28,47 ; 28,38 ; 25,15 ; 21,70 ; 13,12 ppm. **³¹P {¹H} NMR** (203 MHz, CDCl₃): δ -30,20 (br) ppm.

### Complex 12

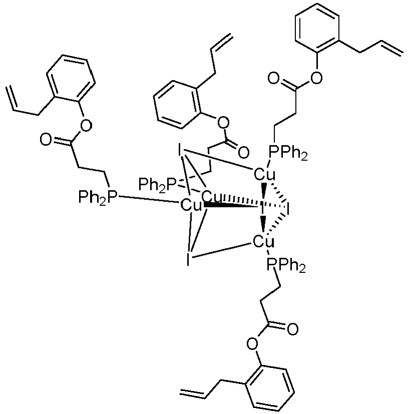

**¹H NMR** (500 MHz, CDCl₃): δ 2.63 (m, 8H), 2.77 (m, 8H), 3.05 (d, 8H), 4.84 (m, 8H), 5.68 (m, 4H), 6.80 (m,4H), 7.06 (m, 12H), 7.26 (m, 24H), 7.55 (m, 16H) ppm. **¹³C NMR** (126 MHz, CDCl₃): δ 23.12(d, J= 17.3Hz), 29.65 (d, J= 8Hz), 34.57, 116.26, 122.37, 126.02, 127.30, 128.53 (d, J= 9Hz), 129.82, 130.28, 131.85, 132.62 (d, J= 29Hz), 133.28 (d, J= 12.0 Hz)), 135.77, 148.91 171.34 (d, J= 17Hz) ppm. **³¹P {¹H} NMR** (203 MHz, CDCl₃): δ: -30 (br) ppm. **IR (neat) v =** 3070, 2985, 2910, 1751, 1579, 1487, 1429, 1346, 1215, 1123, 912, 730, 686 cm⁻¹

### Complex 13

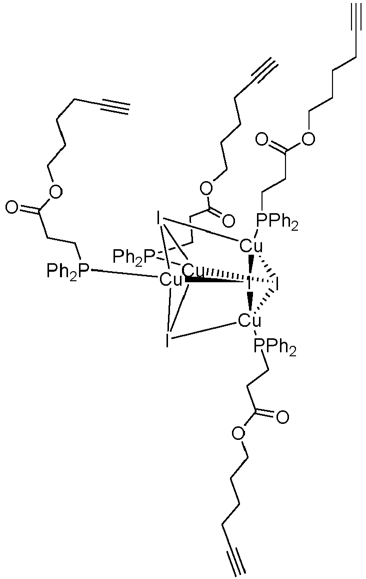

**¹H NMR** (500 MHz, CDCl₃): δ 1.53 (m, 8H), 1.66 (m, 8H), 1.94 (m, 4H), 2.17 (td, J=7.3Hz, 8H), 2.57 (m, 16H), 4.01 (t, 8H), 7.32 (m, 24H), 7.60 (m, 16H) ppm. **¹³C NMR** (126 MHz, CDCl₃): δ 18.08, 22.29 (d, J= 17.3Hz), 24.84, 27.55, 29.44(d, J= 8Hz), 64.16, 68.81, 83.94, 128.79 (d, J= 9Hz), 129.67, 132.78 (d, J= 29Hz), 133.40 (d, J= 12.0 Hz)), 173.03 (d, J= 17Hz) ppm. **³¹P {¹H} NMR** (203 MHz, CDCl₃): δ -30 (br) ppm. **IR (neat)** v = 3291, 3056, 2948, 1725, 1479,1429, 1344, 1220, 1169, 1094, 735, 684cm⁻¹

### Complex 14

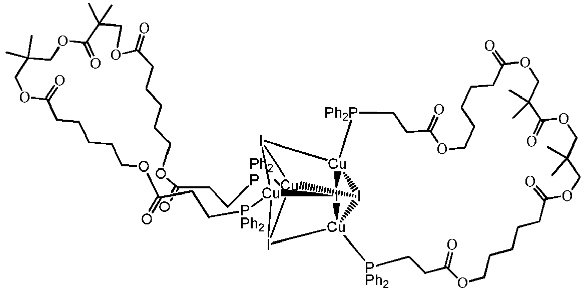

**³¹P NMR** (161 MHz, CDCl₃) δ: -31(br) ppm
IR (neat) v = 3055, 2951, 1730, 1475, 1429, 1218, 1147, 1031, 730, 693.cm⁻¹

### Complex 15

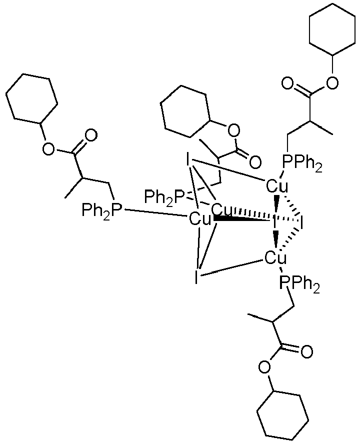

**¹H NMR** (500 MHz, CDCl₃): δ 7.70 (m, 8 H), 7.65 (m, 8 H), 7.31 (m, 24 H), 4.44 (m, 4H), 2.96 (m, 8H), 2.80 (m, 8H), 2.31 (m, 4H), 1.72 (m, 8H), 1.51 (m, 8H), 1.27 (m, 16H), 1.15 (d, ¹J = 7.0 Hz, 12H) ppm. **¹³C NMR** (126 MHz, CDCl₃): δ 18.76(d, J= 7 Hz), 23.56 (d, J= Hz), 25.39, 30.44 (d , J= 15.5 Hz), 31.31 (d, J= 6 Hz)), 36.35(d, J= 7.0 Hz), 72.57, 128.30 (t), 129.27 (d), 133.02 (d, J= 12.6 Hz)), 134.24(d, J= 13.5 Hz)), 175.45(d, J= 9Hz)) ppm. **³¹P {¹H} NMR** (203 MHz, CDCl₃): δ -30 (br) ppm. **IR (neat)** v = 3069, 2928, 2855, 1722, 1450, 1430, 1194, 1153, 1012, 912, 740, 695 cm⁻¹

### Complex 16

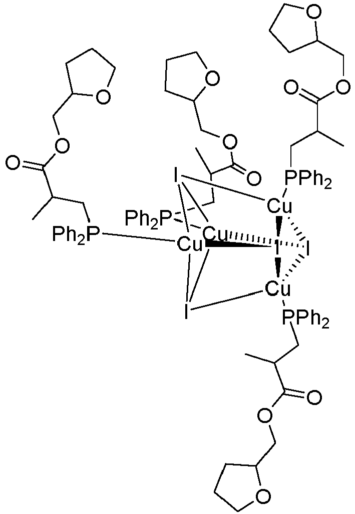

**¹H NMR** (500 MHz, CDCl₃): δ 7.69 (m, 8 H), 7.58 (m, 8 H), 7.33 (m, 24 H), 3.97 (m, 12H), 3.76 (m, 8H), 2.99(m, 4H), 2.81(m, 4H), 2.36 (m, 4H), 1.85 (m, 12H), 1.51 (m, 4H), 1.22 (d, ¹J = 7.0 Hz, 12H) ppm. **¹³C NMR** (126 MHz, CDCl₃): δ 18.61(d, J= 7 Hz), 25.72 (d, J= 9 Hz), 28.01(d, J= 4 Hz), 36.17 (d, J= 7.7 Hz), 64.41(d, J= 11Hz), 68.4(d, J= 7 Hz), 76.25 (d, 4Hz), 128.48 (t), 129.27 (d), 133.02 (d, J= 12.6 Hz)), 134.24(d, J= 13.5 Hz)), 175.45(d, J= 9Hz) ppm. **³¹P {¹H} NMR** (203 MHz, CDCl₃): δ -30 (br) ppm. **IR (neat)** v = 3065, 2970, 2861, 1715, 1480, 1446, 1429, 1164, 1111, 1016, 819, 737, 686 cm⁻¹

### Complex 17

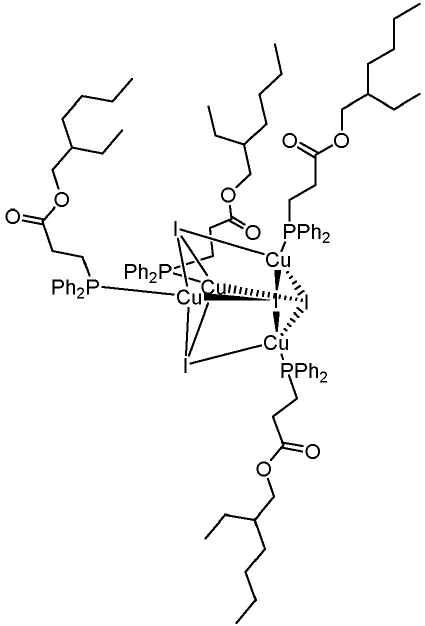

**¹H NMR** (500 MHz, CDCl₃): δ 0.8 (m, 24H), 1.31 (m, 32H), 1.51 (m, 4H), 2.57 (m, 16H), 3.91 (dd, 8H), 7.33 (m, 24H), 7.60 (m, 16H) ppm. **¹³C NMR** (126 MHz, CDCl₃): δ 9.95, 13.05, 21.30(d, J= 17.3Hz), 21.94, 22.67, 28.96, 29.32 (d, J= 8), 30.45, 37.67, 66.24, 127.76(d, J= 9Hz), 128.59, 130.05(d, J= 28Hz), 132.35(d, J= 12.1Hz),), 1723.23(d, J= 17Hz) ppm. **³¹P {¹H} NMR** (203 MHz, CDCl₃): δ -30 (br) ppm. **IR (neat) v =** 3054, 2958, 2864, 1730, 1456, 1431, 1378,1344, 1220, 1162, 1096, 737, 689 cm⁻¹

### Complex 18

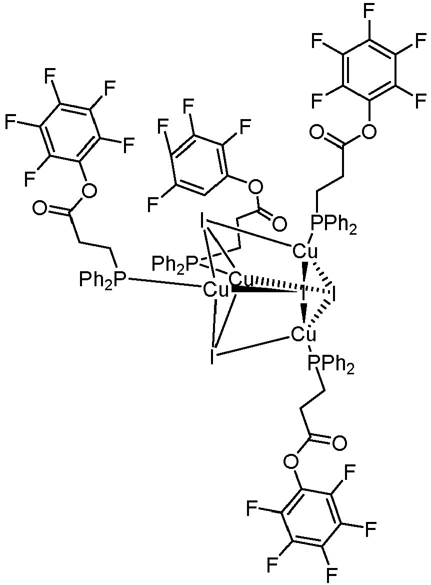

**¹H NMR** (500 MHz, CDCl₃): δ 2.69 (m, 8H), 2.90 (m, 8H), 7.34 (m, 24H), 7.61 (m, 16H) ppm. **¹³C NMR** (126 MHz, CDCl₃): δ 22.90(d, J= 17.3Hz), 30.13 (d, J= 8Hz, 128.71 (d, J= 9Hz),129.61, 130(d), 132.85(d, J= 28Hz), 133.38(d, J= 12.1Hz), 139 (d), 134 (d), 142 (d), 169.32(d, J= 17Hz) ppm. **³¹P {¹H} NMR** (203 MHz, CDCl₃): δ -30 (br) ppm. **IR (neat) v** = 2975, 2902, 1781, 1516, 1429, 1094, 1038, 987, 735, 688 cm⁻¹

### Complex 19

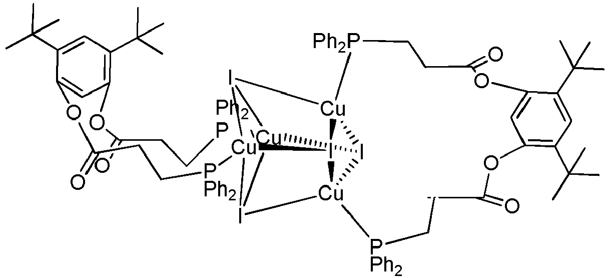

**¹H NMR** (300 MHz, CDCl₃): δH = 1.27 (s, 36H), 2.40 (m, 8H), 2.55 (m, 8H), 6.89 (s, 2H), 7.29 (m, 26H ), 7.38 (m, 16H )
**¹³C{1H} NMR** (75 MHz, CDCl₃): δ C = 22.91 (d), 30.25, 31.49(d) 34.65, 119.10, 125.55, 128.61(d), 128.94, 132.83(d), 137.60 (d), 146.69, 171.50(d)
**³¹P NMR** (161 MHz, CDCl₃)δ: -30.3
IR (neat) v = 2956, 2900, 1754, 1480, 1479, 1434, 1354, 1210, 1099, 917, 735, 694 cm-1

### Complex 20

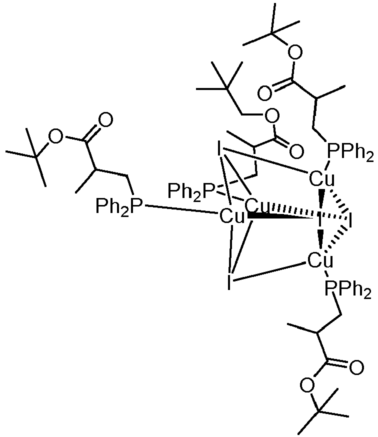

**¹H NMR** (500 MHz, CDCl₃) δ: 7.51 (m, 16 H, C₆H₄), 7.28 (m, 24 H, C₆H₄), 2.30 (m, 8H), 1.94(m, 4H), 1.29 (s, 36H), 1.15 (d, 12H) ppm. **¹³C NMR** (126 MHz, CDCl₃): δ 18.60, 27.96, 32.69, 37.91, 80.36, 128.45 (d, J= 9Hz), 129.65, 132.86(d(d, J= 29Hz)), 133.20(d, J= 12.2Hz)), 175.52(d, J= 17Hz) ppm. **³¹P {¹H} NMR** (203 MHz, CDCl₃): δ -28(br) ppm. **IR (neat) v** = 3054, 2973, 1726, 1462, 1431, 1363, 1343, 1140, 1023, 846, 737, 696 cm⁻¹

### Complex 21

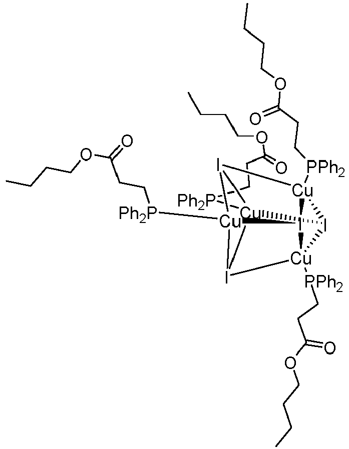

**¹H NMR** (500 MHz, CDCl₃): δ 0.85 (t, 12H), 1.29 (m, 8H), 1.55 (m, 8H), 2.55 (m, 16H), 3.96 (t, 8H), 7.31 (m, 24H), 7.60 (m, 16H) ppm. **¹³C NMR** (126 MHz, CDCl₃): δ 13.74, 19.15, 20.02 (d, J= 17.3Hz), 26.94, 30.66 (d, J= 8Hz), 64.58, 128.52 (d, J= 9Hz), 129.73, 132.81 (d, J= 29Hz), 134.78 (d, J= 12.0 Hz)), 173.34 (d, J= 17Hz) ppm. **³¹P {¹H} NMR** (203 MHz, CDCl₃): δ -29(br) ppm. **IR (neat) v =** 3057, 2993, 2871, 1729, 1459, 1431, 1156, 1016, 734, 696 cm⁻¹

### Complex 22

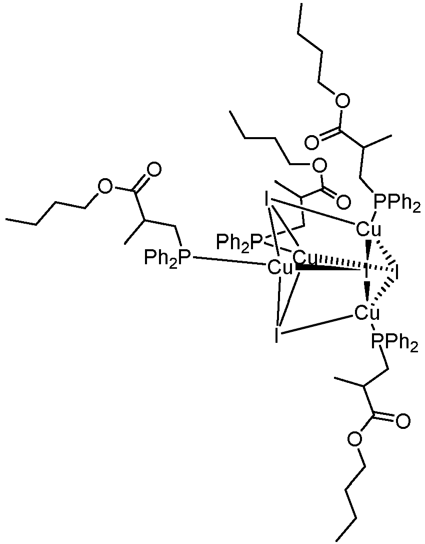

**¹H NMR** (500 MHz, CDCl₃): δ 0.85 (t, 12H), 1.22 (d, 12H), 1.26 (m, 8H), 1.55 (m, 8H), 2.01 (m, 4H), 2.55 (m, 8H), 3.92 (m, 8H), 7.28 (m, 24H), 7.59 (m, 16H) ppm. **¹³C NMR** (126 MHz, CDCl₃): δ 13.78, 18.67, 19.27, 30.68, 32.77, 37.16, 64.43, 128.48 (d, J= 9Hz), 129.75, 132.80 (d, J= 29Hz), 134.01 (d, J= 12.0 Hz)), 176.15 (d, J= 17Hz) ppm. **³¹P {¹H} NMR** (203 MHz, CDCl₃): δ -30 (br) ppm. **IR (neat) v =** 3065, 2954, 1732, 1475, 1434, 1344, 1218, 1165, 1066, 738, 686 cm⁻¹

### Complex 23

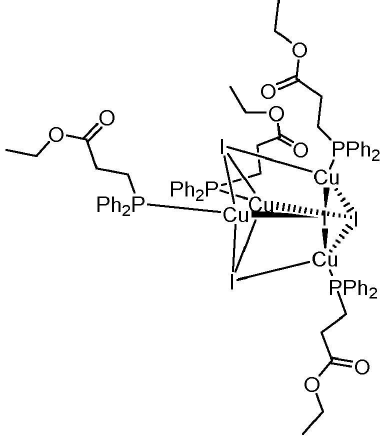

**¹H NMR** (500 MHz, CDCl₃): δH = 1.15 (t, 12H), 2.52 (m, 16H), 4.01 (m, 8H), 7.28 (m, 24H), 7.57 (m, 16H) ppm. **¹³C NMR** (126 MHz, CDCl₃): δ 14.19, 22.39(d, J= 17.3Hz), 29.5 (d, J= 8Hz),, 60.59, 128.54(d, J= 9Hz),129.61, 132.85(d, J= 28Hz), 133.38(d, J= 12.1Hz),), 173.23(d, J= 17Hz) ppm. **³¹P {¹H} NMR** (203 MHz, CDCl₃): δ -29.69 ppm. **IR (neat) v =** 3056, 2969, 2872, 1727, 1476, 1430, 1369, 1348, 1226, 1163, 1097, 1024, 733, 691 cm⁻¹. **Anal. Calcd** for C₆₄H₆₆Cu₄I₄O₄P₄: C, 43,83; H, 4.02. Found: C, 41.76; H, 4.38. **ATG** : 5% lostof mass at 253°C. **DSC** : Pf: 128 °C recristallization at 61°C

### Complex 24

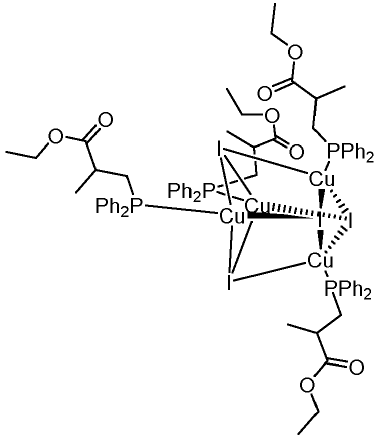

**¹H NMR** (500 MHz, CDCl₃): δ 1.1(t, 12H), 1.23 (d, 12H), 2.1 (m, 4H), 2.41 (m, 8H), 3.97 (m, 8H), 7.28 (m, 24H), 7.50(m, 16H) ppm. **¹³C NMR** (126 MHz, CDCl₃): δ 14.22, 18.74, 32.70, 37.27 60.60, 128.50 (d, J= 9Hz), 129.69, 132.86(d, J= 28Hz),, 133.45(d, J= 12.2Hz), 176.14 (d, J= 17.2Hz) ppm. **³¹P {¹H} NMR** (203 MHz, CDCl₃): δ -29 (br) ppm.**IR (neat) v =** 3065, 2978, 2932, 1730, 1456, 1438, 1369, 1175, 1153, 1096, 1020, 732, 693 cm⁻¹

### Complex 25

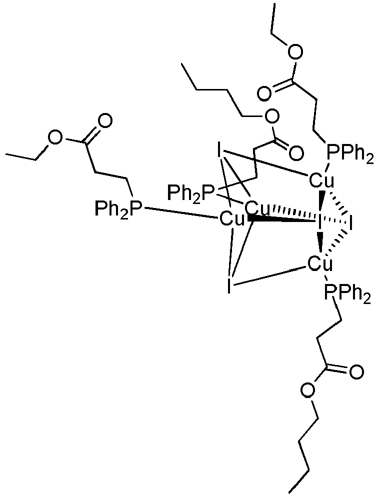

**³¹P NMR** (161 MHz, CDCl₃)δ: -30 (br)

### Complex 26

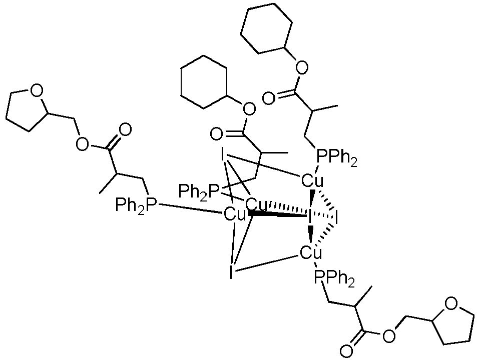

**³¹P NMR** (161 MHz, CDCl₃)δ: -29 (br)

### Complex 27

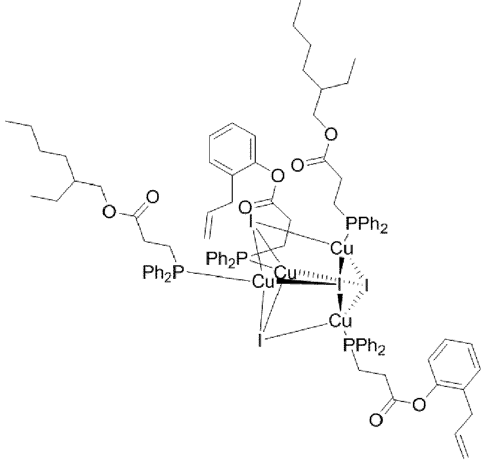

**¹H NMR** (600 MHz, CDCl₃): δH = 0.94 (m, 12H), 1.23 (m, 16H), 1.51 (m, 2H), 2.56 (m, 8H), 2.72 (m, 4H), 2.85 (m, 4H), 3.16 (d, 4H), 3.90 (m, 4H), 4.93 (m, 4H), 5.77 (m, 2H), 6.94 (m, 2H), 7.19 (m, 6H), 7.34 (m, 24H), 7.63 (m, 16H)
**¹³C{1H} NMR** (75 MHz, CDCl₃): δ C = 10.93, 14.09, 22.21 (d), 22.34 (d), 22.96, 23.68, 28.87, 29.54 (d), 29.60 (d), 30.29, 34.56, 38.60, 67.29, 116.26, 122.37, 126.03, 127.29, 128.43(d), 128.60 (d), 129.68, 129.81, 130.29, 131.87, 132.41, 132.62, 133.29(d), 133.39 (d), 135.77, 148.93, 171.28 (d), 173.1 (d)
**³¹P NMR** (161 MHz, CDCl₃) δ: -29.9 (br)

### Complex 28

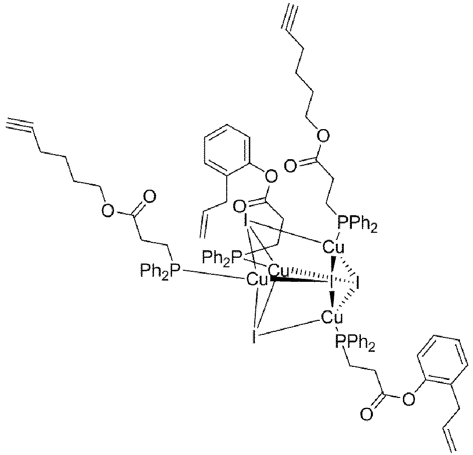

**¹H NMR** (600 MHz, CDCl₃): δH = 1.53 (m, 4H), 1.69 (m, 4H), 1.96 (br, 2H), 2.17 (td, 4H), 2.58 (m, 8H), 2.70 (m, 4H), 2.86 (m, 4H), 3.11 (d, 4H), 4.01 (t, 4H), 4.92 (m, 4H), 5.77 (m, 2H), 6.94 (m,2H), 7.19 (m, 6H), 7.34 (m, 24H), 7.63 (m, 16H)
**¹³C{1H} NMR** (75 MHz, CDCl3): δ C = 18.10, 22.24 (d), 22.41(d), 24.83, 27.53, 29.46(d), 29.63(d),31.61, 34.57, 64.15, 84.18, 116.24, 122.37, 126.04, 127.30, 128.45 (d), 128.61 (d), 129.71, 129.82, 130.30, 131.87, 132.42 (d), 132.70(d), 133.30 (d), 133.40, 135.76, 148.93, 171.28 (d), 172.98 (d).
**³¹P NMR** (161 MHz, CDCl₃)δ: -29.68 (br)

### Complex 29

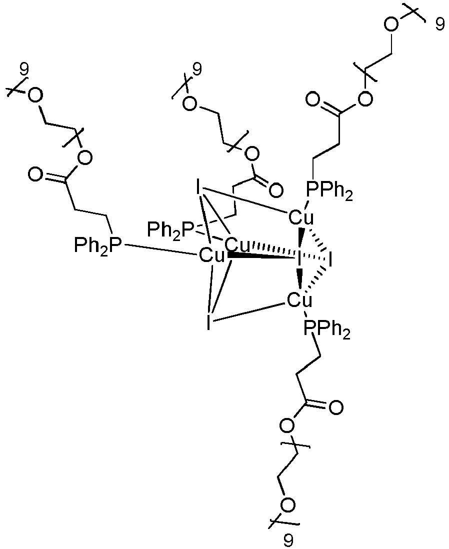

**¹H NMR** (500 MHz, CDCl3): δ 2.50 (m, 16H), 2.37 (m, 8H), 3.32 (s, 12H), 3.49 (m, 8H), 3.59 (m, 112H), 4.12 (t, 8H), 7.28 (m, 24H), 7.54 (m, 16H) ppm. **¹³C NMR** (126 MHz, CDCl3): δ 22.27(d, J=17Hz), 29.33 (d, J=9Hz), 59.04, 63.79, 68.7, 70.58, 71.95, 128.49 (d, J= 9Hz), 129.68, 132.73(d, J= 28Hz), 133.40(d, J= 12.1Hz), 172.92(d, J= 17Hz) ppm. **³¹P {¹H} NMR** (203 MHz, CDCl3): δ -29.92(br) ppm. **IR (neat) v =** 3056, 2874, 1729, 1433, 1343, 1270, 1219, 1097, 951, 849, 730, 698cm⁻¹

### Complex 30

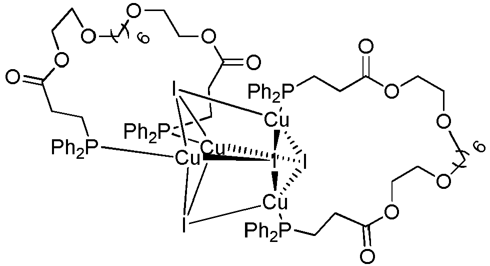

**¹H NMR** (500 MHz, CDCl₃) δ: 7.60 (m, 16 H), 7.32 (m, 24 H), 4.14 (m, 4H), 3.97 (m, 4H), 3.63(m, 12H) ,3.42 (m, 4H), 2.58 (m, 16H), 1.49 (m, 8H), 1.28 (m, 8H). **³¹P NMR** (202 MHz, CDCl₃)δ: -30.21(br)
**¹³C NMR** (75 MHz, CDCl3): δ 21.64 (d), 24.96, 27.36, 30.58 (d), 63.46, 69.57, 69.71, 127.50 (d), 128.69, 131.80 (d) 132.33 (d), 172.10 (d)

### Complex 31

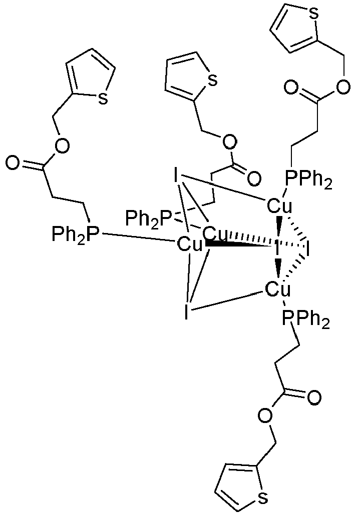

**¹H NMR** (500 MHz, CDCl3): δ 2.60 (m, 16H), 5.18 (s, 8H), 6.93 (dd, J= 5.93 Hz, 4H), 7.04 (d, J= 3.4Hz, 4H), 7.25 (dd, J= 5.1Hz, 4H), 7.29 (m, 24H), 7.58 (m, 16H) ppm. **¹³C NMR** (126 MHz, CDCl3): δ 22.23 (d, J=17Hz), 29.51(d, J=9Hz), 60.73, 126.94 (d, J=6.1 Hz), 128.35, 128.54(d, J= 9Hz), 129.7, 132.85(d, J= 28Hz), 133.48(d, J= 12.1Hz), 137.82, 172.82(d, J= 17Hz) ppm. **³¹P {¹H} NMR** (203 MHz, CDCl3): δ -29.78 (br) ppm. **IR (neat)** v = 3064, 2937, 1729, 1481, 1435, 1335, 1263, 1219, 1158, 944, 852, 735 cm⁻¹

### Complex 32

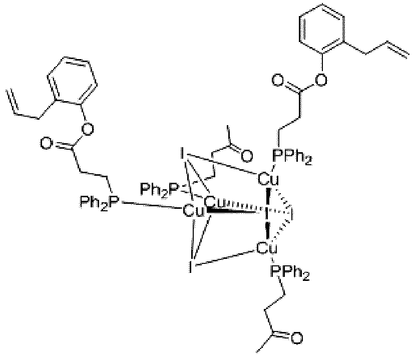

**¹H NMR** (600 MHz, CDCl3): δH = 1.94 (s, 6H), 2.50 (m, 4H), 2.63 (m, 8H), 2.80 (m, 4H), 3.19 (d, 4H), 4.98 (m, 4H), 5.80 (m, 2H), 6.91 (m, 2H), 7.16 (m, 6H), 7.29 (m, 24H), 7.58 (m, 16H)
**¹³C{1H} NMR** (75 MHz, CDCl3): δ C = 21.36 (d), 22.71, 29.57(d), 31.64, 34.81, 38.71(d), 116.32, 122.39, 126.10, 127.34, 128.70 (d), 128.90 (d), 129.87, 129.98, 130.34, 131.87, 132.14 (d), 132.65(d), 133.05 (d), 133.15, 135.87, 148.94, 171.27 (d), 207.30 (d).
**³¹P NMR** (161 MHz, CDCl₃)δ: -30 (br)

### Determining the Structure:

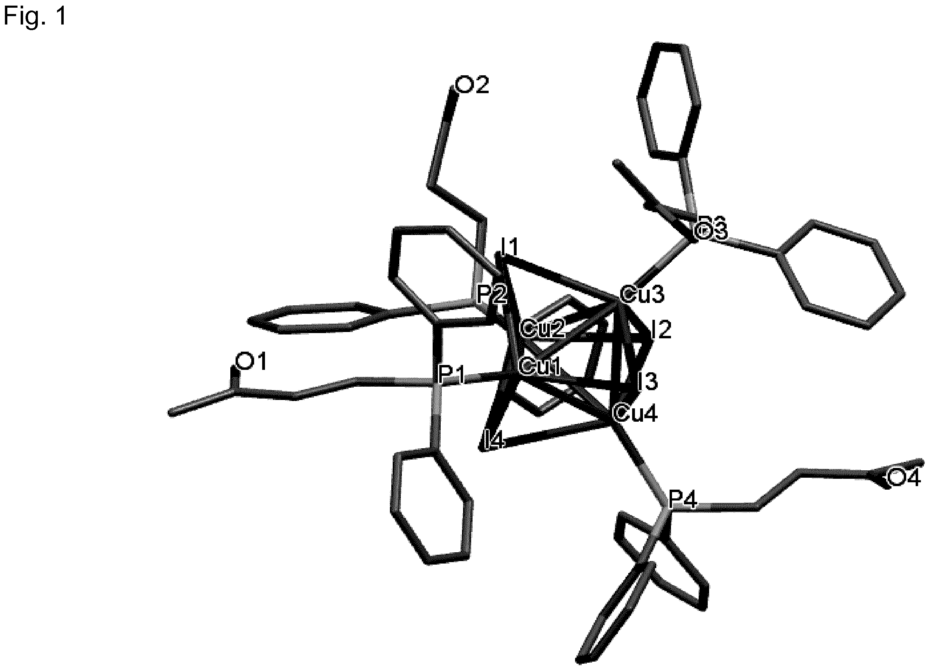

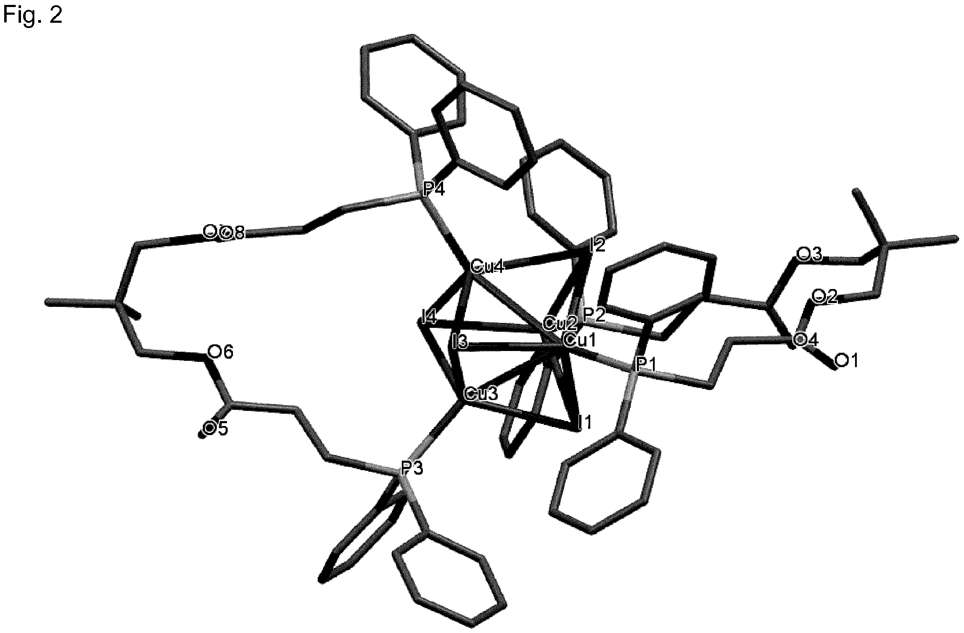

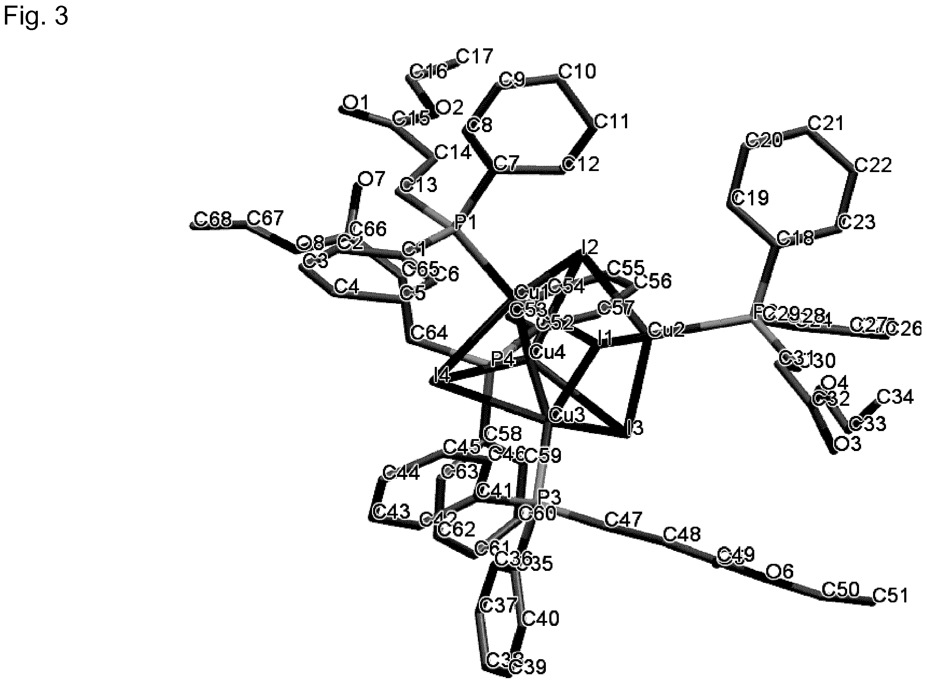

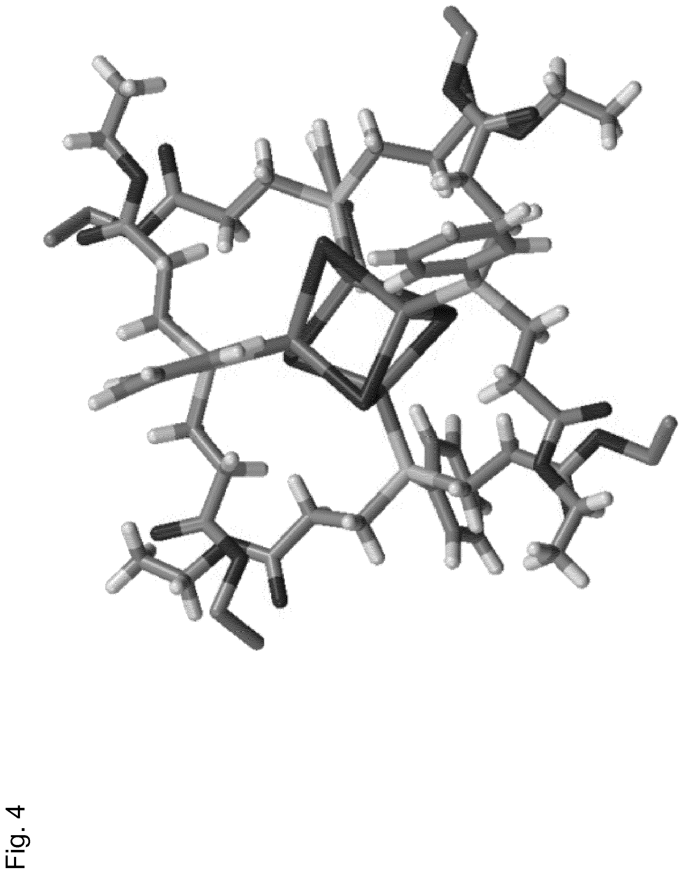

The three-dimensional (3D) (crystal) structure was determined by means of NMR. The results are depicted in Figures 1 to 4.

For Complex 2, the following distances and angles have been determined. The numbers correspond to those depicted in Figure 1.

**Table 3. Distances in the CuI cubane-like core structure of Complex 2:**

| No. | Objects | | Length | | No. | Objects | | Length |
|---|---|---|---|---|---|---|---|---|
| 1 | Cu1 | P1 | 2.245(2) | | 12 | Cu2 | Cu3 | 2.7413(9) |
| 2 | Cu1 | I1 | 2.7368(9) | | 13 | Cu2 | I4 | 2.7413(9) |
| 3 | Cu1 | I4 | 2.7041(9) | | 14 | Cu3 | I1 | 2.7413(9) |
| 4 | Cu1 | I3 | 2.7413(9) | | 15 | Cu3 | I2 | 2.7413(9) |
| 5 | Cu1 | Cu4 | 2.7413(9) | | 16 | Cu3 | P3 | 2.7413(9) |
| 6 | Cu1 | Cu3 | 2.7413(9) | | 17 | Cu3 | I3 | 2.7413(9) |
| 7 | Cu1 | Cu2 | 2.7413(9) | | 18 | Cu3 | Cu4 | 2.7413(9) |
| 8 | Cu2 | I1 | 2.7413(9) | | 19 | Cu4 | I3 | 2.7413(9) |
| 9 | Cu2 | P2 | 2.7413(9) | | 20 | Cu4 | P4 | 2.7413(9) |
| 10 | Cu2 | I2 | 2.7413(9) | | 21 | Cu4 | I2 | 2.7413(9) |
| 11 | Cu2 | Cu4 | 2.7413(9) | | 22 | 2.7413(9) | 2.7413(9) | 2.7413(9) |

**Table 4. Angles determined for the CuI cubane-like core structure of Complex 2:**

| No. | compared objects | | | Angle | | No. | compared objects | | | Angle |
|---|---|---|---|---|---|---|---|---|---|---|
| 1 | Cu1 | Cu2 | Cu3 | 58.53(3) | | 49 | Cu3 | Cu4 | I4 | 107.23(3) |
| 2 | Cu1 | Cu2 | Cu4 | 56.85(3) | | 50 | Cu3 | I2 | Cu4 | 61.68(3) |
| 3 | Cu1 | Cu2 | I1 | 59.68(3) | | 51 | Cu3 | I3 | Cu4 | 60.76(3) |
| 4 | Cu1 | Cu2 | I2 | 104.44(3) | | 52 | Cu4 | Cu1 | I1 | 109.35(4) |
| 5 | Cu1 | Cu2 | I4 | 59.30(3) | | 53 | Cu4 | Cu1 | I3 | 60.84(3) |
| 6 | Cu1 | Cu3 | Cu2 | 60.51(3) | | 54 | Cu4 | Cu1 | I4 | 60.94(3) |
| 7 | Cu1 | Cu3 | Cu4 | 59.20(3) | | 55 | Cu4 | Cu2 | I1 | 104.97(3) |
| 8 | Cu1 | Cu3 | I1 | 61.02(3) | | 56 | Cu4 | Cu2 | I2 | 56.79(3) |
| 9 | Cu1 | Cu3 | I2 | 107.07(4) | | 57 | Cu4 | Cu2 | I4 | 58.97(3) |
| 10 | Cu1 | Cu3 | I3 | 58.02(3) | | 58 | Cu4 | Cu3 | I1 | 110.73(4) |
| 11 | Cu1 | Cu4 | Cu2 | 59.82(3) | | 59 | Cu4 | Cu3 | I2 | 59.03(3) |
| 12 | Cu1 | Cu4 | Cu3 | 60.35(3) | | 60 | Cu4 | Cu3 | I3 | 59.58(3) |
| 13 | Cu1 | Cu4 | I2 | 108.21(4) | | 61 | I1 | Cu1 | I3 | 110.42(3) |
| 14 | Cu1 | Cu4 | I3 | 58.41(3) | | 62 | I1 | Cu1 | I4 | 111.38(3) |
| 15 | Cu1 | Cu4 | I4 | 59.57(3) | | 63 | I1 | Cu2 | I2 | 110.18(3) |
| 16 | Cu1 | I1 | Cu2 | 61.62(3) | | 64 | I1 | Cu2 | I4 | 113.23(3) |
| 17 | Cu1 | I1 | Cu3 | 60.88(3) | | 65 | I1 | Cu3 | I2 | 113.04(3) |
| 18 | Cu1 | I3 | Cu3 | 61.51 (3) | | 66 | I1 | Cu3 | I3 | 110.81(3) |
| 19 | Cu1 | I3 | Cu4 | 60.75(3) | | 67 | I2 | Cu2 | I4 | 108.61(3) |
| 20 | Cu1 | I4 | Cu2 | 62.49(3) | | 68 | I2 | Cu3 | I3 | 113.20(3) |
| 21 | Cu1 | I4 | Cu4 | 59.48(3) | | 69 | I2 | Cu4 | I3 | 113.50(3) |
| 22 | Cu2 | Cu1 | Cu3 | 60.96(3) | | 70 | I2 | Cu4 | I4 | 107.96(3) |
| 23 | Cu2 | Cu1 | Cu4 | 63.33(3) | | 71 | I3 | Cu1 | I4 | 116.15(3) |
| 24 | Cu2 | Cu1 | I1 | 58.70(3) | | 72 | I3 | Cu4 | I4 | 112.74(3) |
| 25 | Cu2 | Cu1 | I3 | 112.67(4) | | 73 | P1 | Cu1 | Cu2 | 133.30(6) |
| 26 | Cu2 | Cu1 | I4 | 58.22(3) | | 74 | P1 | Cu1 | Cu3 | 144.58(6) |
| 27 | Cu2 | Cu3 | Cu4 | 62.75(3) | | 75 | P1 | Cu1 | Cu4 | 151.48(6) |
| 28 | Cu2 | Cu3 | I1 | 59.44(3) | | 76 | P1 | Cu1 | I1 | 98.82(5) |
| 29 | Cu2 | Cu3 | I2 | 59.31(3) | | 77 | P1 | Cu1 | I3 | 113.60(6) |
| 30 | Cu2 | Cu3 | I3 | 110.21(4) | | 78 | P1 | Cu1 | I4 | 105.04(6) |
| 31 | Cu2 | Cu4 | Cu3 | 59.74(3) | | 79 | P2 | Cu2 | Cu1 | 155.09(6) |
| 32 | Cu2 | Cu4 | I2 | 58.33(3) | | 80 | P2 | Cu2 | Cu3 | 138.16(6) |
| 33 | Cu2 | Cu4 | I3 | 107.86(3) | | 81 | P2 | Cu2 | Cu4 | 143.70(6) |
| 34 | Cu2 | Cu4 | I4 | 56.69(3) | | 82 | P2 | Cu2 | I1 | 109.77(6) |
| 35 | Cu2 | I1 | Cu3 | 62.95(3) | | 83 | P2 | Cu2 | I2 | 100.41(5) |
| 36 | Cu2 | I2 | Cu3 | 62.72(3) | | 84 | P2 | Cu2 | I4 | 113.87(6) |
| 37 | Cu2 | I2 | Cu4 | 64.87(3) | | 85 | P3 | Cu3 | Cu1 | 148.56(6) |
| 38 | Cu2 | I4 | Cu4 | 64.34(3) | | 86 | P3 | Cu3 | Cu2 | 144.90(6) |
| 39 | Cu3 | Cu1 | Cu4 | 60.45(3) | | 87 | P3 | Cu3 | Cu4 | 138.77(6) |
| 40 | Cu3 | Cu1 | I1 | 58.10(3) | | 88 | P3 | Cu3 | I1 | 110.50(6) |
| 41 | Cu3 | Cu1 | I3 | 60.47(3) | | 89 | P3 | Cu3 | I2 | 103.98(6) |
| 42 | Cu3 | Cu1 | I4 | 108.38(4) | | 90 | P3 | Cu3 | I3 | 104.76(6) |
| 43 | Cu3 | Cu2 | Cu4 | 57.51(3) | | 91 | P4 | Cu4 | Cu1 | 140.22(6) |
| 44 | Cu3 | Cu2 | I1 | 57.61(3) | | 92 | P4 | Cu4 | Cu2 | 146.30(6) |
| 45 | Cu3 | Cu2 | I2 | 57.96(3) | | 93 | P4 | Cu4 | Cu3 | 147.38(6) |
| 46 | Cu3 | Cu2 | I4 | 107.27(3) | | 94 | P4 | Cu4 | I2 | 111.54(6) |
| 47 | Cu3 | Cu4 | I2 | 59.29(3) | | 95 | P4 | Cu4 | I3 | 105.48(6) |
| 48 | Cu3 | Cu4 | I3 | 59.65(3) | | 96 | P4 | Cu4 | I4 | 105.34(6) |

**Table 5. Angles determined for the copper (I) complex structure of Complex 2:**

| No. | Compared Objects | | | Angle | | No. | Compared Objects | | | Angle |
|---|---|---|---|---|---|---|---|---|---|---|
| 1 | C1 | C2 | H2 | 118.6 | | 175 | C9 | C10 | H10 | 120.3 |
| 2 | C1 | C2 | C3 | 122.8(8) | | 176 | C9 | C10 | C11 | 119.2(8) |
| 3 | C1 | C6 | C5 | 121.3(9) | | 177 | Cu1 | Cu2 | Cu3 | 58.53(3) |
| 4 | C1 | C6 | H6 | 119.4 | | 178 | Cu1 | Cu2 | Cu4 | 56.85(3) |
| 5 | C1 | P1 | C7 | 104.4(3) | | 179 | Cu1 | Cu2 | I1 | 59.68(3) |
| 6 | C1 | P1 | C13 | 108.9(4) | | 180 | Cu1 | Cu2 | I2 | 104.44(3) |
| 7 | C1 | P1 | Cu1 | 113.2(3) | | 181 | Cu1 | Cu2 | I4 | 59.30(3) |
| 8 | C10 | C11 | H11 | 119.8 | | 182 | Cu1 | Cu3 | Cu2 | 60.51(3) |
| 9 | C10 | C11 | C12 | 120.6(8) | | 183 | Cu1 | Cu3 | Cu4 | 59.20(3) |
| 10 | C11 | C12 | H12 | 119.7 | | 184 | Cu1 | Cu3 | I1 | 61.02(3) |
| 11 | C12 | C7 | P1 | 122.5(5) | | 185 | Cu1 | Cu3 | I2 | 107.07(4) |
| 12 | C13 | C14 | H14A | 109.0 | | 186 | Cu1 | Cu3 | I3 | 58.02(3) |
| 13 | C13 | C14 | H14B | 109.1 | | 187 | Cu1 | Cu4 | Cu2 | 59.82(3) |
| 14 | C13 | C14 | C15 | 113.1(7) | | 188 | Cu1 | Cu4 | Cu3 | 60.35(3) |
| 15 | C13 | P1 | Cu1 | 108.4(3) | | 189 | Cu1 | Cu4 | I2 | 108.21(4) |
| 16 | C14 | C13 | P1 | 119.1(6) | | 190 | Cu1 | Cu4 | I3 | 58.41(3) |
| 17 | C14 | C15 | C16 | 115.9(7) | | 191 | Cu1 | Cu4 | I4 | 59.57(3) |
| 18 | C14 | C15 | O1 | 121.2(8) | | 192 | Cu1 | I1 | Cu2 | 61.62(3) |
| 19 | C15 | C16 | H16A | 109.6 | | 193 | Cu1 | I1 | Cu3 | 60.88(3) |
| 20 | C15 | C16 | H16B | 109.5 | | 194 | Cu1 | I3 | Cu3 | 61.51(3) |
| 21 | C15 | C16 | H16C | 109.5 | | 195 | Cu1 | I3 | Cu4 | 60.75(3) |
| 22 | C16 | C15 | O1 | 122.7(8) | | 196 | Cu1 | I4 | Cu2 | 62.49(3) |
| 23 | C17 | C18 | H18 | 119.6 | | 197 | Cu1 | I4 | Cu4 | 59.48(3) |
| 24 | C17 | C18 | C19 | 121.0(7) | | 198 | Cu2 | Cu1 | Cu3 | 60.96(3) |
| 25 | C17 | C22 | C21 | 120.5(7) | | 199 | Cu2 | Cu1 | Cu4 | 63.33(3) |
| 26 | C17 | C22 | H22 | 119.7 | | 200 | Cu2 | Cu1 | I1 | 58.70(3) |
| 27 | C17 | P2 | C23 | 105.7(3) | | 201 | Cu2 | Cu1 | I3 | 112.67(4) |
| 28 | C17 | P2 | C29 | 102.0(3) | | 202 | Cu2 | Cu1 | I4 | 58.22(3) |
| 29 | C17 | P2 | Cu2 | 117.8(2) | | 203 | Cu2 | Cu3 | Cu4 | 62.75(3) |
| 30 | C18 | C17 | C22 | 118.1(6) | | 204 | Cu2 | Cu3 | I1 | 59.44(3) |
| 31 | C18 | C17 | P2 | 118.5(5) | | 205 | Cu2 | Cu3 | I2 | 59.31(3) |
| 32 | C18 | C19 | H19 | 120.4 | | 206 | Cu2 | Cu3 | I3 | 110.21(4) |
| 33 | C18 | C19 | C20 | 119.2(8) | | 207 | Cu2 | Cu4 | Cu3 | 59.74(3) |
| 34 | C19 | C20 | H20 | 119.3 | | 208 | Cu2 | Cu4 | I2 | 58.33(3) |
| 35 | C19 | C20 | C21 | 121.2(8) | | 209 | Cu2 | Cu4 | I3 | 107.86(3) |
| 36 | C2 | C1 | C6 | 118.2(8) | | 210 | Cu2 | Cu4 | I4 | 56.69(3) |
| 37 | C2 | C1 | P1 | 118.5(6) | | 211 | Cu2 | I1 | Cu3 | 62.95(3) |
| 38 | C2 | C3 | H3 | 122 | | 212 | Cu2 | I2 | Cu3 | 62.72(3) |
| 39 | C2 | C3 | C4 | 116.7(9) | | 213 | Cu2 | I2 | Cu4 | 64.87(3) |
| 40 | C20 | C21 | H21 | 120.0 | | 214 | Cu2 | I4 | Cu4 | 64.34(3) |
| 41 | C20 | C21 | C22 | 120.0(8) | | 215 | Cu3 | Cu1 | Cu4 | 60.45(3) |
| 42 | C21 | C22 | H22 | 119.8 | | 216 | Cu3 | Cu1 | I1 | 58.10(3) |
| 43 | C22 | C17 | P2 | 123.1(5) | | 217 | Cu3 | Cu1 | I3 | 60.47(3) |
| 44 | C23 | C24 | H24 | 119.9 | | 218 | Cu3 | Cu1 | I4 | 108.38(4) |
| 45 | C23 | C24 | C25 | 120.1(8) | | 219 | Cu3 | Cu2 | Cu4 | 57.51(3) |
| 46 | C23 | C28 | C27 | 120.6(8) | | 220 | Cu3 | Cu2 | I1 | 57.61(3) |
| 47 | C23 | C28 | H28 | 119.8 | | 221 | Cu3 | Cu2 | I2 | 57.96(3) |
| 48 | C23 | P2 | C29 | 103.1(3) | | 222 | Cu3 | Cu2 | I4 | 107.27(3) |
| 49 | C23 | P2 | Cu2 | 113.2(2) | | 223 | Cu3 | Cu4 | I2 | 59.29(3) |
| 50 | C24 | C23 | C28 | 118.7(7) | | 224 | Cu3 | Cu4 | I3 | 59.65(3) |
| 51 | C24 | C23 | P2 | 120.3(6) | | 225 | Cu3 | Cu4 | I4 | 107.23(3) |
| 52 | C24 | C25 | H25 | 120 | | 226 | Cu3 | I2 | Cu4 | 61.68(3) |
| 53 | C24 | C25 | C26 | 120(1) | | 227 | Cu3 | I3 | Cu4 | 60.76(3) |
| 54 | C25 | C26 | H26 | 120 | | 228 | Cu4 | Cu1 | I1 | 109.35(4) |
| 55 | C25 | C26 | C27 | 120(1) | | 229 | Cu4 | Cu1 | I3 | 60.84(3) |
| 56 | C26 | C27 | H27 | 120 | | 230 | Cu4 | Cu1 | I4 | 60.94(3) |
| 57 | C26 | C27 | C28 | 120(1) | | 231 | Cu4 | Cu2 | I1 | 104.97(3) |
| 58 | C27 | C28 | H28 | 119.7 | | 232 | Cu4 | Cu2 | I2 | 56.79(3) |
| 59 | C28 | C23 | P2 | 120.6(6) | | 233 | Cu4 | Cu2 | I4 | 58.97(3) |
| 60 | C29 | C30 | H30A | 109.6 | | 234 | Cu4 | Cu3 | I1 | 110.73(4) |
| 61 | C29 | C30 | H30B | 109.6 | | 235 | Cu4 | Cu3 | I2 | 59.03(3) |
| 62 | C29 | C30 | C31 | 110.4(6) | | 236 | Cu4 | Cu3 | I3 | 59.58(3) |
| 63 | C29 | P2 | Cu2 | 113.5(2) | | 237 | H10 | C10 | C11 | 120.4 |
| 64 | C3 | C4 | H4 | 119 | | 238 | H11 | C11 | C12 | 119.7 |
| 65 | C3 | C4 | C5 | 122(1) | | 239 | H13A | C13 | H13B | 107.2 |
| 66 | C30 | C29 | P2 | 113.0(5) | | 240 | H13A | C13 | C14 | 107.5 |
| 67 | C30 | C31 | C32 | 118.1(7) | | 241 | H13A | C13 | P1 | 107.6 |
| 68 | C30 | C31 | O2 | 120.6(8) | | 242 | H13B | C13 | C14 | 107.4 |
| 69 | C31 | C32 | H32A | 109.4 | | 243 | H13B | C13 | P1 | 107.5 |
| 70 | C31 | C32 | H32B | 109.4 | | 244 | H14A | C14 | H14B | 107.6 |
| 71 | C31 | C32 | H32C | 109.5 | | 245 | H14A | C14 | C15 | 108.9 |
| 72 | C32 | C31 | O2 | 121.3(8) | | 246 | H14B | C14 | C15 | 108.9 |
| 73 | C33 | C34 | H34 | 120.2 | | 247 | H16A | C16 | H16B | 109.5 |
| 74 | C33 | C34 | C35 | 119.7(8) | | 248 | H16A | C16 | H16C | 109.4 |
| 75 | C33 | C38 | C37 | 120.5(8) | | 249 | H16B | C16 | H16C | 109.4 |
| 76 | C33 | C38 | H38 | 119.7 | | 250 | H18 | C18 | C19 | 119.5 |
| 77 | C33 | P3 | C39 | 104.8(3) | | 251 | H19 | C19 | C20 | 120.4 |
| 78 | C33 | P3 | C45 | 106.2(3) | | 252 | H2 | C2 | C3 | 118.6 |
| 79 | C33 | P3 | Cu3 | 116.3(2) | | 253 | H20 | C20 | C21 | 119.5 |
| 80 | C34 | C33 | C38 | 118.8(7) | | 254 | H21 | C21 | C22 | 120.1 |
| 81 | C34 | C33 | P3 | 117.6(6) | | 255 | H24 | C24 | C25 | 120.0 |
| 82 | C34 | C35 | H35 | 119.4 | | 256 | H25 | C25 | C26 | 120 |
| 83 | C34 | C35 | C36 | 121.2(9) | | 257 | H26 | C26 | C27 | 120 |
| 84 | C35 | C36 | H36 | 120 | | 258 | H27 | C27 | C28 | 120 |
| 85 | C35 | C36 | C37 | 120(1) | | 259 | H29A | C29 | H29B | 107.9 |
| 86 | C36 | C37 | H37 | 120 | | 260 | H29A | C29 | C30 | 108.9 |
| 87 | C36 | C37 | C38 | 120(1) | | 261 | H29A | C29 | P2 | 109.0 |
| 88 | C37 | C38 | H38 | 119.8 | | 262 | H29B | C29 | C30 | 108.9 |
| 89 | C38 | C33 | P3 | 123.6(6) | | 263 | H29B | C29 | P2 | 109.0 |
| 90 | C39 | C40 | H40 | 120.2 | | 264 | H3 | C3 | C4 | 122 |
| 91 | C39 | C40 | C41 | 119.7(7) | | 265 | H30A | C30 | H30B | 108.1 |
| 92 | C39 | C44 | C43 | 119.8(6) | | 266 | H30A | C30 | C31 | 109.5 |
| 93 | C39 | C44 | H44 | 120.1 | | 267 | H30B | C30 | C31 | 109.6 |
| 94 | C39 | P3 | C45 | 102.6(3) | | 268 | H32A | C32 | H32B | 109 |
| 95 | C39 | P3 | Cu3 | 112.2(2) | | 269 | H32A | C32 | H32C | 110 |
| 96 | C4 | C5 | H5 | 120 | | 270 | H32B | C32 | H32C | 110 |
| 97 | C4 | C5 | C6 | 119(1) | | 271 | H34 | C34 | C35 | 120.1 |
| 98 | C40 | C39 | C44 | 119.5(6) | | 272 | H35 | C35 | C36 | 119 |
| 99 | C40 | C39 | P3 | 123.3(5) | | 273 | H36 | C36 | C37 | 120 |
| 100 | C40 | C41 | H41 | 119.8 | | 274 | H37 | C37 | C38 | 120 |
| 101 | C40 | C41 | C42 | 120.4(8) | | 275 | H4 | C4 | C5 | 119 |
| 102 | C41 | C42 | H42 | 119.9 | | 276 | H40 | C40 | C41 | 120.2 |
| 103 | C41 | C42 | C43 | 120.3(8) | | 277 | H41 | C41 | C42 | 119.7 |
| 104 | C42 | C43 | H43 | 119.9 | | 278 | H42 | C42 | C43 | 119.8 |
| 105 | C42 | C43 | C44 | 120.2(8) | | 279 | H43 | C43 | C44 | 119.9 |
| 106 | C43 | C44 | H44 | 120.2 | | 280 | H45A | C45 | H45B | 107.8 |
| 107 | C44 | C39 | P3 | 117.1(5) | | 281 | H45A | C45 | C46 | 108.8 |
| 108 | C45 | C46 | H46A | 108.8 | | 282 | H45A | C45 | P3 | 108.8 |
| 109 | C45 | C46 | H46B | 108.8 | | 283 | H45B | C45 | C46 | 109.0 |
| 110 | C45 | C46 | C47 | 113.9(7) | | 284 | H45B | C45 | P3 | 108.9 |
| 111 | C45 | P3 | Cu3 | 113.5(2) | | 285 | H46A | C46 | H46B | 107.6 |
| 112 | C46 | C45 | P3 | 113.5(5) | | 286 | H46A | C46 | C47 | 108.8 |
| 113 | C46 | C47 | C48 | 118.6(8) | | 287 | H46B | C46 | C47 | 108.8 |
| 114 | C46 | C47 | O3 | 121.4(8) | | 288 | H48A | C48 | H48B | 109 |
| 115 | C47 | C48 | H48A | 110 | | 289 | H48A | C48 | H48C | 109 |
| 116 | C47 | C48 | H48B | 110 | | 290 | H48B | C48 | H48C | 109 |
| 117 | C47 | C48 | H48C | 110 | | 291 | H5 | C5 | C6 | 120 |
| 118 | C48 | C47 | O3 | 120.0(9) | | 292 | H50 | C50 | C51 | 119.1 |
| 119 | C49 | C50 | H50 | 119.0 | | 293 | H51 | C51 | C52 | 120.1 |
| 120 | C49 | C50 | C51 | 121.9(8) | | 294 | H52 | C52 | C53 | 120.3 |
| 121 | C49 | C54 | C53 | 120.9(7) | | 295 | H53 | C53 | C54 | 119.4 |
| 122 | C49 | C54 | H54 | 119.5 | | 296 | H56 | C56 | C57 | 119.9 |
| 123 | C49 | P4 | C55 | 104.6(3) | | 297 | H57 | C57 | C58 | 119.3 |
| 124 | C49 | P4 | C61 | 104.5(3) | | 298 | H58 | C58 | C59 | 120.4 |
| 125 | C49 | P4 | Cu4 | 116.0(2) | | 299 | H59 | C59 | C60 | 120.3 |
| 126 | C5 | C6 | H6 | 119 | | 300 | H61A | C61 | H61B | 107.7 |
| 127 | C50 | C49 | C54 | 117.3(7) | | 301 | H61A | C61 | C62 | 108.5 |
| 128 | C50 | C49 | P4 | 120.1(5) | | 302 | H61A | C61 | P4 | 108.7 |
| 129 | C50 | C51 | H51 | 120.3 | | 303 | H61B | C61 | C62 | 108.5 |
| 130 | C50 | C51 | C52 | 119.6(8) | | 304 | H61B | C61 | P4 | 108.6 |
| 131 | C51 | C52 | H52 | 120.4 | | 305 | H62A | C62 | H62B | 108.0 |
| 132 | C51 | C52 | C53 | 119.3(8) | | 306 | H62A | C62 | C63 | 109.1 |
| 133 | C52 | C53 | H53 | 119.5 | | 307 | H62B | C62 | C63 | 109.1 |
| 134 | C52 | C53 | C54 | 121.1(8) | | 308 | H64A | C64 | H64B | 110 |
| 135 | C53 | C54 | H54 | 119.6 | | 309 | H64A | C64 | H64C | 110 |
| 136 | C54 | C49 | P4 | 122.6(5) | | 310 | H64B | C64 | H64C | 109 |
| 137 | C55 | C56 | H56 | 119.9 | | 311 | H8 | C8 | C9 | 119.1 |
| 138 | C55 | C56 | C57 | 120.2(8) | | 312 | H9 | C9 | C10 | 119.9 |
| 139 | C55 | C60 | C59 | 121.6(7) | | 313 | I1 | Cu1 | I3 | 110.42(3) |
| 140 | C55 | C60 | H60 | 119.2 | | 314 | I1 | Cu1 | I4 | 111.38(3) |
| 141 | C55 | P4 | C61 | 100.5(3) | | 315 | I1 | Cu2 | I2 | 110.18(3) |
| 142 | C55 | P4 | Cu4 | 113.2(2) | | 316 | I1 | Cu2 | I4 | 113.23(3) |
| 143 | C56 | C55 | C60 | 118.0(6) | | 317 | I1 | Cu3 | I2 | 113.04(3) |
| 144 | C56 | C55 | P4 | 123.1(5) | | 318 | I1 | Cu3 | I3 | 110.81(3) |
| 145 | C56 | C57 | H57 | 119.2 | | 319 | I2 | Cu2 | I4 | 108.61(3) |
| 146 | C56 | C57 | C58 | 121.4(8) | | 320 | I2 | Cu3 | I3 | 113.20(3) |
| 147 | C57 | C58 | H58 | 120.3 | | 321 | I2 | Cu4 | I3 | 113.50(3) |
| 148 | C57 | C58 | C59 | 119.3(8) | | 322 | I2 | Cu4 | I4 | 107.96(3) |
| 149 | C58 | C59 | H59 | 120.2 | | 323 | I3 | Cu1 | I4 | 116.15(3) |
| 150 | C58 | C59 | C60 | 119.5(7) | | 324 | I3 | Cu4 | I4 | 112.74(3) |
| 151 | C59 | C60 | H60 | 119.1 | | 325 | P1 | Cu1 | Cu2 | 133.30(6) |
| 152 | C6 | C1 | P1 | 122.9(6) | | 326 | P1 | Cu1 | Cu3 | 144.58(6) |
| 153 | C60 | C55 | P4 | 118.9(5) | | 327 | P1 | Cu1 | Cu4 | 151.48(6) |
| 154 | C61 | C62 | H62A | 109.0 | | 328 | P1 | Cu1 | I1 | 98.82(5) |
| 155 | C61 | C62 | H62B | 108.9 | | 329 | P1 | Cu1 | I3 | 113.60(6) |
| 156 | C61 | C62 | C63 | 112.6(6) | | 330 | P1 | Cu1 | I4 | 105.04(6) |
| 157 | C61 | P4 | Cu4 | 116.2(2) | | 331 | P2 | Cu2 | Cu1 | 155.09(6) |
| 158 | C62 | C61 | P4 | 114.8(5) | | 332 | P2 | Cu2 | Cu3 | 138.16(6) |
| 159 | C62 | C63 | C64 | 117.1(7) | | 333 | P2 | Cu2 | Cu4 | 143.70(6) |
| 160 | C62 | C63 | O4 | 121.0(7) | | 334 | P2 | Cu2 | I1 | 109.77(6) |
| 161 | C63 | C64 | H64A | 109.5 | | 335 | P2 | Cu2 | I2 | 100.41(5) |
| 162 | C63 | C64 | H64B | 109.5 | | 336 | P2 | Cu2 | I4 | 113.87(6) |
| 163 | C63 | C64 | H64C | 109.5 | | 337 | P3 | Cu3 | Cu1 | 148.56(6) |
| 164 | C64 | C63 | O4 | 121.9(8) | | 338 | P3 | Cu3 | Cu2 | 144.90(6) |
| 165 | C7 | C8 | H8 | 119.4 | | 339 | P3 | Cu3 | Cu4 | 138.77(6) |
| 166 | C7 | C8 | C9 | 121.5(6) | | 340 | P3 | Cu3 | I1 | 110.50(6) |
| 167 | C7 | C12 | C11 | 120.7(7) | | 341 | P3 | Cu3 | I2 | 103.98(6) |
| 168 | C7 | C12 | H12 | 119.6 | | 342 | P3 | Cu3 | I3 | 104.76(6) |
| 169 | C7 | P1 | C13 | 103.9(3) | | 343 | P4 | Cu4 | Cu1 | 140.22(6) |
| 170 | C7 | P1 | Cu1 | 117.4(2) | | 344 | P4 | Cu4 | Cu2 | 146.30(6) |
| 171 | C8 | C7 | C12 | 117.8(6) | | 345 | P4 | Cu4 | Cu3 | 147.38(6) |
| 172 | C8 | C7 | P1 | 119.7(5) | | 346 | P4 | Cu4 | I2 | 111.54(6) |
| 173 | C8 | C9 | H9 | 119.8 | | 347 | P4 | Cu4 | I3 | 105.48(6) |
| 174 | C8 | C9 | C10 | 120.2(7) | | 348 | P4 | Cu4 | I4 | 105.34(6) |

The molecular structure of the other Complexes was found to be similar.

The photochemical (optical) properties were investigated, in particular the emission and excitation maxima and the quantum yields:

**Table 6. Emission and excitation wavelengths of the cubanes and quantum yields (determined in dry state (i.e., without solvent).**

| ID | Emission max (nm) | Excitation max (nm) | Quantum yield |
|---|---|---|---|
| Complex 1 | 570 | 340 | 17% |
| Complex 2 | 606 | 344 | 74% |
| Complex 3 | 514 | 364 | 70% |
| Complex 4 | 568 | 310 | 67% |
| Complex 5 | 563 | 310 | 76% |
| Complex 6 | 571 | 320 | 56% |
| Complex 7 | 566 | 310 | 47% |
| Complex 8 | 563 | 310 | 85% |
| Complex 9 | 557 | 330 | 49% |
| Complex 10 | 591 | 320 | 25% |
| Complex 11 | 576 | 330 | 11% |
| Complex 12 | 563 | 300 | 62% |
| Complex 13 | 570 | 310 | 40% |
| Complex 14 | 565 | 310 | 30% |
| Complex 15 | 569 | 300 | 61% |
| Complex 16 | 566 | 320 | 50% |
| Complex 17 | 604 | 310 | 15% |
| Complex 18 | 580 | 333 | 18% |
| Complex 19 | 566 | 320 | 61% |
| Complex 20 | 566 | 300 | 18% |
| Complex 21 | 569 | 310 | 60% |
| Complex 22 | 569 | 310 | 24% |
| Complex 23 | 560 | 320 | 99% |
| Complex 24 | 589 | 310 | 22% |
| Complex 25 | 572 | 310 | 27% |
| Complex 26 | 572 | 310 | 45% |
| Complex 27 | 575 | 320 | 46% |
| Complex 28 | 575 | 310 | 51% |
| Complex 29 | 570 | 320 | 6% |
| Complex 30 | 560 | 330 | 52% |
| Complex 31 | 570 | 320 | 38% |

It was seen that the copper (I) complexes show an absorption maximum in the UV range and an emission maximum in the visible range.

### Complex 33

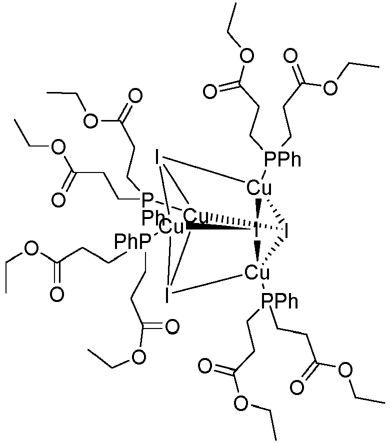

**¹H NMR** (500 MHz, CDCl3): δH = 1.19 (t, J= 7.1Hz, 24H), 2.33-2.72 (m, 32H), 4.05 (q, J= 7.2Hz, 16H), 7.41 (m, 12H), 7.80 (m, 8H) ppm.
**¹³C NMR** (126 MHz, CDCl3): δ 14.17, 22.02 (d, J= 15.5Hz), 29.53 (d, J= 4.7Hz), 60.66, 128.85 (d, J= 8.5Hz), 130.40, 133.16, 133.18, 172.72 (d, J= 15Hz) ppm.
**³¹P {¹H} NMR** (203 MHz, CDCl3): δ -35.28 ppm.

Complex 33 was found to have an excitation maximum of 360 nm and a quantum yield of 96%.

It was found that also ligands that have more than one aliphatic substituents to the phosphorous atoms in accordance with the present invention can very well be used in the context of the present invention, in particular as light-emitting compounds

## Claims

1. A copper (I) complex of Formula (A) 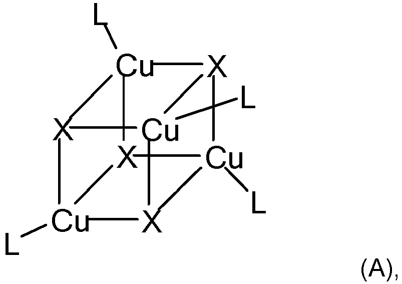 wherein:
each Cu is copper (I);
each X is independently from each other halogen;
each L is independently from each other a ligand that has a structure of Formula (A1):
P(Ar)ₘ(CHR2-CHR1-CO-Y-Rx)ₙ (A1),
wherein:
P is phosphorous;
each Ar is independently from each other an unsubstituted or substituted aryl residue;
each R1 is independently from each other hydrogen, -R^{a}-R^{b}, -O-R^{b}, -R^{a}-COO-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, - R^{a}-CO-R^{b}, deuterium, or halogen;
each R2 is independently from each other hydrogen, -O-R^{b}, -R^{a}-R^{b}, -R^{a}-COO-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b},
or -R^{a}-CO-R^{b}, deuterium, or halogen;
Y is O or a bond to a carbon atom of residue Rx or is N bound to two independent Rx, preferably wherein Y is O or a bond to a carbon atom of residue Rx;
Rx is an unsubstituted or substituted hydrocarbon residue comprising from 1 to 30 carbon atoms, a polymeric moiety, or a solid support, wherein Rx may optionally be or contribute to a linker that interconnects two ligands L with another;
m is an integer from 0 to 2;
n is an integer from 1 to 3;
the sum of n and m is 3;
R^{a} at each occurrence independently from each other is a single bond, an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue; and
R^{b} at each occurrence independently from each other is an unsubstituted or substituted C₁-C₂₀-(hetero)alkyl residue, an unsubstituted or substituted C₂-C₂₀-(hetero)alkenyl residue, an unsubstituted or substituted C₂-C₂₀-(hetero)alkinyl residue, an unsubstituted or substituted C₁-C₂₀-(hetero)cycloalkyl residue, an unsubstituted or substituted C₂-C₂₀-(hetero)cycloalkenyl residue, an unsubstituted or substituted C₂-C₂₀-(hetero)cycloalkinyl residue, an unsubstituted or substituted C₂-C₂₀-(hetero)aromatic residue, or an unsubstituted or substituted C₂-C₂₀-alk(hetero)aromatic residue,
wherein the phosphorous is bound to Cu, and
wherein said copper (I) complex has a neutral net charge,
wherein a substituent of a substituted residue does not comprise more than 20 carbon atoms.

2. The copper (I) complex of claim 1, wherein each X is iodine.

3. The copper (I) complex of any of claims 1 or 2, wherein each ligand L is a monovalent ligand of the same kind.

4. The copper (I) complex of any of claims 1 to 3, wherein each L is independently from each other a diarylphosphine residue of Formula (A2):
P(Ar)ₘ(CHR2-CHR1-CO-Y-R13)ₙ (A2),
wherein:
R13 is -R^{a}-R^{b}, -R^{c}-CO-O-R^{b}, -R^{c}-O-CO-R^{b}, -R^{c}-O-R^{b}, -R^{c}-CO-NH-R^{b}, -R^{c}-NH-CO-R^{b}, -R^{c}-NH-R^{b}, -R^{c}-CO-R^{b}, di- or polyethylene glycol, di- or polypropylene glycol, a polymeric moiety, or a solid support; and
R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue, wherein a substituent of a substituted residue does not comprise more than 20 carbon atoms,
P, Ar, R1, R2, Y, R^{a}, R^{b}, m and n are defined as in claim 1, and
wherein the phosphorous is bound to Cu.

5. The copper (I) complex of any of claims 1 to 4, wherein each L is a diphenylphosphine residue of Formula (A4): 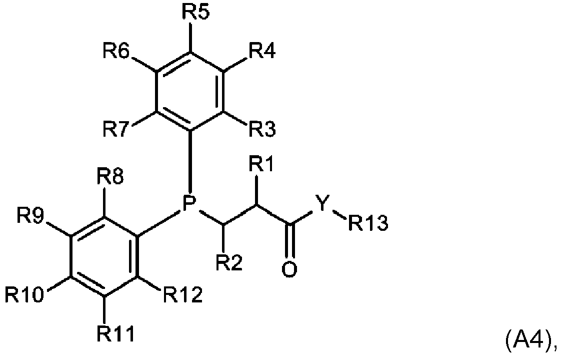 wherein P, R1, R2, Y, R13, R^{a}, R^{b} and R^{c} are defined as in any of claims 1 or 4, and wherein:
R3 to R12 are independently from each other selected from hydrogen, a C₁-C₁₈-alkyl residue and a C₁-C₁₂-alkoxy residue, and
wherein the phosphorous is bound to Cu.

6. The copper (I) complex of any of claims 1 or 2, wherein two ligands L are interconnected with another, thereby forming a bivalent ligand.

7. The copper (I) complex of any of claims 1, 2 or 6, wherein two L are interconnected with another, thereby forming a bivalent ligand of Formula (A3): 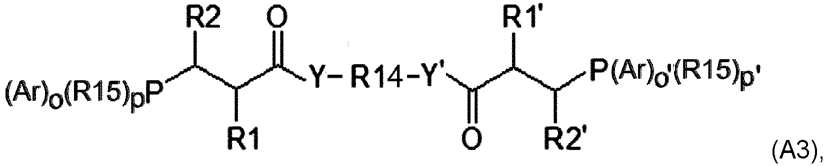 wherein:
o and o' are the same or different and are independently from each other an integer from 0 to 2;
p and p' are the same or different and are independently from each other an integer from 0 to 2;
the sum of o and p is 2 and the sum of o' and p' is 2;
R1 and R1' are the same or different and are independently from each other selected from hydrogen, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, and -R^{a}-CO-R^{b};
R2 and R2' are the same or different and are independently from each other selected from hydrogen, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, and -R^{a}-CO-R^{b};
Y and Y' are the same or different and are independently from each other selected from O and a single bond to a carbon atom of residue Rx;
R14 is a bivalent linker comprising 1 to 30 carbon atoms;
R15 is -R^{a}-R^{b}, -R^{c}-CO-O-R^{b}, -R^{c}-O-CO-R^{b}, -R^{c}-O-R^{b}, -R^{c}-CO-NH-R^{b}, -R^{c}-NH-CO-R^{b}, -R^{c}-NH-R^{b}, -R^{c}-CO-R^{b}, di- or polyethylene glycol, di- or polypropylene glycol, a polymeric moiety, or a solid support;
P, Ar, R^{a}, R^{b} and R^{c} are defined as in claim 1,
wherein phosphorous is each bound to a Cu.

8. The copper (I) complex of any of claims 1, 2, 6 or 7, wherein two L are interconnected with another, thereby forming a bivalent ligand of Formula (A5): 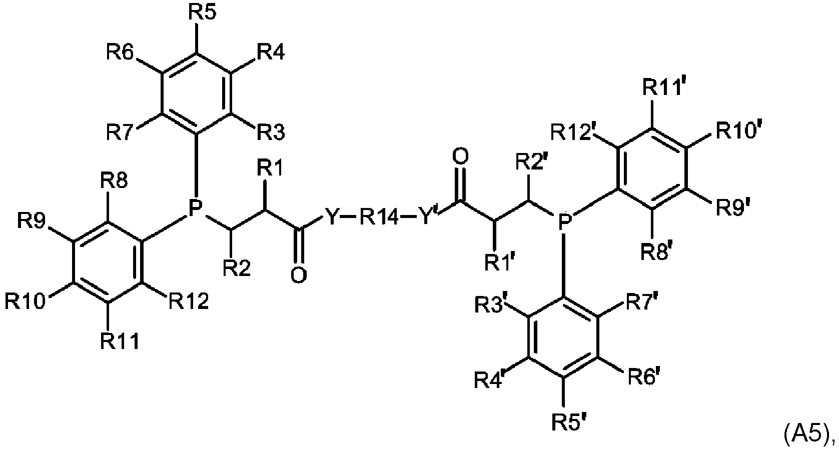 wherein:
R3 to R12 and R3' to R12' are independently from each other selected from hydrogen, a C₁-C₁₈-alkyl residue, and a C₁-C₁₂-alkoxy residue; and
R14 is selected from -R^{c}-, -R^{a}-O-R^{a}-, a di- or polyethylene glycol linker, a di- or polypropylene glycol linker, -R^{c}-CO-O-R^{c}-, -R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, -R^{c}-CO-NH-R^{c}-NH-COR^{c}-, -R^{c}-NH-CO-R^{c}-,-R^{c}-NH-CO-R^{c}-CO-NH-R^{c}-, -R^{c}-NH-R^{c}-, -R^{c}-CO-R^{c}-, and -R^{c}-NH-R^{c}-NH-R^{c}-;
R^{c} at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue, wherein a substituent of a substituted residue does not comprise more than 20 carbon atoms; and
P, R1, R1', R2, R2' Y, Y', R14, R^{a} and R^{b} are defined as in any of claims 1 to 7,
wherein phosphorous is each bound to a Cu.

9. The copper (I) complex of any of claims 1 to 8, wherein at least one mono- or bivalent ligand L is selected from the group consisting of: 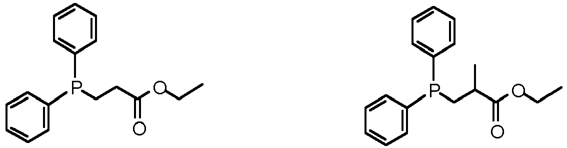 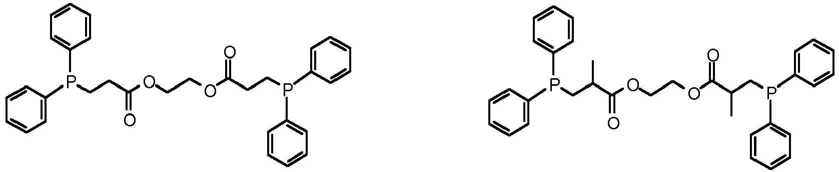 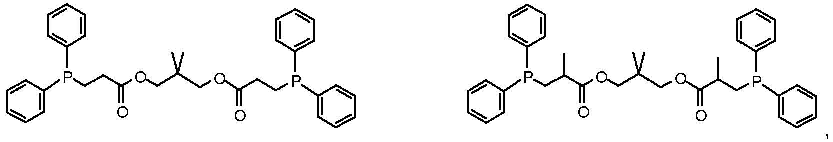 and 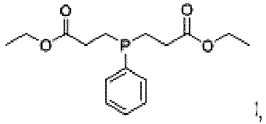 wherein the phosphorous is bound to Cu.

10. The copper (I) complex of any of claims 1 to 9, wherein said copper (I) complex is selected from the group consisting of: 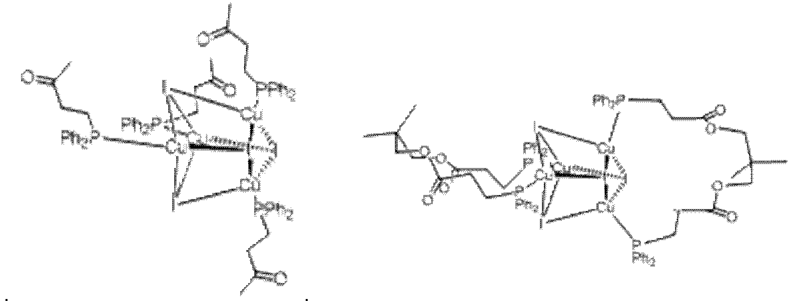 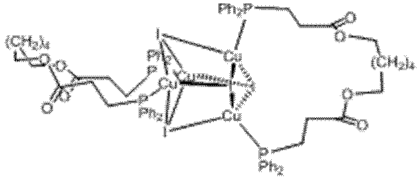 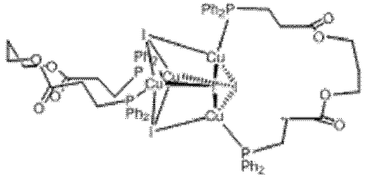 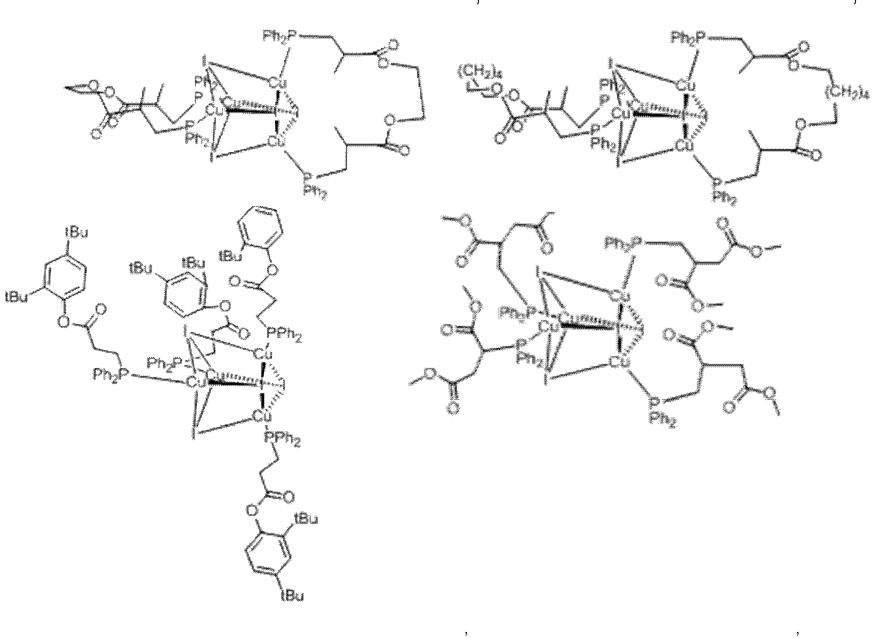 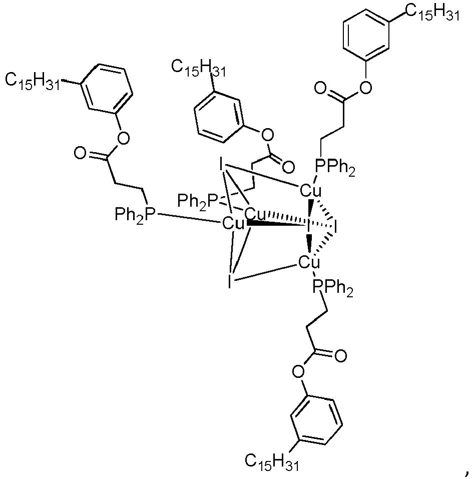 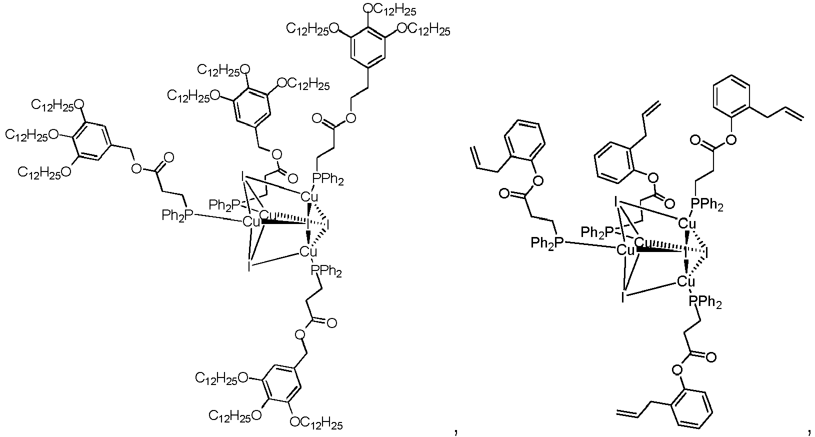 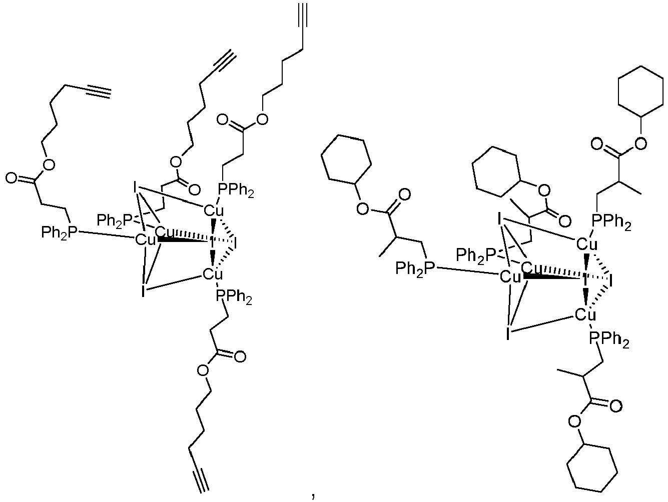 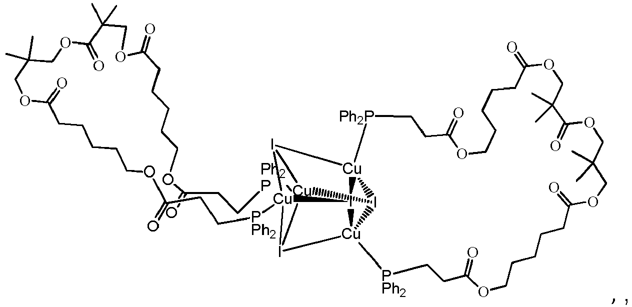 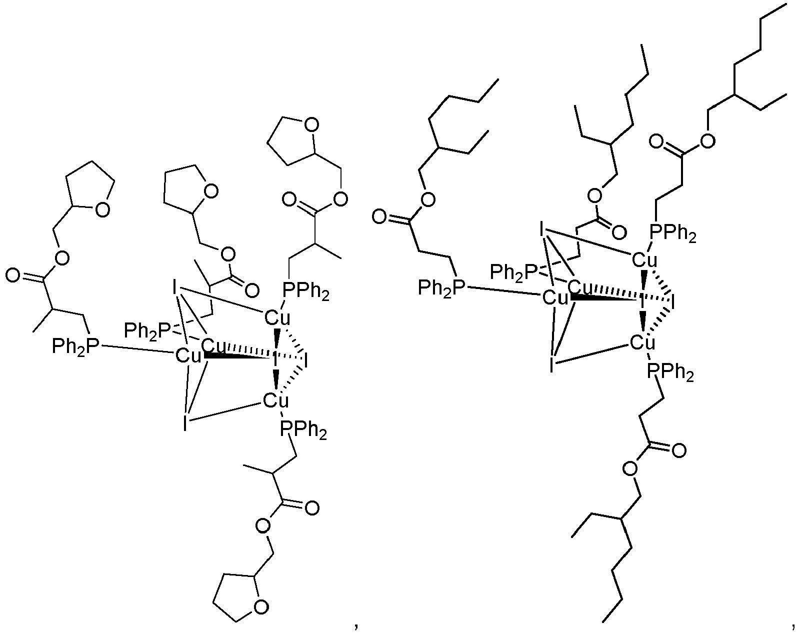 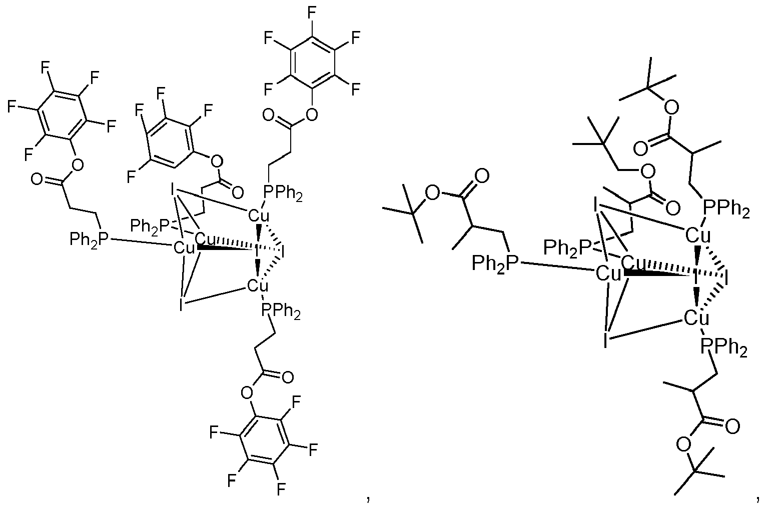 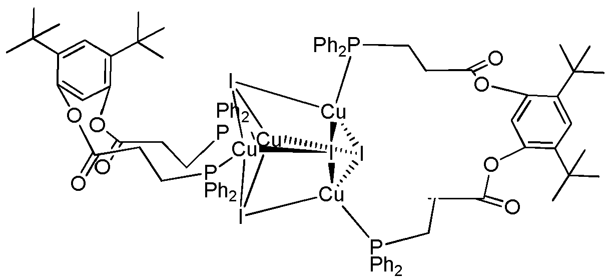 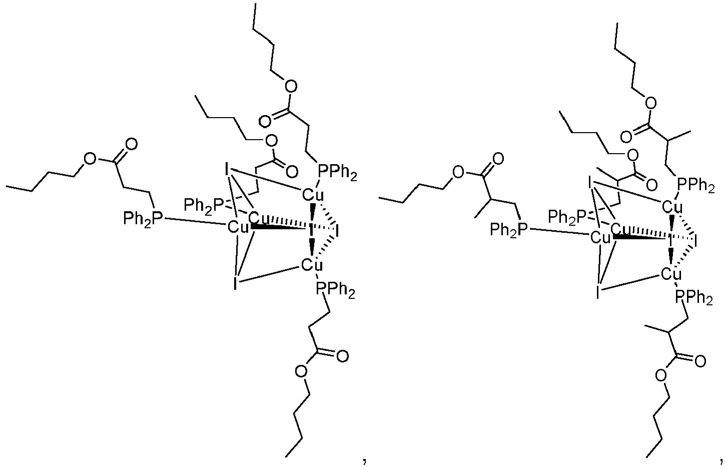 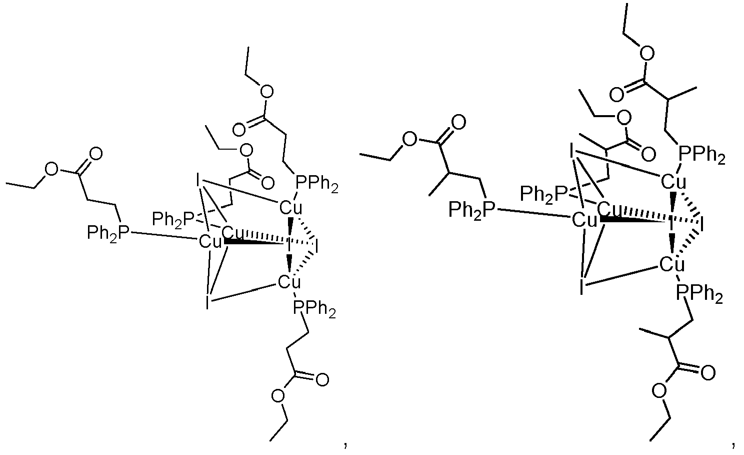 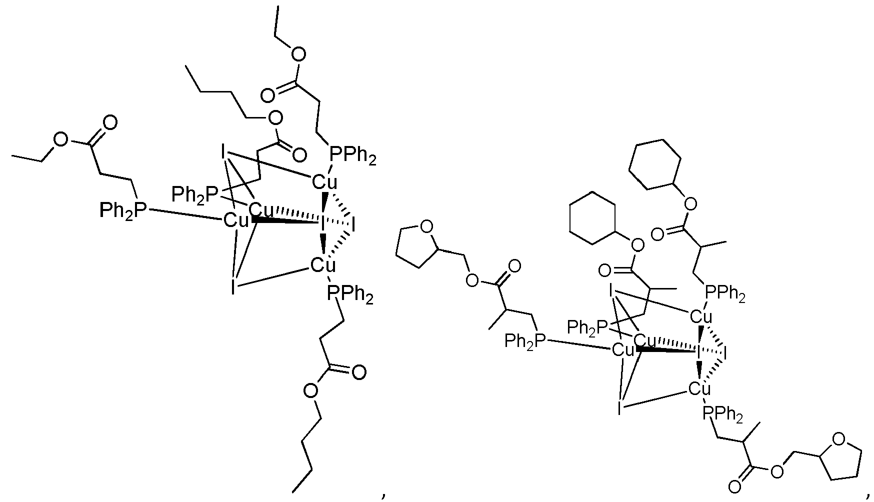 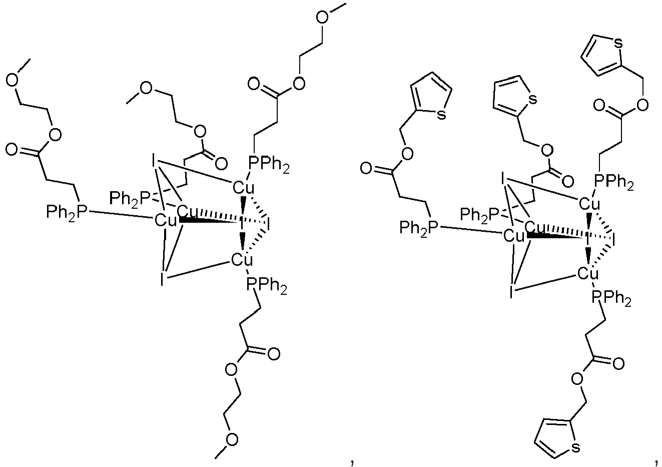 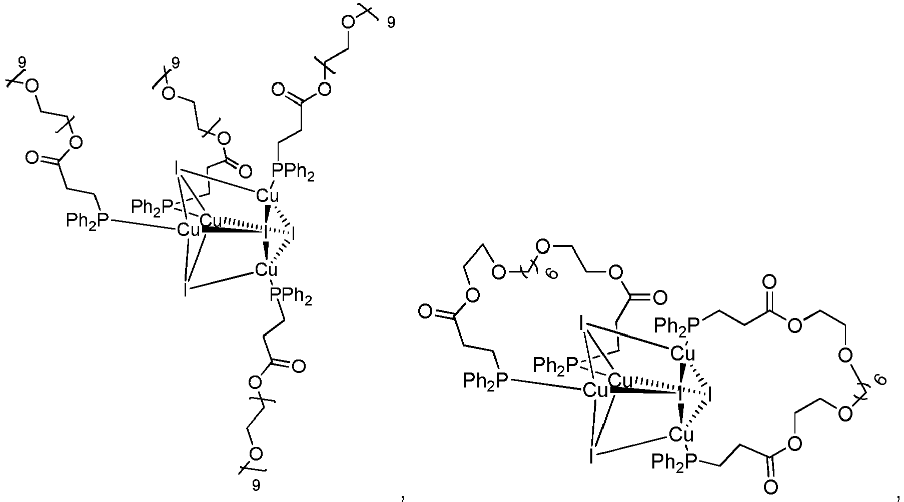 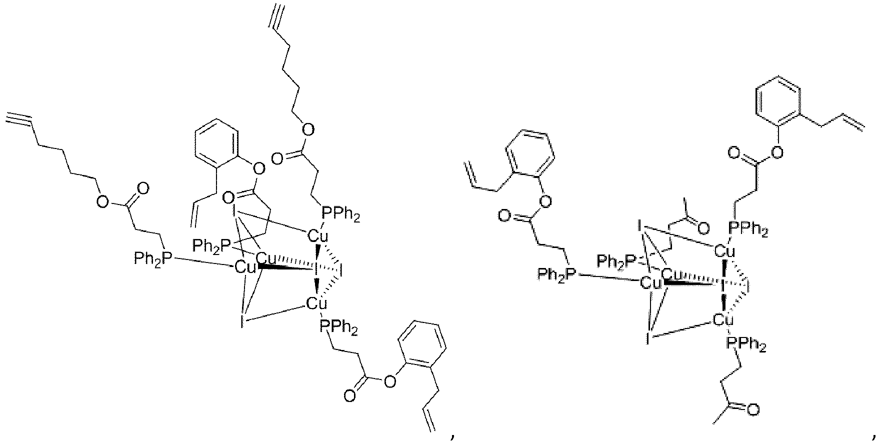 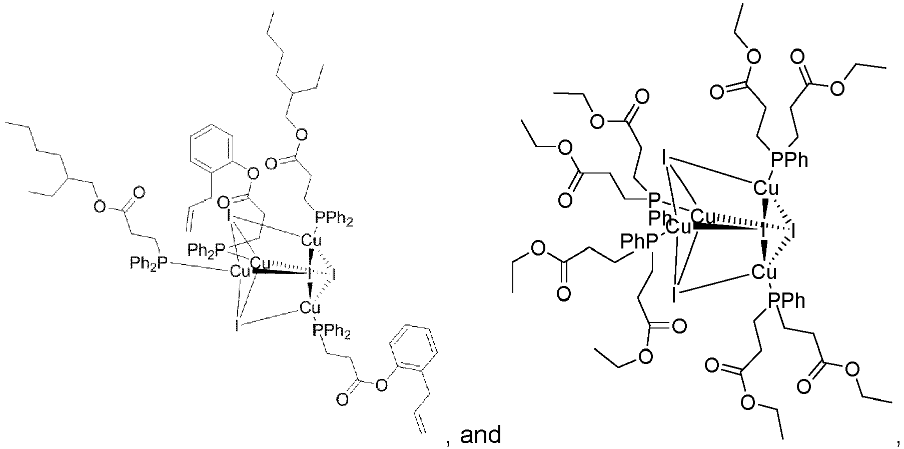 wherein Ph is an unsubstituted phenyl residue.

11. A method for generating a copper (I) complex of any of claims 1 to 10, said method comprising the following steps:
(i) providing, in an inert atmosphere:
(a) copper (I) halide,
(b) an electronically neutral substituted ligand L as defined in any of claims 1 or 3 to 10, wherein a substituent of a substituted ligand L does not comprise more than 20 carbon atoms, and
(c) a solvent in which components (a) and (b) are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

12. A method for generating a copper (I) complex of any of claims 1 to 10, said method comprising the following steps:
(i) providing, in an inert atmosphere:
(a') copper (I) halide,
(b') educts of the ligand L:
(b1') an electronically neutral phosphine ligand precursor of formula (L1):
PH(Ar)ₒ(CHR2-CHR1-CO-Y-Rx)ₚ (L1),
wherein:
o is an integer from 0 to 2; and
p is an integer from 0 to 2;
the sum of o and p is 2,
and P, H, Ar, R1, R2, Y and Rx are defined as in any of claims 1 to 10; and
(b2') an unbound (meth)acrylate derivative AD compound;
(c') a solvent in which components (a'), (b1') and (b2') are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

13. A method for generating a copper (I) complex of any of claims 1 to 10, said method comprising the following steps:
(i) providing, in an inert atmosphere:
(a") a copper (I) complex precursor of Formula (A') 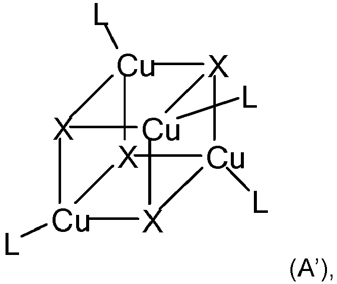 wherein:
each Cu is copper (I);
each X is independently from another halogen,
each L is independently from each other a ligand of formula (L1):
PH(Ar)ₒ(CHR2-CHR1-CO-Y-Rx)ₚ (L1),
wherein:
o is an integer from 0 to 2; and
p is an integer from 0 to 2;
the sum of o and p is 2,
and P, H, Ar, R1, R2, Y and Rx are defined as in any of claims 1 to 10; and
wherein said copper (I) complex has a neutral net charge,
(b") an unbound (meth)acrylate derivative AD compound, and
(c") a solvent in which components (a") and (b") are dissolved;
(ii) incubating the composition of step (i) at conditions allowing the formation of the copper (I) complex;
(iii) optionally removing the solvent and obtaining a solid residue; and
(iv) optionally mixing the composition of step (ii) or a solution obtained by dissolving the solid residue of step (iii) with an anti-solvent, thereby forming a precipitate, and subsequently drying the precipitate.

14. The method of any of claims 12 or 13, wherein the (meth)acrylate derivative AD compound is a compound of Formula (B): 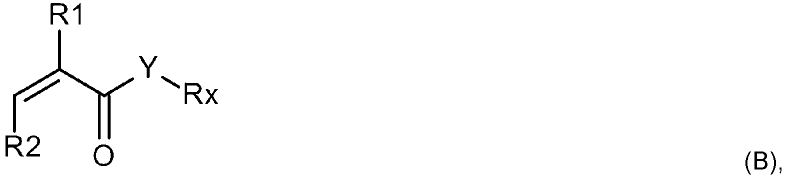 wherein:
R1 is hydrogen, -R^{a}-R^{b}, -O-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, deuterium, or halogen;
R2 is hydrogen, -O-R^{b}, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, or -R^{a}-CO-R^{b}, deuterium, or halogen;
Y is O or a bond to a carbon atom of residue Rx or is N bound to two independent Rx, preferably wherein Y is O or a bond to a carbon atom of residue Rx;
Rx is a residue comprising from 1 to 30 carbon atoms, a polymeric moiety, or a solid support, wherein Rx may optionally be or contribute to a linker that interconnects two ligands L with another;
R^{a} at each occurrence independently from each other is a single bond, at each occurrence independently from another is an unsubstituted or substituted C₁-C₂₀-(hetero)alkylene residue, an unsubstituted or substituted C₂-C₂₀-(hetero)alkenylene residue, an unsubstituted or substituted C₂-C₂₀-(hetero)alkinylene residue, an unsubstituted or substituted C₁-C₂₀-(hetero)cycloalkylene residue, an unsubstituted or substituted C₂-C₂₀-(hetero)cycloalkenylene residue, an unsubstituted or substituted C₂-C₂₀-(hetero)cycloalkinylene residue, an unsubstituted or substituted C₂-C₂₀-(hetero)arylene residue, or an unsubstituted or substituted C₂-C₂₀-alk(hetero)arylene residue wherein a substituent of a substituted residue does not comprise more than 20 carbon atoms; and
R^{b} at each occurrence independently from each other is an unsubstituted or substituted C₁-C₂₀-(hetero)alkyl residue, an unsubstituted or substituted C₂-C₂₀-(hetero)alkenyl residue, an unsubstituted or substituted C₂-C₂₀-(hetero)alkinyl residue, an unsubstituted or substituted C₁-C₂₀-(hetero)cycloalkyl residue, an unsubstituted or substituted C₂-C₂₀-(hetero)cycloalkenyl residue, an unsubstituted or substituted C₂-C₂₀-(hetero)cycloalkinyl residue, an unsubstituted or substituted C₂-C₂₀-(hetero)aromatic residue, or an unsubstituted or substituted C₂-C₂₀-alk(hetero)aromatic residue wherein a substituent of a substituted residue does not comprise more than 20 carbon atoms.

15. An opto-electronic device containing a copper (I) complex of any of claims 1 to 10.

## Patentansprüche

1. Kupfer(I)-Komplex der Formel (A) 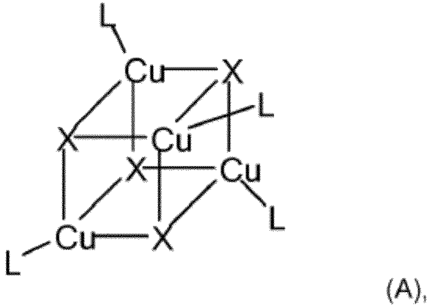 wobei:
Cu jeweils für Kupfer(I) steht;
X jeweils unabhängig voneinander für Halogen steht;
L jeweils unabhängig voneinander für einen Liganden steht, der eine Struktur der Formel (A1) aufweist:
P(Ar)ₘ(CHR2-CHR1-CO-Y-Rx)ₙ (A1),
wobei:
P für Phosphor steht;
Ar jeweils unabhängig voneinander für einen unsubstituierten oder substituierten Arylrest steht;
R1 jeweils unabhängig voneinander für Wasserstoff, -R^{a}-R^{b}, -O-R^{b}, -R^{a}-CO-O-R^{b}, -R^{a}-O-CO-R^{b}, -R^{a}-O-R^{b}, - R^{a}-CO-NH-R^{b}, -R^{a}-NH-CO-R^{b}, -R^{a}-NH-R^{b}, -R^{a}-CO-R^{b}, Deuterium oder Halogen steht;
R2 jeweils unabhängig voneinander für Wasserstoff, -O-R^{b}, -R^{a}-R^{b}, -R^{a}-CO-O-R^{b}, -R^{a}-O-CO-R^{b}, -R^{a}-O-R^{b}, - R^{a}-CO-NH-R^{b}, -R^{a}-NH-CO-R^{b}, -R^{a}-NH-R^{b} oder -R^{a}-CO-R^{b}, Deuterium oder Halogen steht;
Y für O oder eine Bindung an ein Kohlenstoffatom des Rests Rx steht oder für an zwei unabhängige Rx gebundenes N steht, vorzugsweise wobei Y für O oder eine Bindung an ein Kohlenstoffatom des Rests Rx steht;
Rx für einen unsubstituierten oder substituierten Kohlenwasserstoffrest mit 1 bis 30 Kohlenstoffatomen, eine polymere Gruppierung oder einen festen Träger steht, wobei Rx gegebenenfalls ein Linker, der zwei Liganden L miteinander verbindet, ist oder dazu beiträgt;
m für eine ganze Zahl von 0 bis 2 steht;
n für eine ganze Zahl von 1 bis 3 steht;
die Summe von n und m gleich 3 ist;
R^{a} bei jedem Auftreten unabhängig voneinander für eine Einfachbindung, einen substituierten oder unsubstituierten C₁-C₂₀- (Hetero) alkylenrest, einen substituierten oder unsubstituierten C₂-C₂₀-(Hetero)alkenylenrest, einen substituierten oder unsubstituierten C₂-C₂₀- (Hetero) alkinylenrest, einen substituierten oder unsubstituierten C₁-C₂₀-(Hetero)cycloalkylenrest, einen substituierten oder unsubstituierten C₂-C₂₀-(Hetero)cycloalkenylenrest, einen substituierten oder unsubstituierten C₂-C₂₀-(Hetero)cycloalkinylenrest, einen substituierten oder unsubstituierten C₂-C₂₀-(Hetero)arylenrest oder einen substituierten oder unsubstituierten C₂-C₂₀-Alk(hetero)arylenrest steht und
R^{b} bei jedem Auftreten unabhängig voneinander für einen substituierten oder unsubstituierten C₁-C₂₀-(Hetero)alkylrest, einen substituierten oder unsubstituierten C₂-C₂₀-(Hetero)alkenylrest, einen substituierten oder unsubstituierten C₂-C₂₀-(Hetero)alkinylrest, einen substituierten oder unsubstituierten C₁-C₂₀-(Hetero)cycloalkylrest, einen substituierten oder unsubstituierten C₂-C₂₀-(Hetero)cycloalkenylrest, einen substituierten oder unsubstituierten C₂-C₂₀-(Hetero)cycloalkinylrest, einen substituierten oder unsubstituierten C₂-C₂₀-(hetero)aromatischen Rest oder einen substituierten oder unsubstituierten C₂-C₂₀-alk (hetero) aromatischen Rest steht,
wobei der Phosphor an Cu gebunden ist und
wobei der Kupfer(I)-Komplex eine neutrale Nettoladung aufweist,
wobei ein Substituent eines substituierten Rests nicht mehr als 20 Kohlenstoffatome enthält.

2. Kupfer(I)-Komplex nach Anspruch 1, wobei X jeweils für Iod steht.

3. Kupfer(I)-Komplex nach Anspruch 1 oder 2, wobei der Ligand L jeweils für einen einwertigen Liganden der gleichen Art steht.

4. Kupfer(I)-Komplex nach einem der Ansprüche 1 bis 3, wobei L jeweils unabhängig voneinander für einen Diarylphosphinrest der Formel (A2) steht:
P(Ar)ₘ(CHR2-CHR1-CO-Y-R13)ₙ (A2),
wobei:
R13 für -R^{a}-R^{b}, -R^{c}-CO-O-R^{b}, -R^{c}-O-CO-R^{b}, -R^{c}-O-R^{b}, - R^{c}-CO-NH-R^{b}, -R^{c}-NH-CO-R^{b}, -R^{c}-NH-R^{b}, -R^{c}-CO-R^{b}, Di- oder Polyethylenglykol, Di- oder Polypropylenglykol, eine polymere Gruppierung oder einen festen Träger steht und
R^{c} bei jedem Auftreten unabhängig voneinander für einen substituierten oder unsubstituierten C₁-C₂₀-(Hetero)alkylenrest, einen substituierten oder unsubstituierten C₂-C₂₀-(Hetero)alkenylenrest, einen substituierten oder unsubstituierten C₂-C₂₀-(Hetero)alkinylenrest, einen substituierten oder unsubstituierten C₁-C₂₀-(Hetero)cycloalkylenrest, einen substituierten oder unsubstituierten C₂-C₂₀-(Hetero)cycloalkenylenrest, einen substituierten oder unsubstituierten C₂-C₂₀-(Hetero)cycloalkinylenrest, einen substituierten oder unsubstituierten C₂-C₂₀-(Hetero)arylenrest oder einen substituierten oder unsubstituierten C₂-C₂₀-Alk(hetero)arylenrest steht, wobei ein Substituent eines substituierten Rests nicht mehr als 20 Kohlenstoffatome enthält,
P, Ar, R1, R2, Y, R^{a}, R^{b}, m und n wie in Anspruch 1 definiert sind und
wobei der Phosphor an Cu gebunden ist.

5. Kupfer(I)-Komplex nach einem der Ansprüche 1 bis 4, wobei L jeweils für einen Diphenylphosphinrest der Formel (A4) steht: 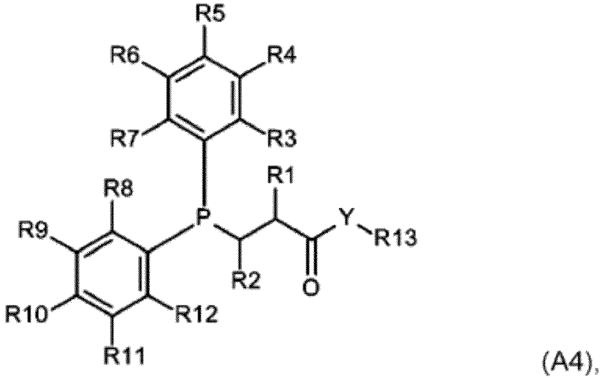 wobei P, R1, R2, Y, R13, R^{a}, R^{b} und R^{c} wie in Anspruch 1 oder 4 definiert sind und wobei:
R3 bis R12 unabhängig voneinander aus Wasserstoff, einem C₁-C₁₈-Alkylrest und einem C₁-C₁₂-Alkoxyrest ausgewählt sind und
wobei der Phosphor an Cu gebunden ist.

6. Kupfer (I) -Komplex nach Anspruch 1 oder 2, wobei zwei Liganden L miteinander verbunden sind und dadurch einen zweiwertigen Liganden bilden.

7. Kupfer (I) -Komplex nach einem der Ansprüche 1, 2 oder 6, wobei zwei Liganden L miteinander verbunden sind und dadurch einen zweiwertigen Liganden der Formel (A3) bilden: 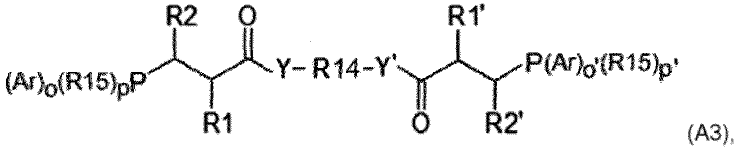 wobei:
o und o' gleich oder verschieden sind und unabhängig voneinander für eine ganze Zahl von 0 bis 2 stehen;
p und p' gleich oder verschieden sind und unabhängig voneinander für eine ganze Zahl von 0 bis 2 stehen; die Summe von o und p gleich 2 ist und die Summe von o' und p' gleich 2 ist;
R1 und R1' gleich oder voneinander verschieden sind und unabhängig voneinander aus Wasserstoff, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b} und -R^{a}-CO-R^{b} ausgewählt sind;
R2 und R2' gleich oder voneinander verschieden sind und unabhängig voneinander aus Wasserstoff, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b} und -R^{a}-CO-R^{b} ausgewählt sind;
Y und Y' gleich oder verschieden sind und unabhängig voneinander aus O und einer Einfachbindung an ein Kohlenstoffatom des Rests Rx ausgewählt sind;
R14 für einen zweiwertigen Linker mit 1 bis 30 Kohlenstoffatomen steht;
R15 für -R^{a}-R^{b}, -R^{c}-CO-O-R^{b}, -R^{c}-O-CO-R^{b}, -R^{c}-O-R^{b}, - R^{c}-CO-NH-R^{b}, -R^{c}-NH-CO-R^{b}, -R^{c}-NH-R^{b}, -R^{c}-CO-R^{b}, Di- oder Polyethylenglykol, Di- oder Polypropylenglykol, eine polymere Gruppierung oder einen festen Träger steht;
P, Ar, R^{a}, R^{b} und R^{c} wie in Anspruch 1 definiert sind,
wobei Phosphor jeweils an ein Cu gebunden ist.

8. Kupfer(I)-Komplex nach einem der Ansprüche 1, 2, 6 oder 7, wobei zwei Liganden L miteinander verbunden sind und dadurch einen zweiwertigen Liganden der Formel (A5) bilden: 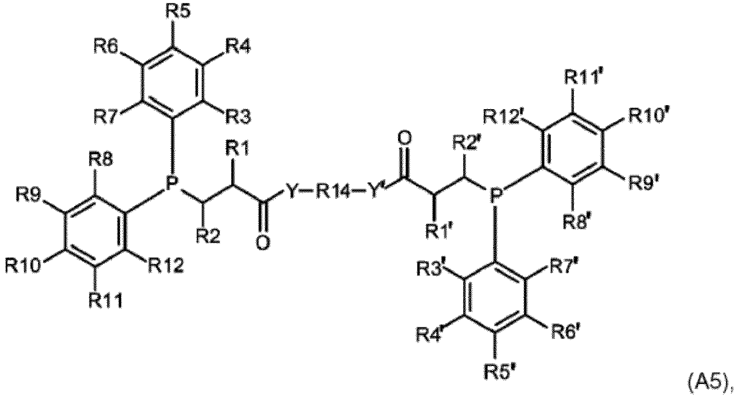 wobei:
R3 bis R12 und R3' bis R12' unabhängig voneinander aus Wasserstoff, einem C₁-C₁₈-Alkylrest und einem C₁-C₁₂-Alkoxyrest ausgewählt sind und
R14 aus -R^{c}-, -R^{a}-O-R^{a}-, einem Di- oder Polyethylenglykol-Linker, einem Di- oder Polypropylenglykol-Linker, -R^{c}-CO-O-R^{c}-, -R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, -R^{c}-CO-NH-R^{c}-NH-CO-R^{c}-, -R^{c}-NH-CO-R^{c}-,-R^{c}-NH-CO-R^{c}-CO-NH-R^{c}-, -R^{c}-NH-R^{c}-, -R^{c}-CO-R^{c}- und -R^{c}-NH-R^{c}-NH-R^{c}- ausgewählt ist;
R^{c} bei jedem Auftreten unabhängig voneinander für einen substituierten oder unsubstituierten C₁-C₂₀-(Hetero)alkylenrest, einen substituierten oder unsubstituierten C₂-C₂₀-(Hetero)alkenylenrest, einen substituierten oder unsubstituierten C₂-C₂₀-(Hetero)alkinylenrest, einen substituierten oder unsubstituierten C₁-C₂₀-(Hetero)cycloalkylenrest, einen substituierten oder unsubstituierten C₂-C₂₀-(Hetero)cycloalkenylenrest, einen substituierten oder unsubstituierten C₂-C₂₀-(Hetero)cycloalkinylenrest, einen substituierten oder unsubstituierten C₂-C₂₀-(Hetero)arylenrest oder einen substituierten oder unsubstituierten C₂-C₂₀-Alk(hetero)arylenrest steht, wobei ein Substituent eines substituierten Rests nicht mehr als 20 Kohlenstoffatome enthält; und
P, R1, R1', R2, R2' Y, Y', R14, R^{a} und R^{b} wie in einem der Ansprüche 1 bis 7 definiert sind,
wobei Phosphor jeweils an ein Cu gebunden ist.

9. Kupfer(I)-Komplex nach einem der Ansprüche 1 bis 8, wobei mindestens ein ein- oder zweiwertiger Ligand L aus der Gruppe bestehend aus: 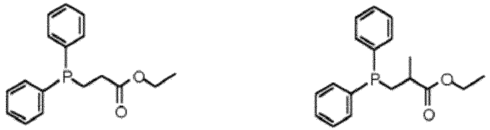 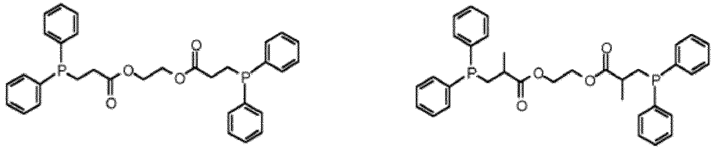 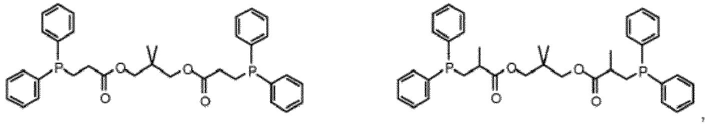 und 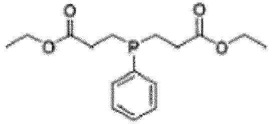 ausgewählt ist,
wobei der Phosphor jeweils an Cu gebunden ist.

10. Kupfer(I)-Komplex nach einem der Ansprüche 1 bis 9, wobei der Kupfer(I)-Komplex aus der Gruppe bestehend aus: 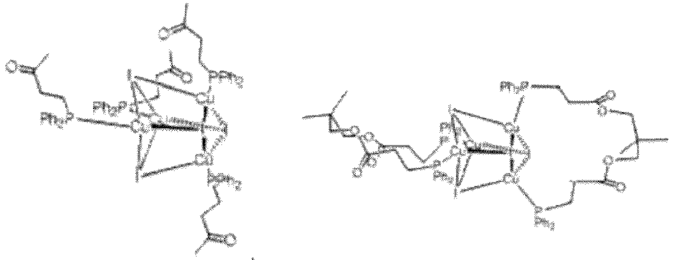 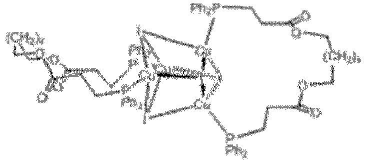 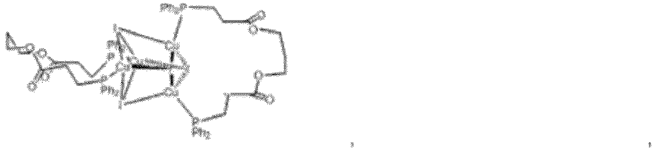 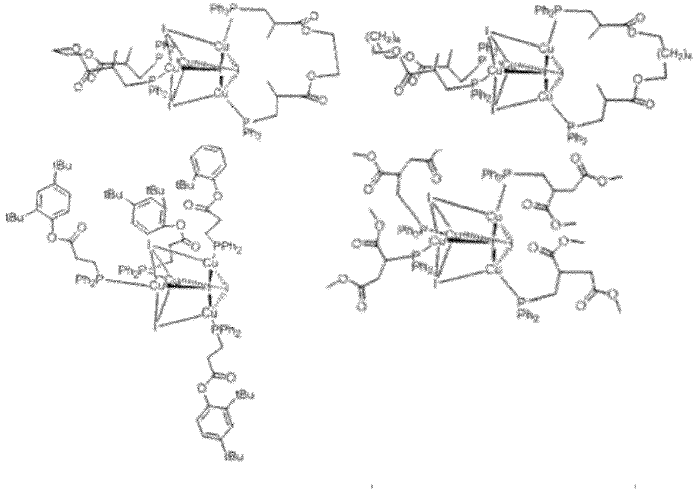 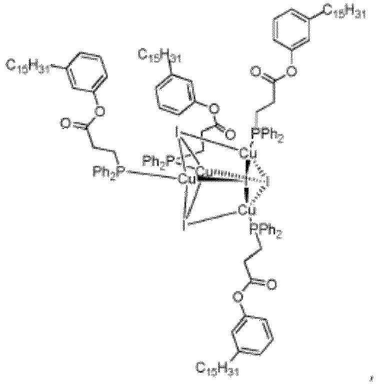 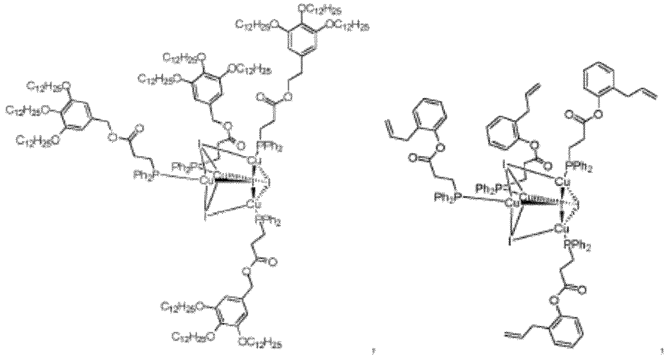 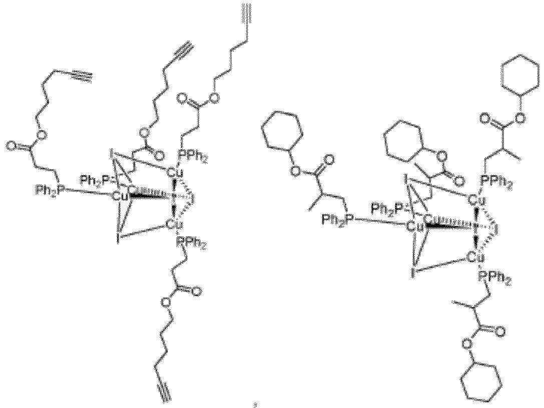 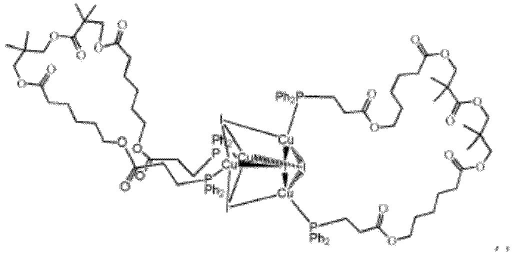 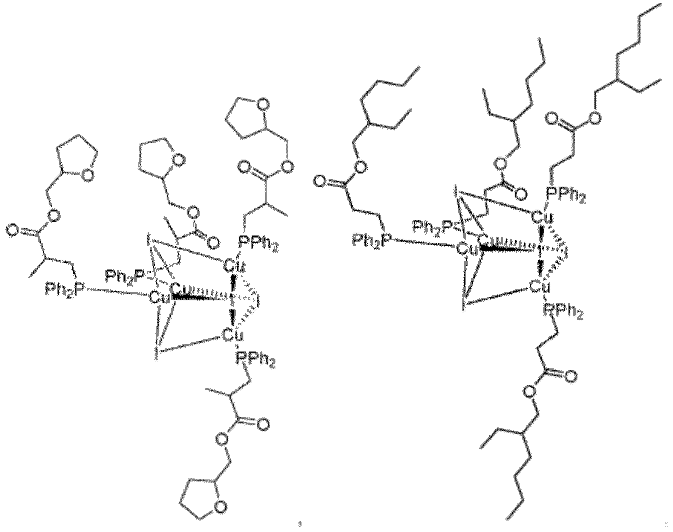 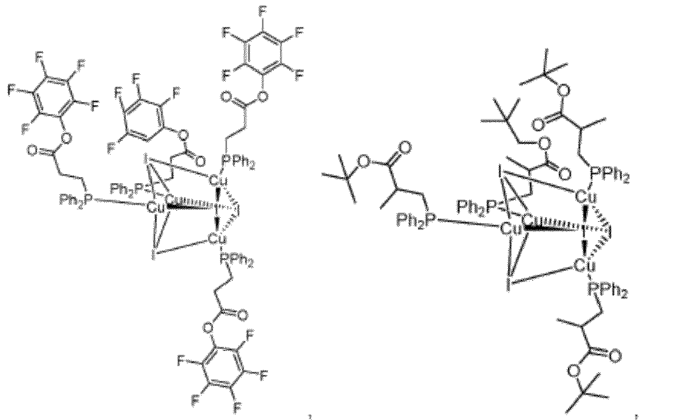 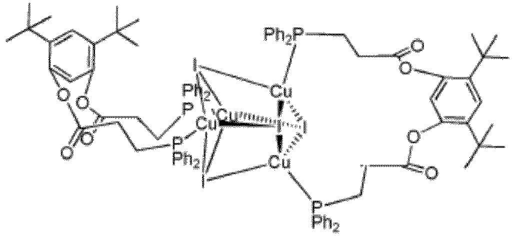 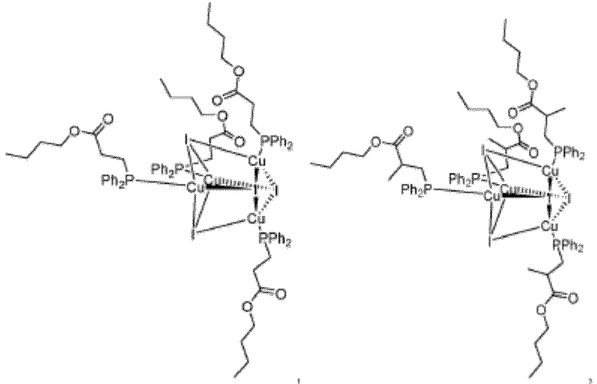 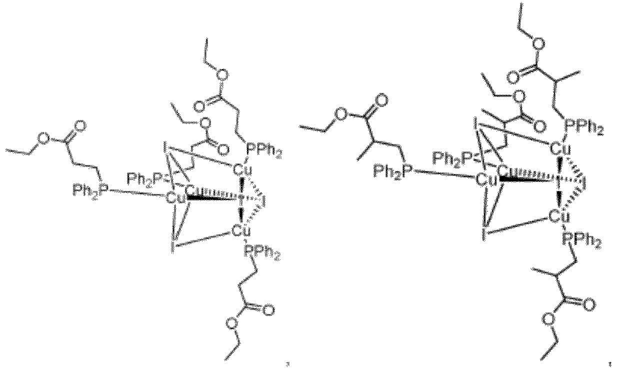 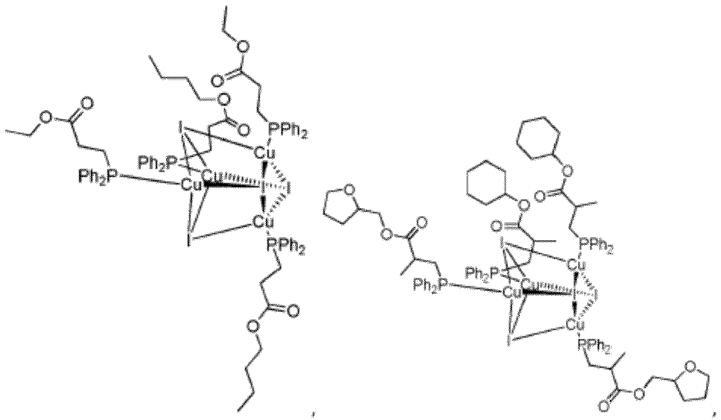 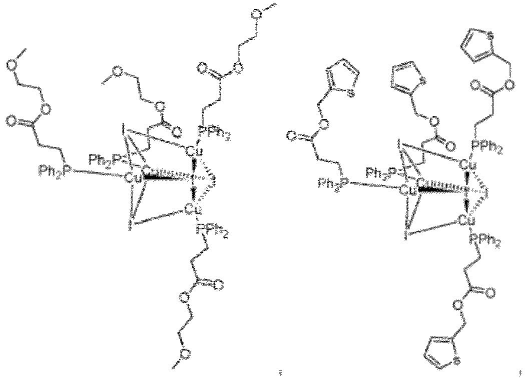 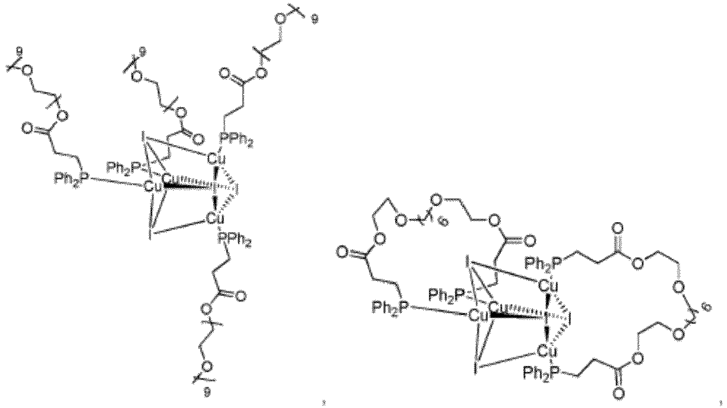 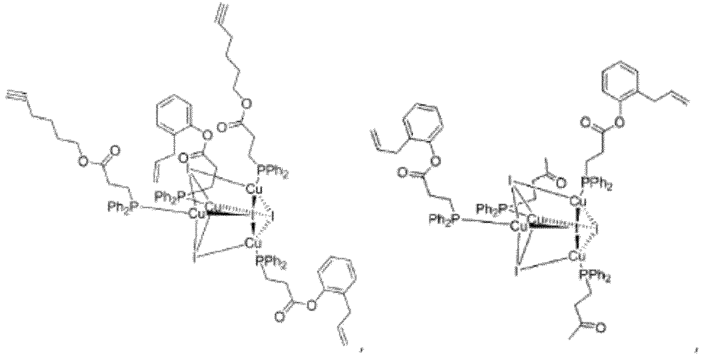 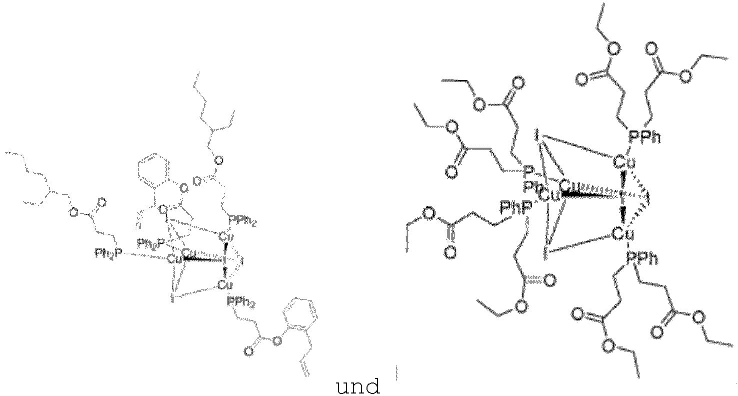 ausgewählt ist,
wobei Ph für einen unsubstituierten Phenylrest steht.

11. Verfahren zur Erzeugung eines Kupfer(I)-Komplexes nach einem der Ansprüche 1 bis 10, wobei das Verfahren die folgenden Schritte umfasst:
(i) Bereitstellen von
(a) Kupfer(I)-halogenid,
(b) einem elektronisch neutralen substituierten Liganden L gemäß einem der Ansprüche 1 oder 3 bis 10, wobei ein Substituent eines substituierten Liganden L nicht mehr als 20 Kohlenstoffatome enthält, und
(c) einem Lösungsmittel, in dem die Komponenten (a) und (b) gelöst werden,
in einer Inertatmosphäre;
(ii) Inkubieren der Zusammensetzung aus Schritt (i) unter Bedingungen, die die Bildung des Kupfer(I)-Komplexes ermöglichen;
(iii) gegebenenfalls Entfernen des Lösungsmittels und Erhalten eines festen Rückstands und
(iv) gegebenenfalls Mischen der Zusammensetzung aus Schritt (ii) oder einer durch Lösen des festen Rückstands aus Schritt (iii) erhaltenen Lösung mit einem Antilösungsmittel, wodurch ein Niederschlag gebildet wird, und anschließendes Trocknen des Niederschlags.

12. Verfahren zur Erzeugung eines Kupfer(I)-Komplexes nach einem der Ansprüche 1 bis 10, wobei das Verfahren die folgenden Schritte umfasst:
(i) Bereitstellen von
(a') Kupfer(I)-halogenid,
(b') Edukten des Liganden L:
(b1') einem Vorläufer eines elektronisch neutralen Phosphinliganden der Formel (L1):
PH(Ar)ₒ(CHR2-CHR1-CO-Y-Rx)ₙ (L1),
wobei:
o für eine ganze Zahl von 0 bis 2 steht und
p für eine ganze Zahl von 0 bis 2 steht;
die Summe von o und p = 2 ist und P, H, Ar, R1, R2, Y und Rx wie in einem der Ansprüche 1 bis 10 definiert sind; und
(b2') einer ungebundenen (Meth)-acrylatderivat-AD-Verbindung;
(c') einem Lösungsmittel, in dem die Komponenten (a'), (b1') und (b2') gelöst werden,
in einer Inertatmosphäre;
(ii) Inkubieren der Zusammensetzung aus Schritt (i) unter Bedingungen, die die Bildung des Kupfer(I)-Komplexes ermöglichen;
(iii) gegebenenfalls Entfernen des Lösungsmittels und Erhalten eines festen Rückstands und
(iv) gegebenenfalls Mischen der Zusammensetzung aus Schritt (ii) oder einer durch Lösen des festen Rückstands aus Schritt (iii) erhaltenen Lösung mit einem Antilösungsmittel, wodurch ein Niederschlag gebildet wird, und anschließendes Trocknen des Niederschlags.

13. Verfahren zur Erzeugung eines Kupfer(I)-Komplexes nach einem der Ansprüche 1 bis 10, wobei das Verfahren die folgenden Schritte umfasst:
(i) Bereitstellen von
(a") einer Kupfer(I)-Komplex-Vorstufe der Formel (A') 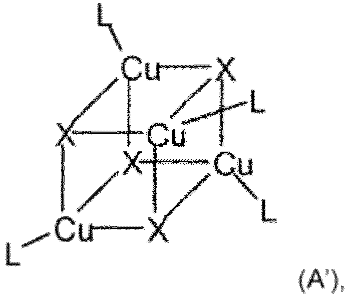 wobei:
Cu jeweils für Kupfer(I) steht;
X jeweils unabhängig voneinander für Halogen steht,
L jeweils unabhängig voneinander für einen Liganden der Formel (L1) steht:
PH(Ar)ₒ(CHR2-CHR1-CO-Y-Rx)ₚ (L1),
wobei:
o für eine ganze Zahl von 0 bis 2 steht und
p für eine ganze Zahl von 0 bis 2 steht;
die Summe von o und p = 2 ist und P, H, Ar, R1, R2, Y und Rx wie in einem der Ansprüche 1 bis 10 definiert sind; und
wobei der Kupfer(I)-Komplex eine neutrale Nettoladung aufweist,
(b") einer ungebundenen (Meth)acrylat-derivat-AD-Verbindung und
(c") einem Lösungsmittel, in dem die Komponenten (a") und (b") gelöst werden,
in einer Inertatmosphäre;
(ii) Inkubieren der Zusammensetzung aus Schritt (i) unter Bedingungen, die die Bildung des Kupfer(I)-Komplexes ermöglichen;
(iii) gegebenenfalls Entfernen des Lösungsmittels und Erhalten eines festen Rückstands und
(iv) gegebenenfalls Mischen der Zusammensetzung aus Schritt (ii) oder einer durch Lösen des festen Rückstands aus Schritt (iii) erhaltenen Lösung mit einem Antilösungsmittel, wodurch ein Niederschlag gebildet wird, und anschließendes Trocknen des Niederschlags.

14. Verfahren nach Anspruch 12 oder 13, wobei es sich bei der (Meth)acrylatderivat-AD-Verbindung um eine Verbindung der Formel (B) handelt: 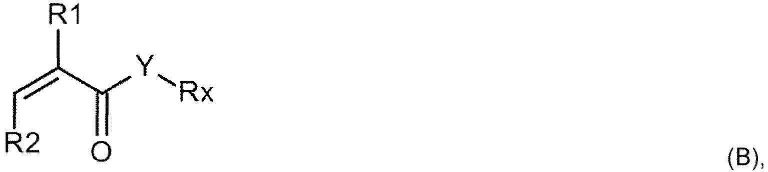 wobei:
R1 für Wasserstoff, -R^{a}-R^{b}, -O-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, -R^{a}-CO-R^{b}, Deuterium oder Halogen steht;
R2 für Wasserstoff, -O-R^{b}, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b} oder -R^{a}-CO-R^{b}, Deuterium oder Halogen steht;
Y für O oder eine Bindung an ein Kohlenstoffatom des Rests Rx steht oder für an zwei unabhängige Rx gebundenes N steht, vorzugsweise wobei Y für O oder eine Bindung an ein Kohlenstoffatom des Rests Rx steht;
Rx für einen Rest mit 1 bis 30 Kohlenstoffatomen, eine polymere Gruppierung oder einen festen Träger steht, wobei Rx gegebenenfalls ein Linker, der zwei Liganden L miteinander verbindet, ist oder dazu beiträgt;
R^{a} bei jedem Auftreten unabhängig voneinander für eine Einfachbindung, bei jedem Auftreten unabhängig voneinander für einen substituierten oder unsubstituierten C₁-C₂₀-(Hetero)alkylenrest, einen substituierten oder unsubstituierten C₂-C₂₀-(Hetero)alkenylenrest, einen substituierten oder unsubstituierten C₂-C₂₀- (Hetero) alkinylenrest, einen substituierten oder unsubstituierten C₁-C₂₀-(Hetero)cycloalkylenrest, einen substituierten oder unsubstituierten C₂-C₂₀-(Hetero)cycloalkenylenrest, einen substituierten oder unsubstituierten C₂-C₂₀-(Hetero)cycloalkinylenrest, einen substituierten oder unsubstituierten C₂-C₂₀-(Hetero)arylenrest oder einen substituierten oder unsubstituierten C₂-C₂₀-Alk(hetero)arylenrest steht, wobei ein Substituent eines substituierten Rests nicht mehr als 20 Kohlenstoffatome enthält; und
R^{b} bei jedem Auftreten unabhängig voneinander für einen substituierten oder unsubstituierten C₁-C₂₀-(Hetero)alkylrest, einen substituierten oder unsubstituierten C₂-C₂₀-(Hetero)alkenylrest, einen substituierten oder unsubstituierten C₂-C₂₀-(Hetero)alkinylrest, einen substituierten oder unsubstituierten C₁-C₂₀-(Hetero)cycloalkylrest, einen substituierten oder unsubstituierten C₂-C₂₀-(Hetero)cycloalkenylrest, einen substituierten oder unsubstituierten C₂-C₂₀-(Hetero)cycloalkinylrest, einen substituierten oder unsubstituierten C₂-C₂₀-(hetero)aromatischen Rest oder einen substituierten oder unsubstituierten C₂-C₂₀-alk (hetero) aromatischen Rest steht, wobei ein Substituent eines substituierten Rests nicht mehr als 20 Kohlenstoffatome enthält.

15. Optoelektronische Vorrichtung, enthaltend einen Kupfer(I) -Komplex nach einem der Ansprüche 1 bis 10.

## Revendications

1. Complexe de cuivre (I) de formule (A) 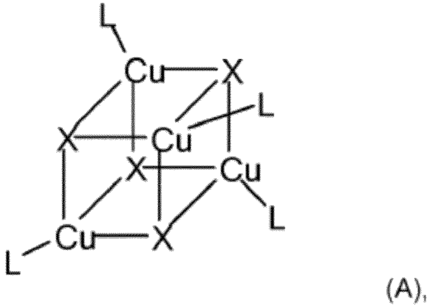
chaque Cu étant cuivre (I) ;
chaque X étant indépendamment les uns des autres halogène ;
chaque L étant indépendamment les uns des autres un ligand qui possède une structure de formule (A1) :
P(Ar)ₘ(CHR2-CHR1-CO-Y-Rx)ₙ (A1),
P étant phosphore ;
chaque Ar étant indépendamment les uns des autres un radical aryle non substitué ou substitué ;
chaque R1 étant indépendamment les uns des autres hydrogène, -R^{a}-R^{b}, -O-R^{b}, -R^{a}-CO-O-R^{b}, -R^{a}-O-CO-R^{b}, - R^{a}-O-R^{b}, -R^{a}-CO-NH-R^{b}, -R^{a}-NH-CO-R^{b}, -R^{a}-NH-R^{b}, - R^{a}-CO-R^{b}, deutérium, ou halogène ;
chaque R2 étant indépendamment les uns des autres hydrogène, -O-R^{b}, -R^{a}-R^{b}, -R^{a}-CO-O-R^{b}, -R^{a}-O-CO-R^{b}, - R^{a}-O-R^{b}, -R^{a}-CO-NH-R^{b}, -R^{a}-NH-CO-R^{b}, -R^{a}-NH-R^{b}, ou - R^{a}-CO-R^{b}, deutérium, ou halogène ;
Y étant O ou une liaison à un atome de carbone du radical Rx ou étant N lié à deux Rx indépendants, préférablement, Y étant O ou une liaison à un atome de carbone du radical Rx ;
Rx étant un radical hydrocarboné non substitué ou substitué comprenant de 1 à 30 atomes de carbone, un groupement polymérique, ou un support solide, Rx pouvant éventuellement être ou contribuer à un lieur qui interconnecte deux ligands L l'un avec l'autre ;
m étant un entier de 0 à 2 ;
n étant un entier de 1 à 3 ;
la somme de n et m étant 3 ;
R^{a} en chaque occurrence indépendamment les uns des autres étant une simple liaison, un radical C₁-C₂₀-(hétéro)alkylène non substitué ou substitué, un radical C₂-C₂₀- (hétéro)alcénylène non substitué ou substitué, un radical C₂-C₂₀- (hétéro)alcynylène non substitué ou substitué, un radical C₁-C₂₀-(hétéro)cycloalkylène non substitué ou substitué, un radical C₂-C₂₀- (hétéro) cycloalcénylène non substitué ou substitué, un radical C₂-C₂₀-(hétéro)cycloalcynylène non substitué ou substitué, un radical C₂-C₂₀- (hétéro) arylène non substitué ou substitué, ou un radical C₂-C₂₀-alk (hétéro) arylène non substitué ou substitué ; et
R^{b} en chaque occurrence indépendamment les uns des autres étant un radical C₁-C₂₀- (hétéro) alkyle non substitué ou substitué, un radical C₂-C₂₀-(hétéro)alcényle non substitué ou substitué, un radical C₂-C₂₀-(hétéro)alcynyle non substitué ou substitué, un radical C₁-C₂₀-(hétéro)cycloalkyle non substitué ou substitué, un radical C₂-C₂₀-(hétéro)cycloalcényle non substitué ou substitué, un radical C₂-C₂₀-(hétéro)cycloalcynyle non substitué ou substitué, un radical C₂-C₂₀-(hétéro)aromatique non substitué ou substitué, ou un radical C₂-C₂₀-alk (hétéro) aromatique non substitué ou substitué,
le phosphore étant lié au Cu, et
ledit complexe de cuivre (I) possédant une charge nette neutre,
un substituant d'un radical substitué ne comprenant pas plus de 20 atomes de carbone.

2. Complexe de cuivre (I) selon la revendication 1, chaque X étant iode.

3. Complexe de cuivre (I) selon l'une quelconque des revendications 1 ou 2, chaque ligand L étant un ligand monovalent de la même sorte.

4. Complexe de cuivre (I) selon l'une quelconque des revendications 1 à 3, chaque L étant indépendamment les uns des autres un radical diarylphosphine de formule (A2) :
**P(Ar)ₘ(CHR2-CHR1-CO-Y-R13)ₙ** (A2),
R13 étant -R^{a}-R^{b}, -R^{c}-CO-O-R^{b}, -R^{c}-O-CO-R^{b}, -R^{c}-O-R^{b}, -R^{c}-CO-NH-R^{b}, -R^{c}- NH-CO-R^{b}, -R^{c}-NH-R^{b}, -R^{c}-CO-R^{b}, di- ou polyéthylène glycol, di- ou polypropylène glycol, un groupement polymérique, ou un support solide ; et
R^{c} en chaque occurrence indépendamment les uns des autres étant un radical C₁-C₂₀- (hétéro)alkylène non substitué ou substitué, un radical C₂-C₂₀-(hétéro)alcénylène non substitué ou substitué, un radical C₂-C₂₀- (hétéro)alcynylène non substitué ou substitué, un radical C₁-C₂₀- (hétéro)cycloalkylène non substitué ou substitué, un radical C₂-C₂₀-(hétéro)cycloalcénylène non substitué ou substitué, un radical C₂-C₂₀- (hétéro) cycloalcynylène non substitué ou substitué, un radical C₂-C₂₀-(hétéro)arylène non substitué ou substitué, ou un radical C₂-C₂₀-alk (hétéro) arylène non substitué ou substitué, un substituant d'un radical substitué ne comprenant pas plus de 20 atomes de carbone, P, Ar, R1 , R2, Y, R^{a}, R^{b}, m et n étant définis comme dans la revendication 1 , et
le phosphore étant lié au Cu.

5. Complexe de cuivre (I) selon l'une quelconque des revendications 1 à 4, chaque L étant un radical de diphénylphosphine de formule (A4) : 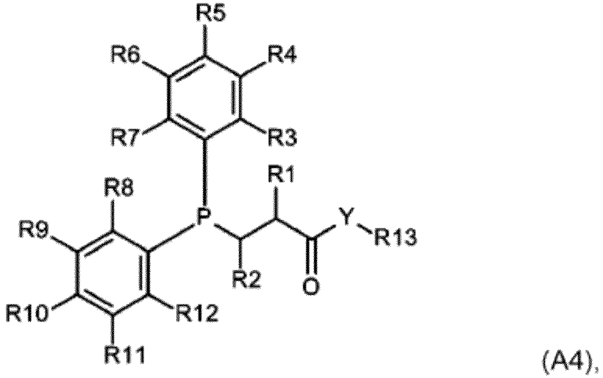 P, R1 , R2, Y, R13, R^{a}, R^{b} et R^{c} étant définis comme dans l'une quelconque des revendications 1 ou 4, et :
R3 à R12 étant indépendamment les uns des autres choisis parmi hydrogène, un radical C₁-C₁₈-alkyle et un radical C₁-C₁₂-alcoxy, et
le phosphore étant lié au Cu.

6. Complexe de cuivre (I) selon l'une quelconque des revendications 1 ou 2, deux ligands L étant interconnectés l'un avec l'autre, formant ainsi un ligand bivalent.

7. Complexe de cuivre (I) selon l'une quelconque des revendications 1, 2 ou 6, deux L étant interconnectés l'un avec l'autre, formant ainsi un ligand bivalent de formule (A3) : 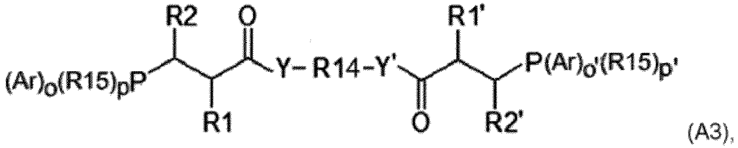
o et o' étant identiques ou différents et étant indépendamment l'un de l'autre un entier de 0 à 2 ;
p et p' étant identiques ou différents et étant indépendamment l'un de l'autre un entier de 0 à 2 ; la somme de o et p étant 2 et la somme de o' et p' étant 2 ;
R1 et R1' étant identiques ou différents et étant indépendamment l'un de l'autre choisis parmi hydrogène, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, et -R^{a}-CO-R^{b} ;
R2 et R2' étant identiques ou différents et étant indépendamment l'un de l'autre choisis parmi hydrogène, -R^{a}-R^{b}, -R^{a}-CO-O-R^{b}, -R^{a}-O-CO-R^{b}, -R^{a}-O-R^{b}, -R^{a}-CO-NH-R^{b}, -R^{a}-NH-CO-R^{b}, -R^{a}-NH-R^{b}, et -R^{a}-CO-R^{b} ;
Y et Y' étant identiques ou différents et étant indépendamment l'un de l'autre choisis parmi O et une simple liaison à un atome de carbone du radical Rx ;
R14 étant un lieur bivalent comprenant 1 à 30 atomes de carbone ;
R15 étant -R^{a}-R^{b}, -R^{c}-CO-O-R^{b}, -R^{c}-O-CO-R^{b}, -R^{c}-O-R^{b}, -R^{c}-CO-NH-R^{b}, -R^{c}- NH-CO-R^{b}, -R^{c}-NH-R^{b}, -R^{c}-CO-R^{b}, di- ou polyéthylène glycol, di- ou polypropylène glycol, un groupement polymérique, ou un support solide ;
P, Ar, R^{a}, R^{b} et R^{c} étant définis comme dans la revendication 1 ,
le phosphore étant chacun lié à un Cu.

8. Complexe de cuivre (I) selon l'une quelconque des revendications 1, 2, 6 ou 7, deux L étant interconnectés l'un avec l'autre, formant ainsi un ligand bivalent de formule (A5) : 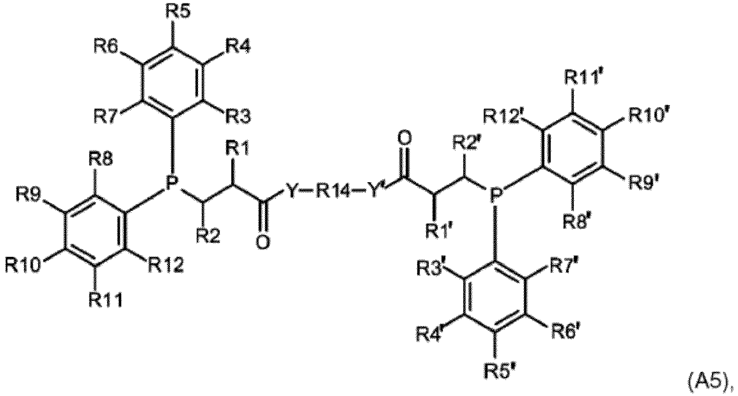
R3 à R12 et R3' à R12' étant indépendamment les uns des autres choisis parmi hydrogène, un radical C₁-C₁₈-alkyle et un radical C₁-C₁₂-alcoxy ; et
R14 étant choisi parmi -R^{c}-, -R^{a}-O-R^{a}-, un lieur di- ou polyéthylène glycol, un lieur di- ou polypropylène glycol, -R^{c}-CO-O-R^{c}-, -R^{c}-CO-O-R^{c}-O-CO-R^{c}-, -R^{c}-O-CO-R^{c}-, -R^{c}-O-CO-R^{c}-CO-O-R^{a}-, -R^{c}-CO-NH-R^{c}-, -R^{c}-CO-NH-R^{c}-NH-CO-R^{c}-, -R^{c}-NH-CO-R^{c}-, -R^{c}-NH-CO-R^{c}-CO-NH-R^{c}-, -R^{c}-NH-R^{c}-, -R^{c}-CO-R^{c}-, et -R^{c}-NH-R^{c}-NH-R^{c}- ;
R^{c} en chaque occurrence indépendamment les uns des autres étant un radical C₁-C₂₀- (hétéro)alkylène non substitué ou substitué, un radical C₂-C₂₀-(hétéro)alcénylène non substitué ou substitué, un radical C₂-C₂₀- (hétéro) alcynylène non substitué ou substitué, un radical C₁-C₂₀- (hétéro)cycloalkylène non substitué ou substitué, un radical C₂-C₂₀-(hétéro)cycloalcénylène non substitué ou substitué, un radical C₂-C₂₀- (hétéro) cycloalcynylène non substitué ou substitué, un radical C₂-C₂₀-(hétéro)arylène non substitué ou substitué, ou un radical C₂-C₂₀-alk (hétéro) arylène non substitué ou substitué, un substituant d'un radical substitué ne comprenant pas plus de 20 atomes de carbone ; et
P, R1, R1', R2, R2', Y, Y', R14, R^{a} et R^{b} étant définis comme dans l'une quelconque des revendications 1 à 7,
le phosphore étant chacun lié à un Cu.

9. Complexe de cuivre (I) selon l'une quelconque des revendications 1 à 8, au moins un ligand L monovalent ou bivalent étant choisi dans le groupe constitué par : 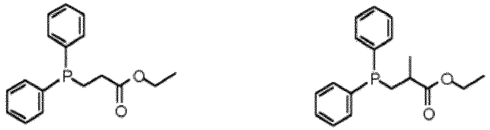 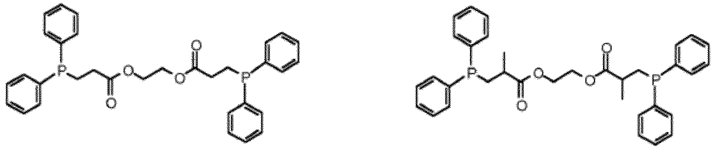 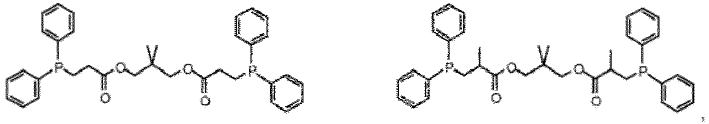 et 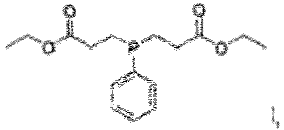 le phosphore étant lié au Cu.

10. Complexe de cuivre (I) selon l'une quelconque des revendications 1 à 9, ledit complexe de cuivre (I) étant choisi dans le groupe constitué par : 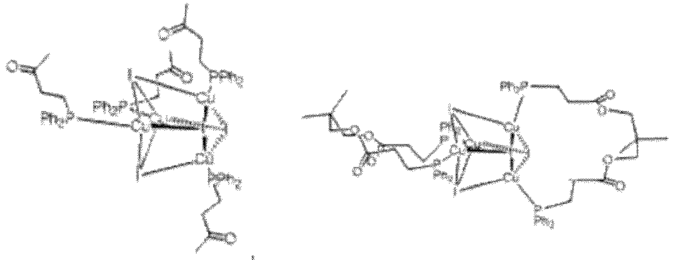 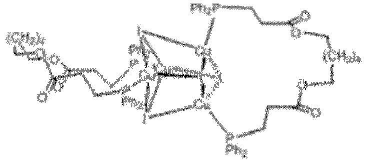 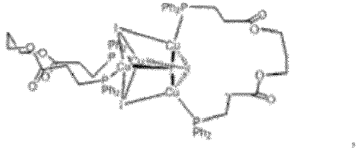 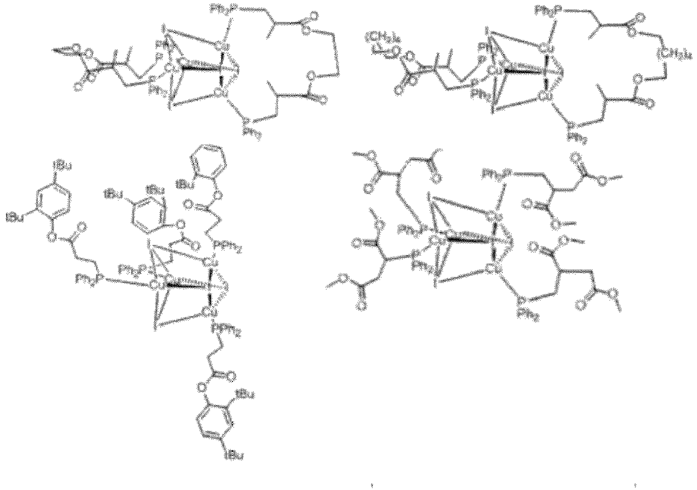 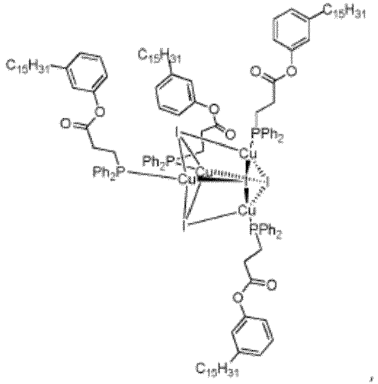 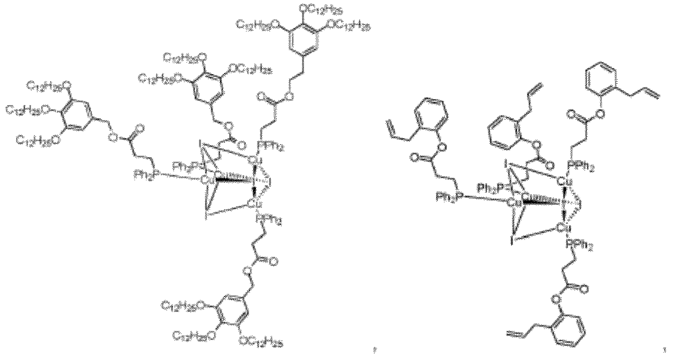 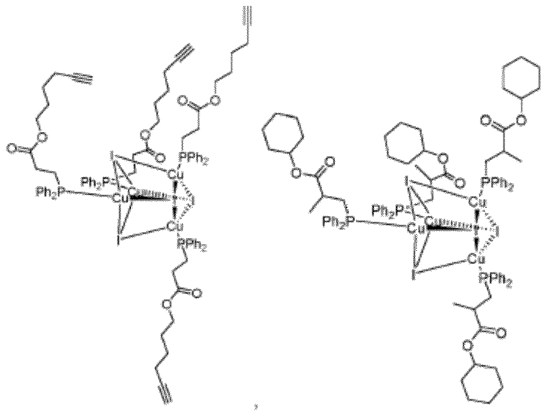 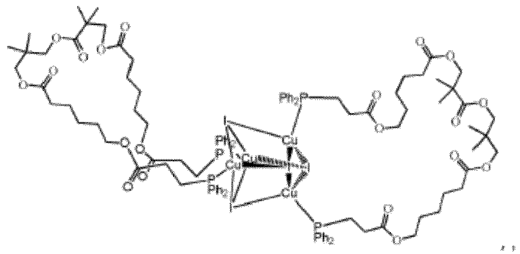 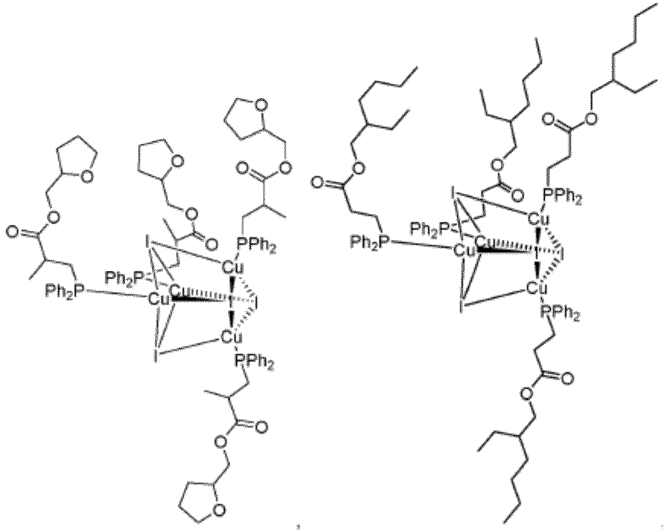 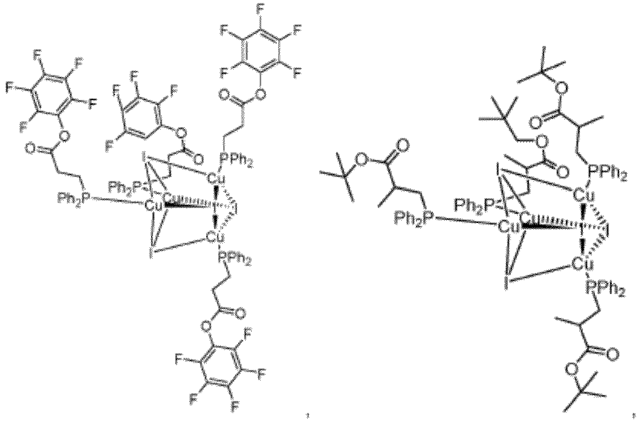 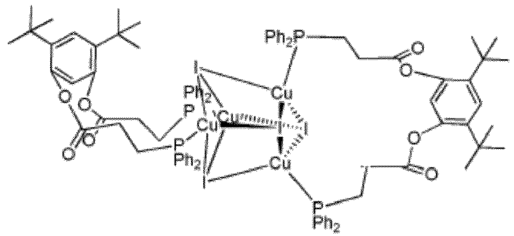 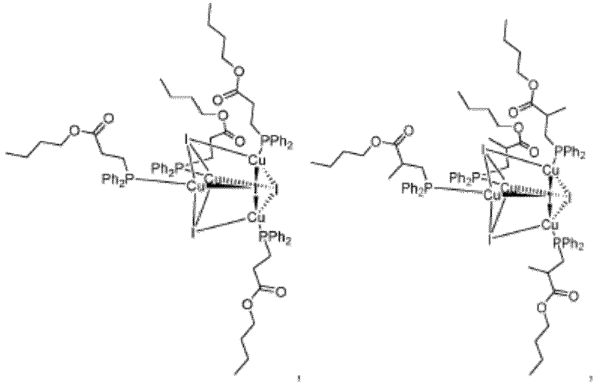 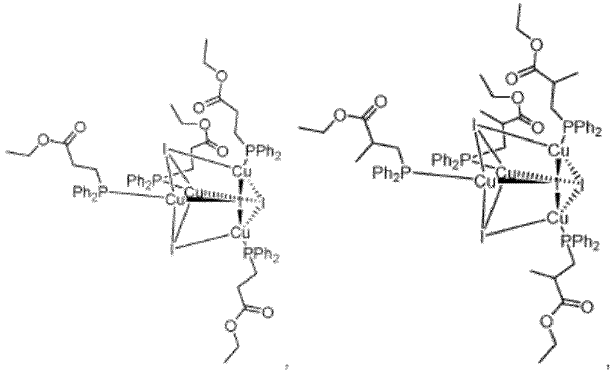 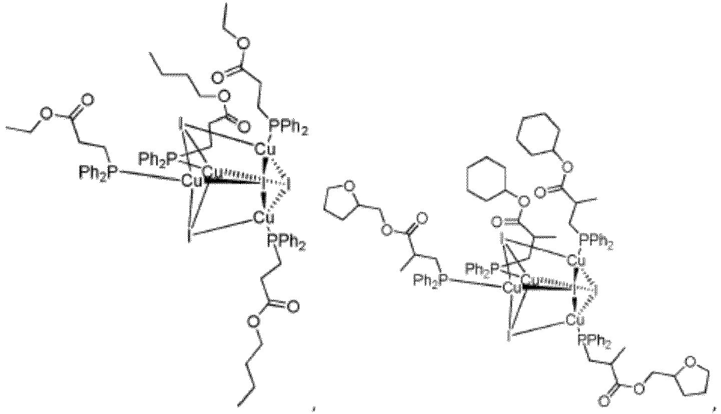 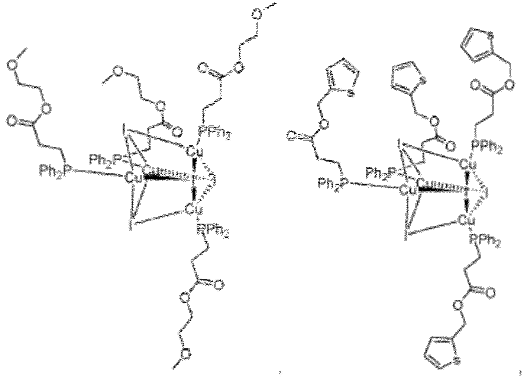 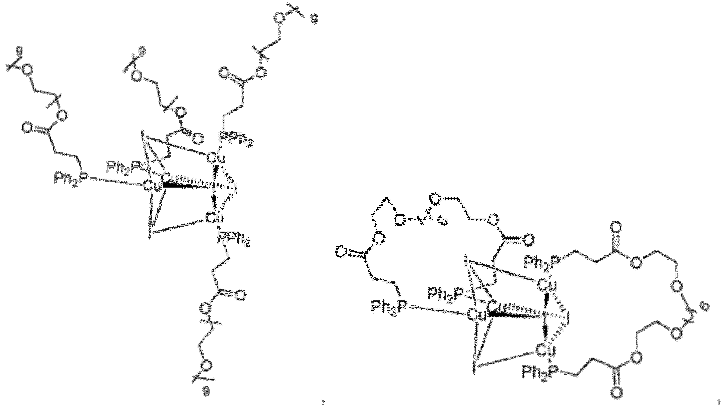 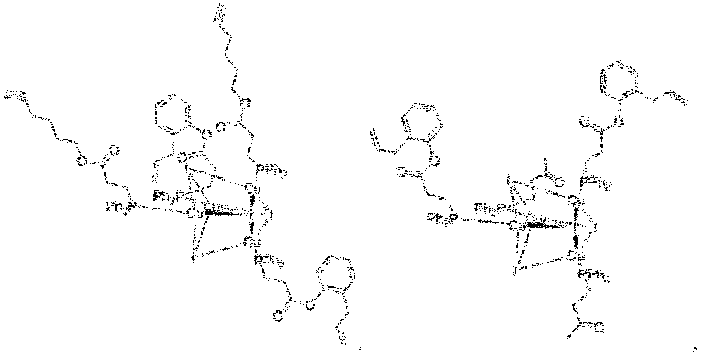 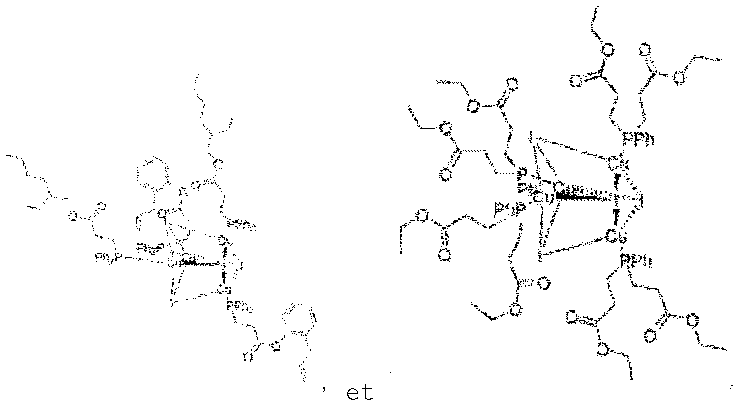 Ph étant un radical phényle non substitué.

11. Procédé pour la génération d'un complexe de cuivre (I) selon l'une quelconque des revendications 1 à 10, ledit procédé comprenant les étapes suivantes :
(i) mise à disposition, dans une atmosphère inerte :
(a) d'un halogénure de cuivre (I),
(b) d'un ligand L substitué électroniquement neutre tel que défini dans l'une quelconque des revendications 1 ou 3 à 10, un substituant d'un ligand L substitué ne comprenant pas plus de 20 atomes de carbone, et
(c) d'un solvant dans lequel les composants (a) et (b) sont dissous ;
(ii) incubation de la composition de l'étape (i) dans des conditions permettant la formation du complexe de cuivre (I) ;
(iii) éventuellement élimination du solvant et obtention d'un résidu solide ; et
(iv) éventuellement mélange de la composition de l'étape (ii) ou d'une solution obtenue en dissolvant le résidu solide de l'étape (iii) avec un antisolvant, formant ainsi un précipité, et subséquemment séchage du précipité.

12. Procédé pour la génération d'un complexe de cuivre (I) selon l'une quelconque des revendications 1 à 10, ledit procédé comprenant les étapes suivantes :
(i) mise à disposition, dans une atmosphère inerte :
(a') d'un halogénure de cuivre (I),
(b') d'éduits du ligand L :
(b1') un précurseur de ligand phosphine électroniquement neutre de formule (L1) :
**PH(Ar)ₒ(CHR2-CHR1-CO-Y-Rx)ₚ** (L1),
o étant un entier de 0 à 2 ; et
p étant un entier de 0 à 2 ;
la somme de o et p étant 2,
et P, H, Ar, R1 , R2, Y et Rx étant définis comme dans l'une quelconque des revendications 1 à 10 ; et
(b2) un composé AD dérivé de (méth)acrylate non lié ;
(c') d'un solvant dans lequel les composants (a'), (b1') et (b2') sont dissous ;
(ii) incubation de la composition de l'étape (i) dans des conditions permettant la formation du complexe de cuivre (I) ;
(iii) éventuellement élimination du solvant et obtention d'un résidu solide ; et
(iv) éventuellement mélange de la composition de l'étape (ii) ou d'une solution obtenue en dissolvant le résidu solide de l'étape (iii) avec un antisolvant, formant ainsi un précipité, et subséquemment séchage du précipité.

13. Procédé pour la génération d'un complexe de cuivre (I) selon l'une quelconque des revendications 1 à 10, ledit procédé comprenant les étapes suivantes :
(i) mise à disposition, dans une atmosphère inerte :
(a") d'un précurseur de complexe de cuivre (I) de formule (A') 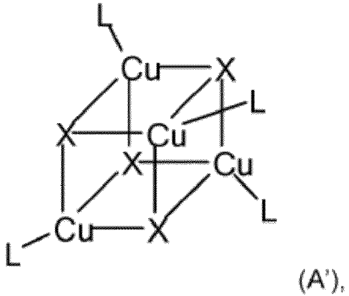
chaque Cu étant cuivre (I) ;
chaque X étant indépendamment les uns des autres halogène,
chaque L étant indépendamment les uns des autres un ligand de formule (L1) :
PH(Ar)ₒ(CHR2-CHR1-CO-Y-Rx)ₚ (L1),
o étant un entier de 0 à 2 ; et
p étant un entier de 0 à 2 ;
la somme de o et p étant 2,
et P, H, Ar, R1 , R2, Y et Rx étant définis comme dans l'une quelconque des revendications 1 à 10 ; et
ledit complexe de cuivre (I) possédant une charge nette neutre,
(b") d'un composé AD dérivé de (méth)acrylate non lié, et
(c") d'un solvant dans lequel les composants
(a") et (b") sont dissous ;
(ii) incubation de la composition de l'étape (i) dans des conditions permettant la formation du complexe de cuivre (I) ;
(iii) éventuellement élimination du solvant et obtention d'un résidu solide ; et
(iv) éventuellement mélange de la composition de l'étape (ii) ou d'une solution obtenue en dissolvant le résidu solide de l'étape (iii) avec un antisolvant, formant ainsi un précipité, et subséquemment séchage du précipité.

14. Procédé selon l'une quelconque des revendications 12 ou 13, le composé AD dérivé de (méth)acrylate étant un composé de formule (B) : 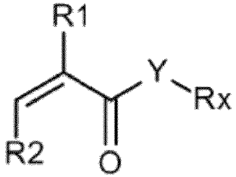
R1 étant hydrogène, -R^{a}-R^{b}, -O-R^{b}, -R^{a}-CO-O-R^{b}, - R^{a}-O-CO-R^{b}, -R^{a}-O-R^{b}, -R^{a}-CO-NH-R^{b}, -R^{a}-NH-CO-R^{b}, - R^{a}-NH-R^{b}, -R^{a}-CO-R^{b}, deutérium, ou halogène ;
R2 étant hydrogène, -O-R^{b}, -R^{a}-R^{b}, -R^{a}-CO-O-R^{b}, - R^{a}-O-CO-R^{b}, -R^{a}-O-R^{b}, -R^{a}-CO-NH-R^{b}, -R^{a}-NH-CO-R^{b}, - R^{a}-NH-R^{b}, ou -R^{a}-CO-R^{b}, deutérium, ou halogène ;
Y étant O ou une liaison à un atome de carbone du radical Rx ou étant N lié à deux Rx indépendants, préférablement, Y étant O ou une liaison à un atome de carbone du radical Rx ;
Rx étant un radical comprenant de 1 à 30 atomes de carbone, un groupement polymérique, ou un support solide, Rx pouvant éventuellement être ou contribuer à un lieur qui interconnecte deux ligands L l'un avec l'autre ;
R^{a} en chaque occurrence indépendamment les uns des autres étant une simple liaison, en chaque occurrence indépendamment les uns des autres étant un radical C₁-C₂₀- (hétéro) alkylène non substitué ou substitué, un radical C₂-C₂₀-(hétéro)alcénylène non substitué ou substitué, un radical C₂-C₂₀-(hétéro)alcynylène non substitué ou substitué, un radical C₁-C₂₀-(hétéro)cycloalkylène non substitué ou substitué, un radical C₂-C₂₀- (hétéro) cycloalcénylène non substitué ou substitué, un radical C₂-C₂₀-(hétéro)cycloalcynylène non substitué ou substitué, un radical C₂-C₂₀- (hétéro) arylène non substitué ou substitué, ou un radical C₂-C₂₀-alk(hétéro)arylène non substitué ou substitué, un substituant d'un radical substitué ne comprenant pas plus de 20 atomes de carbone ; et
R^{b} en chaque occurrence indépendamment les uns des autres étant un radical C₁-C₂₀-(hétéro)alkyle non substitué ou substitué, un radical C₂-C₂₀-(hétéro)alcényle non substitué ou substitué, un radical C₂-C₂₀- (hétéro) alcynyle non substitué ou substitué, un radical C₁-C₂₀- (hétéro) cycloalkyle non substitué ou substitué, un radical C₂-C₂₀-(hétéro)cycloalcényle non substitué ou substitué, un radical C₂-C₂₀-(hétéro)cycloalcynyle non substitué ou substitué, un radical C₂-C₂₀-(hétéro)aromatique non substitué ou substitué, ou un radical C₂-C₂₀-alk (hétéro) aromatique non substitué ou substitué, un substituant d'un radical substitué ne comprenant pas plus de 20 atomes de carbone.

15. Dispositif opto-électronique contenant un complexe de cuivre (I) selon l'une quelconque des revendications 1 à 10.
